# EUROPEAN PATENT APPLICATION

(11) **EP 4 502 729 A1**
(43) Date of publication of application: **05.02.2025**
(21) Application number: 24191453.0
(22) Date of filing: 29.07.2024
(51) Int. Cl.: G03F 7/038, C08G 73/00

(54) **NEGATIVE-TYPE PHOTOSENSITIVE RESIN COMPOSITION, PATTERNING METHOD, METHOD FOR FORMING CURED FILM, INTERLAYER INSULATIVE FILM, SURFACE-PROTECTIVE FILM, AND ELECTRONIC COMPONENT**

(30) Priority: 02.08.2023 JP 2023126541
(71) Applicant: SHIN-ETSU CHEMICAL CO., LTD., Tokyo 1000005 (JP)
(72) Inventor: Urano, Hiroyuki, Niigata (JP); Iio, Masashi, Niigata (JP); Watanabe, Osamu, Niigata (JP); Takemura, Katsuya, Niigata (JP); Honda, Kazuya, Tokyo (JP)
(74) Representative: Sonnenhauser, Thomas Martin

(57) **Abstract**

The present invention is a negative-type photosensitive resin composition, including: a polymer (A) having a structural unit represented by the following general formula (1) and/or (2) and a structural unit represented by the following general formula (3) and/or (4); a photoacid generator (B); a crosslinking agent (C); and a solvent (D). This can provide: a negative-type photosensitive resin composition that is soluble in an alkaline aqueous solution, that can form a fine pattern to yield high resolution, that has good mechanical properties such as breakage elongation and tensile strength even by curing at low temperature, and that causes no deterioration of adhesive force before and after a high-temperature high-humidity test; a patterning method; a method for forming a cured film; an interlayer insulative film; a surface-protective film; and an electronic component.

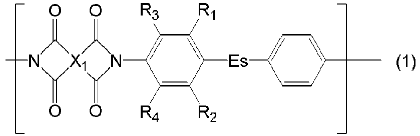

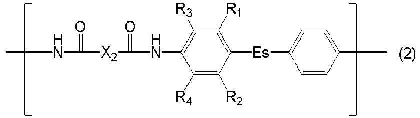

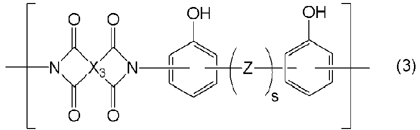

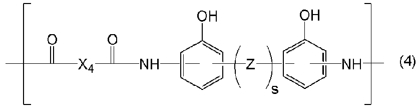

## Description

### TECHNICAL FIELD

The present invention relates to a negative-type photosensitive resin composition, a patterning method, a method for forming a cured film, an interlayer insulative film, a surface-protective film, and an electronic component.

### BACKGROUND ART

As downsizing and increasing performance of various electronic devices such as personal computers, digital cameras, and mobile phones, demands of further downsizing, thinning, and increasing density for semiconductor devices also have rapidly increased. Accordingly, an interlayer insulative film and a surface-protective film of the semiconductor device have required to have all of more excellent electric characteristics, heat resistance, mechanical characteristics, etc.

In a high-density mounting technology such as three-dimensional stacking, as for a photosensitive insulating material patternable on a substrate, a polyimide film has been conventionally utilized as a protective film and an insulative layer. The insulability, mechanical characteristics, adhesiveness to the substrate, etc. of the polyimide film have attracted attention, and the development has been vigorously conducted in progress at present.

There have been many approaches in order to further improve the above required characteristics. Proposed as one approach is a photosensitive resin composition using a ring-closed polyimide resin for a purpose of lowering a post-curing temperature (Patent Document 1 and Patent Document 2). However, it is difficult to achieve all properties of the cured film such as resolution, mechanical characteristics (elongation and tensile strength), and adhesive force, and there has room for improvement.

As improvement of the mechanical strength of the cured film, a composition containing a polymer having a structural unit derived from an ester-containing diamine has been proposed (Patent Document 3 and Patent Document 4). Patent Document 3 proposes a positive-type photosensitive resin composition containing an esterdiamine-containing polybenzoxazole precursor and a naphthoquinone diazide compound, but describes only dissolution contrast and sensitivity on lithographic characteristics. There is no description on pattern resolution, and there is room for improvement of values of the mechanical strength.

Patent Document 4 proposes: a polyamic acid having diamine residual groups derived from an ester-containing diamine and bendable diamine, as diamine residual groups, and having an acid dianhydride residual group; and a polyimide in which this polyamic acid is ring-closed. However, there is no description on the photosensitive resin composition, and there is room for improvement of the mechanical strength, specifically elongation.

Proposed as improvement of the mechanical strength of the cured film is adding a (meth)acryl resin to achieve both of the lithographic characteristics and the properties of the cured film (Patent Document 5, Patent Document 6, and Patent Document 7). However, the object is to modify the main resin, and thus there is room for improvement of values of the mechanical strength of the cured film.

Accordingly, miniaturization of a pattern by rewiring technology of the insulating protective film will proceed more and more with increase in chip density and integration, and therefore, strongly demanded for the photosensitive resin composition is a composition that can embody the pattern shape with high resolution and good rectangularity without impairing excellent features of the pattern and protective film obtained by heating, such as mechanical properties and adhesiveness.

### CITATION LIST

### PATENT LITERATURE

Patent Document 1: JP 4530284 B2
Patent Document 2: JP 2006-313237 A
Patent Document 3: JP 2020-152768 A
Patent Document 4: JP 2021-187934 A
Patent Document 5: JP 5884837 B2
Patent Document 6: JP 2015-129791 A
Patent Document 7: JP 2015-200819 A

### SUMMARY OF INVENTION

### TECHNICAL PROBLEM

The present invention has been made in view of the above circumstances. An object of the present invention is to provide: a negative-type photosensitive resin composition that is soluble in an alkaline aqueous solution, that can form a fine pattern to yield high resolution, that yields good mechanical properties such as breakage elongation and tensile strength even by curing at low temperature, and that causes no deterioration of adhesive force before and after a high-temperature high-humidity test; a patterning method; a method for forming a cured film; an interlayer insulative film; a surface-protective film; and an electronic component.

### SOLUTION TO PROBLEM

To solve the above problem, the present invention provides a negative-type photosensitive resin composition comprising:
a polymer (A) having a structural unit represented by the following general formula (1) and/or (2) and a structural unit represented by the following general formula (3) and/or (4), 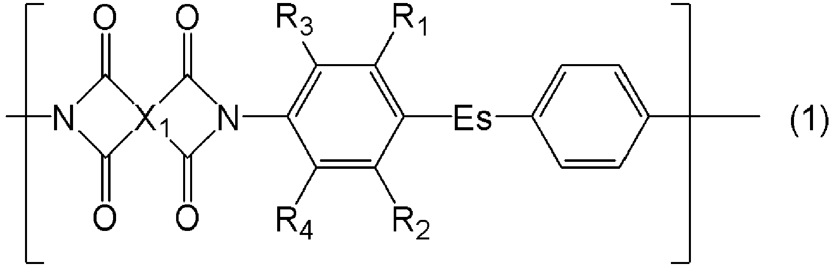
wherein X₁ represents a tetravalent organic group; R₁ to R₄ represent a monovalent organic group having 1 to 15 carbon atoms and optionally having a heteroatom, or a hydrogen atom, R₁ to R₄ may be different from or same as each other, and at least one of R₁ to R₄ represents the monovalent organic group having 1 to 15 carbon atoms and optionally having a heteroatom; and Es represents a -O-C(=O)- bond or a -C(=O)-O- bond, 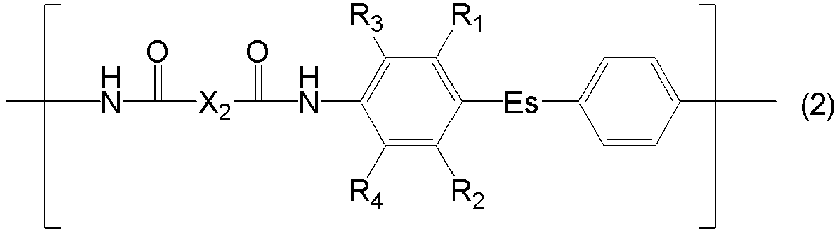
wherein X₂ represents a divalent organic group; and R₁ to R₄ and Es are same as above, 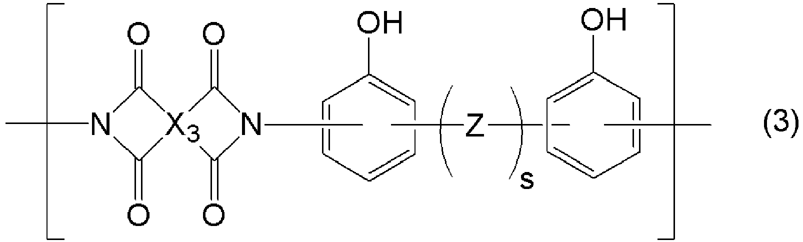
wherein X₃ represents a tetravalent organic group same as or different from the X₁; "s" represents 0 or 1; Z represents a divalent bonding group; and when s=0, two aromatic rings in the formula are directly bonded via no bonding group, 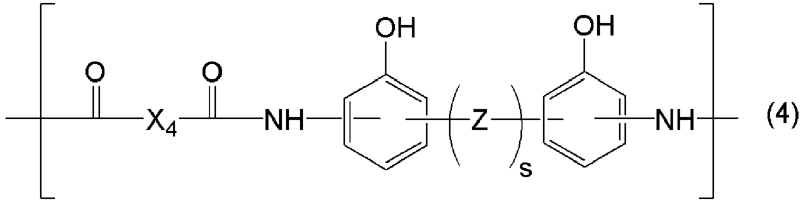
wherein X₄ represents a divalent organic group same as or different from the X₂; and "s" and Z are same as above;
a photoacid generator (B);
a crosslinking agent (C); and
a solvent (D).

Such a negative-type photosensitive resin composition is soluble in an alkaline aqueous solution and can form a fine pattern to yield high resolution due to the general formula (3) or (4) having a phenolic hydroxy group, promotes interaction between the molecules with a hydrogen bond etc. due to the general formula (1) or (2) having an ester group, and interacts with a substrate to yield good mechanical properties and adhesiveness to the substrate even when cured at low temperature.

In the present invention, any one of the R₁ and R₂ in the general formulae (1) and (2) preferably represents the monovalent organic group having 1 to 15 carbon atoms and optionally having a heteroatom, the other preferably represents a hydrogen atom, and the R₃ and R₄ preferably represent hydrogen atoms.

Such a negative-type photosensitive resin composition has a substituent at an ortho position relative to a portion bonded to the ester group to inhibit free rotation of the polymer chain due to steric hinderance of the substituent, which yields appropriate interaction between the molecules to yield good mechanical properties even when cured at low temperature.

In this case, any one of the R₁ and R₂ in the general formulae (1) and (2) preferably represents an aromatic group having 1 to 10 carbon atoms, and the other preferably represents a hydrogen atom.

Such a negative-type photosensitive resin composition yields further better mechanical properties even when cured at low temperature.

In the present invention, the Z in the general formulae (3) and (4) preferably represents at least one bonding group selected from any groups represented by the following formulae (5), (6), (7), and (8), 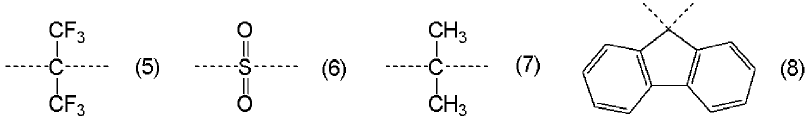 wherein a dotted line represents an attachment point.

Such a negative-type photosensitive resin composition can increase solubility in an alkaline aqueous solution, and can form a finer pattern to yield high resolution.

In the present invention, the component (C) is preferably one or two or more crosslinking agents selected from: an amino condensate modified with formaldehyde or formaldehyde-alcohol; a phenol compound having two or more methylol groups or alkoxymethylol groups in average in one molecule; a compound in which a hydrogen atom in a hydroxy group of a polyvalent phenol is substituted with a glycidyl group; a compound in which a hydrogen atom in a hydroxy group of a polyvalent phenol or in a hydroxy group of a polyhydric alcohol is substituted with a substituent represented by the following formula (C-1); and a compound having two or more nitrogen atoms having a glycidyl group represented by the following formula (C-2), 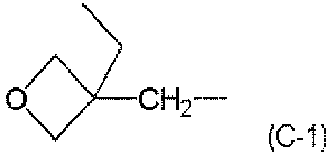 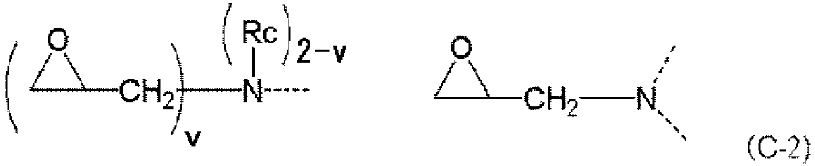 wherein a dotted line represents an attachment point; Rc represents a linear, branched, or cyclic alkyl group having 1 to 6 carbon atoms; and "v" represents 1 or 2.

Such a negative-type photosensitive resin composition can form a finer pattern to yield high resolution, and yields good mechanical properties and adhesiveness to a substrate even when cured at low temperature.

In the present invention, the negative-type photosensitive resin composition preferably further comprises a crosslinkable polymer (E) having a structural unit represented by the following general formula (9) and a group that is crosslinkable with the component (A), 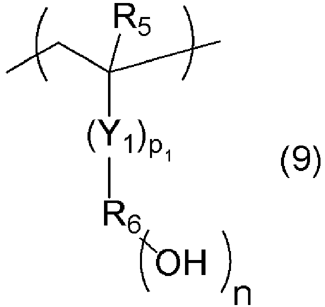 wherein R₅ represents a hydrogen atom or a methyl group; R₆ represents an (n+1)-valent linear, branched, or cyclic aliphatic saturated hydrocarbon group having 1 to 15 carbon atoms, an aromatic hydrocarbon group having 6 to 15 carbon atoms, a benzyl group, or a naphthalenemethyl group, and a carbon atom in the aliphatic saturated hydrocarbon group is optionally substituted with an oxygen atom; "n" represents an integer of 1 to 5; Y₁ each represents -C(=O)-O-, -C(=O)-NH-, or -C(=O)-N(R₇OH)-; R₇ represents a divalent linear, branched, or cyclic aliphatic saturated hydrocarbon group having 1 to 12 carbon atoms or an aromatic hydrocarbon group having 6 to 12 carbon atoms, and a carbon atom in the aliphatic saturated hydrocarbon group is optionally substituted with an oxygen atom; and p₁ represents 0 or 1.

Such a negative-type photosensitive resin composition can form a finer pattern to yield high resolution, and yields good mechanical properties and adhesiveness to a substrate even when cured at low temperature.

In this case, the component (E) is preferably a crosslinkable polymer compound having: a structural unit represented by the following general formula (10); and a structural unit represented by the following general formula (11) having a group that is crosslinkable with the component (A), 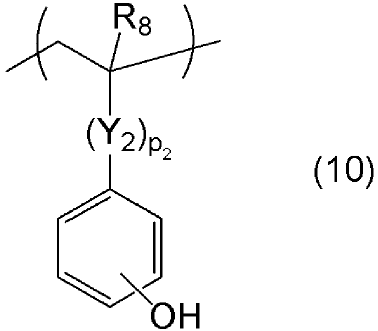 wherein R₈ represents a hydrogen atom or a methyl group; Y₂ each represents -C(=O)-O-, -C(=O)-NH-, or - C(=O)-N(R₉OH)-; R₉ represents a divalent linear, branched, or cyclic aliphatic saturated hydrocarbon group having 1 to 12 carbon atoms or an aromatic hydrocarbon group having 6 to 12 carbon atoms, and a carbon atoms in the aliphatic saturated hydrocarbon group is optionally substituted with an oxygen atom; and p₂ represents 0 or 1, 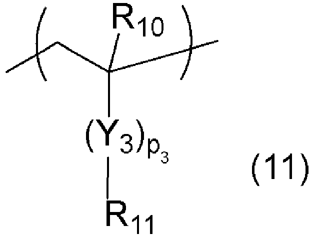 wherein R₁₀ represents a hydrogen atom or a methyl group; R₁₁ represents a group having an oxazoline group, an isocyanate group, a block isocyanate group, an oxetanyl group, or an epoxy group; Y₃ represents -C(=O)-O-, a phenylene group, or a naphthylene group; and p₃ represents 0 or 1.

Such a negative-type photosensitive resin composition retains sufficient solubility in an alkaline aqueous solution to yield a pattern with good rectangularity, and yields good mechanical properties and adhesiveness to the substrate even when cured at low temperature.

In this case, the component (E) is preferably a crosslinkable polymer compound having structural units represented by the following general formula (10) and the following general formula (12), 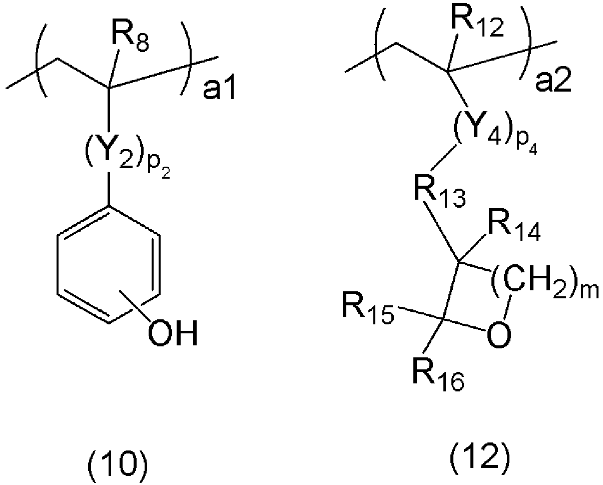 wherein R₈, Y₂, and p₂ are same as above; R₁₂ represents a hydrogen atom or a methyl group; Y₄ each represents -C(=O)-O-, a phenylene group, or a naphthylene group; R₁₃ represents a linear, branched, or cyclic alkylene group having 1 to 15 carbon atoms and optionally having a hydroxy group, an ester group, an ether group, or an aromatic hydrocarbon; R₁₄ represents a hydrogen atom or a linear, branched, or cyclic alkyl group having 1 to 6 carbon atoms, and R₁₄ is optionally bonded to R₁₃ to form a ring; R₁₅ represents a hydrogen atom or a linear, branched, or cyclic alkyl group having 1 to 6 carbon atoms; R₁₆ represents a hydrogen atom or a linear alkyl group having 1 to 6 carbon atoms, and R₁₆ is optionally bonded to R₁₃ to form a ring; "m" represents 0 or 1; p₄ represents 0 or 1; and 0<a1<1.0, 0<a2<1.0, and 0<a1+a2≤1.0.

Such a negative-type photosensitive resin composition can retain the sufficient solubility in an alkaline aqueous solution when added into the polymer of the component (A) to yield a pattern with good rectangularity. In addition, since the crosslinkable group having excellent crosslinking ability is present, such a negative-type photosensitive resin composition causes a crosslinking reaction with a phenolic hydroxy group in the structural unit represented by the general formula (3) and/or (4) of the component (A), which causes no deterioration of adhesiveness to the substrate after the durability test.

In the present invention, the component (E) is preferably a crosslinkable polymer compound further having a structural unit represented by the following general formula (13), 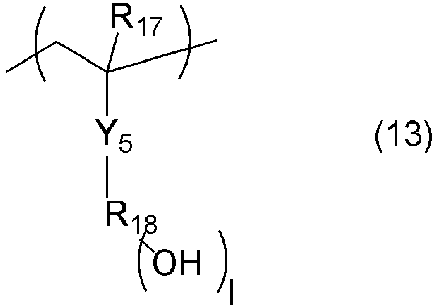 wherein R₁₇ represents a hydrogen atom or a methyl group; R₁₈ represents a single bond or a (l+1)-valent linear, branched, or cyclic aliphatic saturated hydrocarbon group having 1 to 13 carbon atoms, and a carbon atom in the aliphatic saturated hydrocarbon group is optionally substituted with an oxygen atom; Y₅ each represents -C(=O)-O-, -C(=O)-O-R₁₉-, -C(=O)-NH-, -C(=O)-N(R₁₉OH)-, a phenylene group, or a naphthylene group; R₁₉ represents a divalent linear, branched, or cyclic aliphatic saturated hydrocarbon group having 1 to 12 carbon atoms or an aromatic hydrocarbon group having 6 to 12 carbon atoms, and a carbon atom in the aliphatic saturated hydrocarbon group is optionally substituted with an oxygen atom; and "l" represents 0 or 1.

Such a negative-type photosensitive resin composition can form a finer pattern to yield high resolution, and yields good mechanical properties and adhesiveness to the substrate even when cured at low temperature.

In the present invention, the component (E) is preferably a crosslinkable polymer compound further having at least one or more structural units selected from cyclization-polymerized structural units represented by the following general formula (14), the following general formula (15), the following general formula (16), and the following general formula (17), 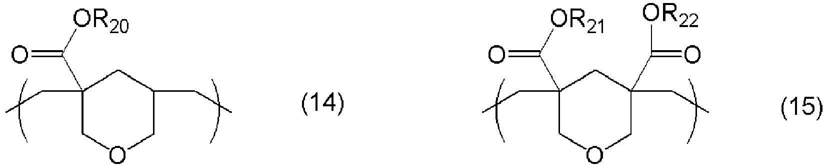 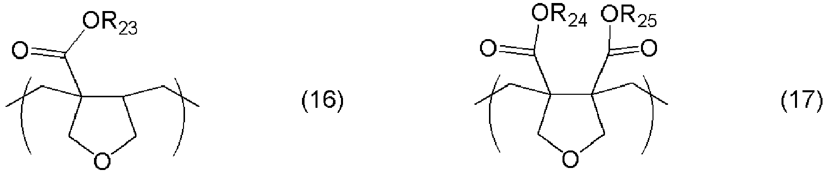 wherein R₂₀, R₂₁, R₂₂, R₂₃, R₂₄, and R₂₅ each independently represent a hydrogen atom or a linear or branched alkyl group having 1 to 5 carbon atoms.

Such a negative-type photosensitive resin composition having the cyclic structure in the main chain yields good mechanical properties such as breakage elongation and tensile strength even when cured at low temperature, and heat resistance is further improved.

In the present invention, the negative-type photosensitive resin composition preferably further comprises one or more selected from a basic compound (F), a thermal acid generator (G), an oxidation inhibitor (H), and a silane compound (I).

Containing such a component (F) can improve dissolution contrast in lithographic patterning, and also can control the pattern shape.

Such a component (G) can furthermore proceed the crosslinking and curing reactions to furthermore increase mechanical properties, chemical resistance, adhesiveness, etc. of the obtained pattern or film.

Such a component (H) can inhibit deterioration of physical properties due to oxidative deterioration of the cured film in the durability tests such as a high-humidity test and a thermal impact test, and can form a further preferable cured film.

Such a component (I) can furthermore improve adhesiveness of the obtained pattern or film to the substrate.

Further, the present invention provides a patterning method comprising steps of:
(1) applying the aforementioned negative-type photosensitive resin composition on a substrate to form a photosensitive film;
(2) after a subsequent heating treatment, subjecting the photosensitive film to light exposure through a photomask by using high-energy ray having a wavelength of 190 to 500 nm or electron beam; and
(3) after the light exposure, subjecting the substrate to a heating treatment, and performing development by using a developer of an alkaline aqueous solution.

Such a patterning method uses the above negative-type photosensitive resin composition to be soluble in an alkaline aqueous solution, and can form a fine pattern to yield high resolution.

Further, the present invention provides a method for forming a cured film comprising a step of heating and post-curing the patterned photosensitive film obtained by the aforementioned patterning method at a temperature of 100 to 300°C.

Such a method for forming a cured film can form a cured film (pattern) having good mechanical properties even when the composition is cured at low temperature.

Further, the present invention provides an interlayer insulative film or surface-protective film being a cured film formed by curing the aforementioned negative-type photosensitive resin composition.

The cured film composed by curing the negative-type photosensitive resin composition of the present invention has excellent adhesiveness to the substrate, heat resistance, electric properties, mechanical strength, and chemical resistance against an alkaline remover etc., and excellent durability of a semiconductor device having the above cured film as a protective film. Therefore, the cured film is suitable for a protective film (an interlayer insulative film or a surface-protective film) of an electric or electronic component, a semiconductor device, etc.

In addition, the present invention provides an electronic component comprising the aforementioned interlayer insulative film or surface-protective film.

Such a protective film (an interlayer insulative film or a surface-protective film) is effective for an insulative film for a semiconductor device including rewiring use, an insulative film for a multilayer printed board, etc. due to its heat resistance, chemical resistance, and insurability, which can provide an electronic component having excellent reliability.

### ADVANTAGEOUS EFFECTS OF INVENTION

As above, the present invention can provide a negative-type photosensitive resin composition that is soluble in an alkaline aqueous solution, that can form a fine pattern with high rectangularity to yield high resolution, and that has good mechanical properties and adhesiveness to the substrate even by curing at low temperature.

### BRIEF DESCRIPTION OF DRAWING

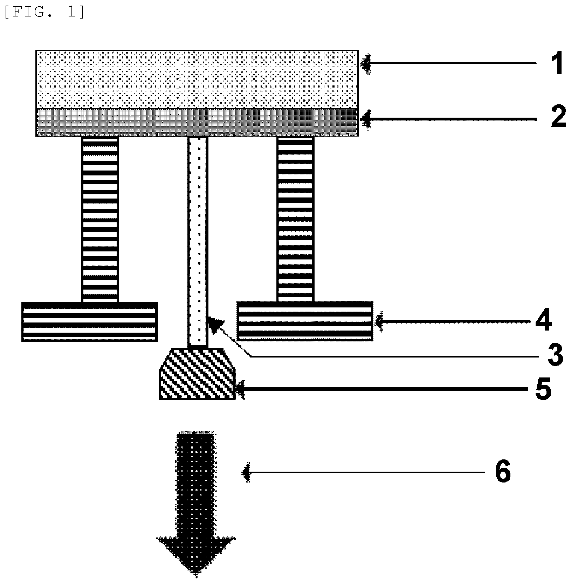

FIG. 1 is an explanatory view illustrating a method for measuring adhesive force.

### DESCRIPTION OF EMBODIMENTS

As noted above, there has been demand for a photosensitive composition that is soluble in an alkaline aqueous solution, that can form a fine pattern with high rectangularity to yield high resolution, and that has good mechanical properties and adhesiveness to the substrate even when cured at low temperature.

The present inventors have made earnest study to achieve the above object, and consequently found that a pattern obtained by using a negative-type photosensitive resin composition containing the following components (A) to (D) has a fine rectangular pattern shape, and the obtained cured film has good mechanical properties and adhesiveness to the substrate.

Further, it has been found that a protective film obtained by forming a pattern using the above negative-type photosensitive resin composition and then heating the pattern at low temperature has excellent mechanical properties and adhesiveness. That is, it has been found that the cured film obtained by having the pattern formed by using the above negative-type photosensitive resin composition is excellent as a protective film for an electric or electronic component and a protective film for insulation. This finding has led to completion of the present invention. Note that an electric and electronic components are collectively referred to as "electronic component" herein.

Specifically, the present invention is a negative-type photosensitive resin composition, comprising:
a polymer (A) having a structural unit represented by the following general formula (1) and/or (2) and a structural unit represented by the following general formula (3) and/or (4), 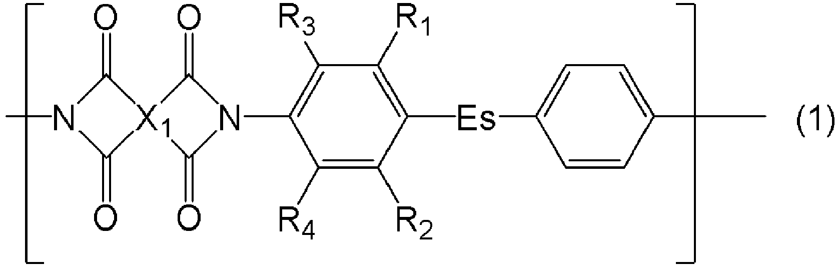
wherein X₁ represents a tetravalent organic group; R₁ to R₄ represent a monovalent organic group having 1 to 15 carbon atoms and optionally having a heteroatom, or a hydrogen atom, R₁ to R₄ may be different from or same as each other, and at least one of R₁ to R₄ represents the monovalent organic group having 1 to 15 carbon atoms and optionally having a heteroatom; and Es represents a -O-C(=O)- bond or a -C(=O)-O- bond, 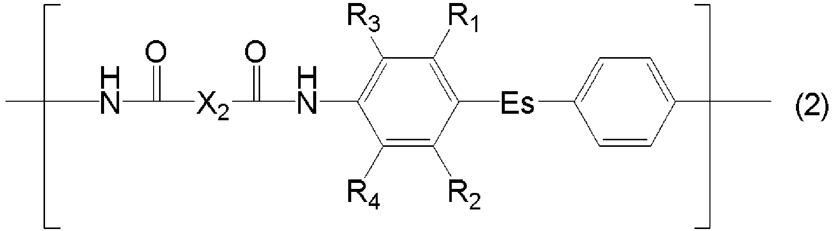
wherein X₂ represents a divalent organic group; and R₁ to R₄ and Es are same as above, 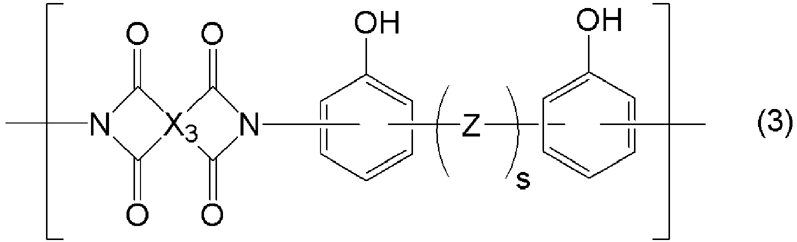
wherein X₃ represents a tetravalent organic group same as or different from the X₁; "s" represents 0 or 1; Z represents a divalent bonding group; and when s=0, two aromatic rings in the formula are directly bonded via no bonding group, 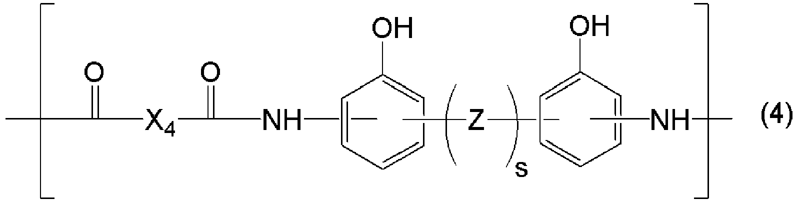
wherein X₄ represents a divalent organic group same as or different from the X₂; and "s" and Z are same as above;
a photoacid generator (B);
a crosslinking agent (C); and
a solvent (D).

Hereinafter, the present invention will be described in detail, but the present invention is not limited thereto.

### Negative-Type Photosensitive Resin Composition

The negative-type photosensitive resin composition of the present invention contains the following components (A) to (D). Hereinafter, each of the components will be described in detail.

### Polymer (A)

The polymer (A) contained in the negative-type photosensitive resin composition of the present invention has a structural unit represented by the following general formula (1) and/or (2) (hereinafter, also referred to as "structural unit (1)" and "structural unit (2)") and a structural unit represented by the following general formula (3) and/or (4) (hereinafter, also referred to as "structural unit (3)" and "structural unit (4)").

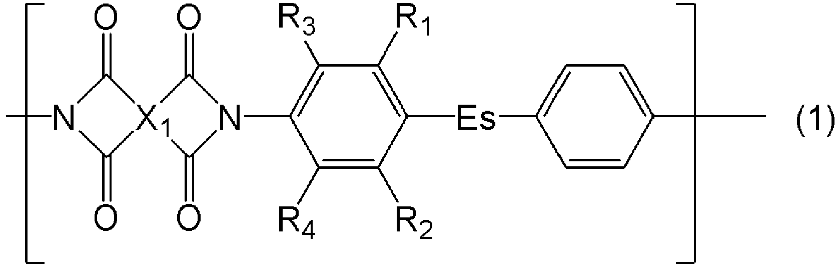

In the formula, X₁ represents a tetravalent organic group; R₁ to R₄ represent a monovalent organic group having 1 to 15 carbon atoms and optionally having a heteroatom, or a hydrogen atom, R₁ to R₄ may be different from or same as each other, and at least one of R₁ to R₄ represents the monovalent organic group having 1 to 15 carbon atoms and optionally having a heteroatom; and Es represents a -O-C(=O)- bond or a - C(=O)-O- bond.

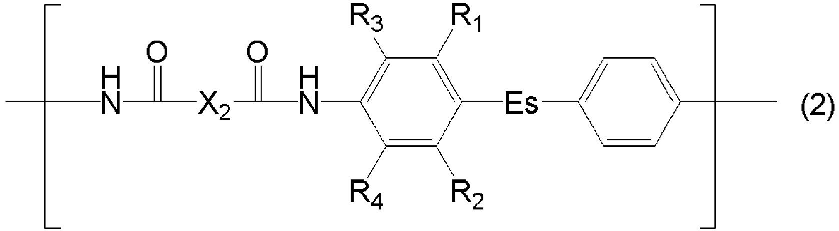

In the formula, X₂ represents a divalent organic group; and R₁ to R₄ and Es are same as above.

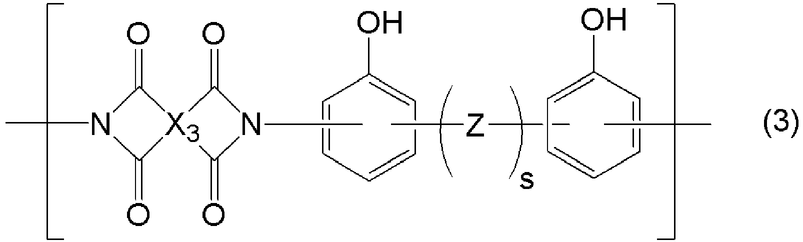

In the formula, X₃ represents a tetravalent organic group same as or different from the X₁; "s" represents 0 or 1; Z represents a divalent bonding group; and when s=0, two aromatic rings in the formula are directly bonded via no bonding group.

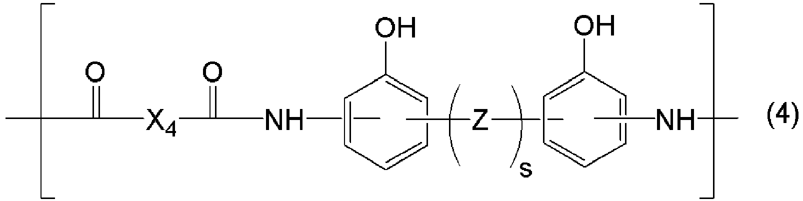

In the formula, X₄ represents a divalent organic group same as or different from the X₂; and "s" and Z are same as above.

X₁ in the general formula (1) represents a tetravalent organic group, but is not limited as long as X₁ represents the tetravalent organic group. X₁ preferably represents a tetravalent alicyclic aliphatic group having 4 to 40 carbon atoms or a tetravalent aromatic group having 6 to 40 carbon atoms, and optionally has a siloxane skeleton. X₁ further preferably represents a tetravalent organic group represented by the following formulae (18). X₁ may have one structure or a combination structure of two or more.

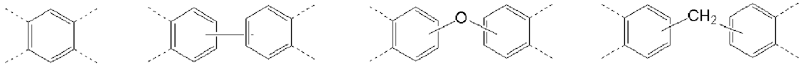

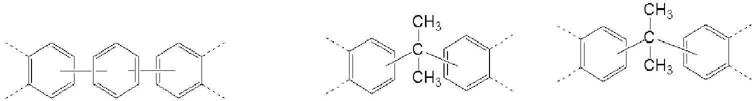

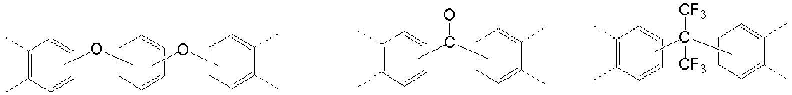

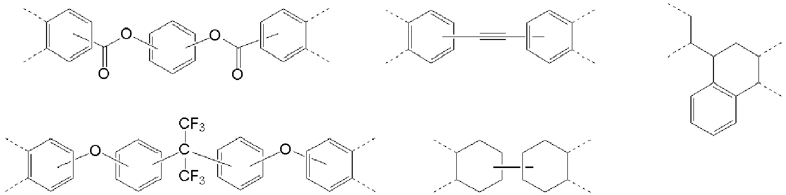

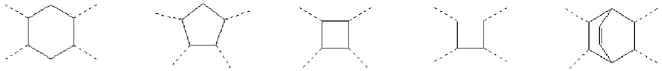

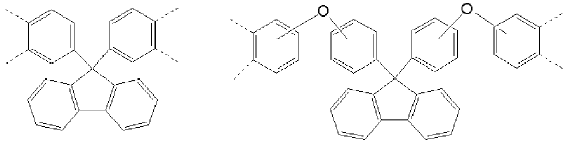

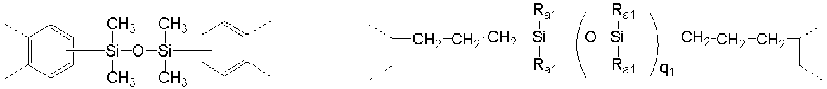

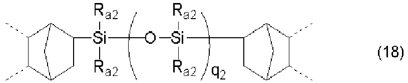

In the formulae, Rₐ₁ and Rₐ₂ each independently represent a methyl group or a phenyl group, q₁ and q₂ represent an integer of 1 to 20, and a dotted line represents an attachment point.

In the general formula (1), any of R₁ to R₄ represents a monovalent organic group having 1 to 15 carbon atoms and optionally having a heteroatom. It is preferable that any one of R₁ and R₂ represents the monovalent organic group having 1 to 15 carbon atoms and optionally having a heteroatom, the other represents a hydrogen atom, and R₃ and R₄ represent a hydrogen atom. It is more preferable that any one of R₁ and R₂ represents a group selected from an alkyl group having 1 to 12 carbon atoms, an alkoxy group having 1 to 12 carbon atoms, an aromatic group having 6 to 12 carbon atoms, a phenoxy group having 6 to 10 carbon atoms, a benzyl group having 7 to 10 carbon atoms, and a benzyloxy group having 7 to 10 carbon atoms, the other represents a hydrogen atom, and R₃ and R₄ represent a hydrogen atom. It is further preferable that any one of R₁ and R₂ represents a monovalent organic group having 1 to 10 carbon atoms and optionally having a heteroatom, the other represents a hydrogen atom, and R₃ and R₄ represent a hydrogen atom.

Examples of the alkyl group having 1 to 12 carbon atoms include a methyl group, an ethyl group, a propyl group, an isopropyl group, a butyl group, an isobutyl group, a pentyl group, and a hexyl group. Examples of the alkoxy group having 1 to 12 carbon atoms include a methoxy group, an ethoxy group, a propoxy group, a butoxy group, and a pentoxy group. Examples of the aromatic group having 6 to 12 carbon atoms include a phenyl group, a methylphenyl group, a dimethylphenyl group, an ethylphenyl group, a diethylphenyl group, a propylphenyl group, a butylphenyl group, a fluorophenyl group, a chlorophenyl group, a bromophenyl group, a methoxyphenyl group, a dimethoxyphenyl group, an ethoxyphenyl group, a diethoxyphenyl group, an aminophenyl group, a nitrophenyl group, a cyanophenyl group, a phenethyl group, a phenylpropyl group, a phenylamino group, a diphenylamino group, a biphenyl group, and a naphthyl group. Examples of the phenoxy group having 6 to 10 carbon atoms include a methylphenoxy group, an ethylphenoxy group, a propylphenoxy group, a dimethylphenoxy group, a diethyphenoxy group, a methoxyphenoxy group, an ethoxyphenoxy group, and a dimethoxyphenoxy group. Examples of the benzyl group having 7 to 10 carbon atoms include a benzyl group, a methylbenzyl group, an ethylbenzyl group, a propylbenzyl group, a dimethylbenzyl group, a diethylbenzyl group, a methoxybenzyl group, an ethoxybenzyl group, a dimethoxybenzyl group, a diethoxybenzyl group, an aminobenzyl group, a nitrobenzyl group, and a cyanobenzyl group. Examples of the benzyloxy group having 7 to 10 carbon atoms include a benzyloxy group, a methylbenzyloxy group, an ethylbenzyloxy group, a propylbenzyloxy group, a dimethylbenzyloxy group, a diethylbenzyloxy group, a methoxybenzyloxy group, and an ethoxybenzyloxy group.

Among the above groups, the aromatic group having 6 to 12 carbon atoms, the phenoxy group having 6 to 10 carbon atoms, the benzyl group having 7 to 10 carbon atoms, and the benzyloxy group having 7 to 10 carbon atoms are preferable, the aromatic group having 6 to 12 carbon atoms are more preferable, and a phenyl group, a methylphenyl group, a dimethylphenyl group, an ethylphenyl group, and a diethylphenyl group are further preferable. It is considered that such an organic group inhibits free rotation of the polymer chain with its bulkiness to inhibit an intermolecular packing effect, resulting in an appropriate intermolecular interaction to improve mechanical properties of the cured film, specifically breakage elongation.

X₂ in the general formula (2) represents a divalent organic group, and not is limited as long as X₂ represents the divalent organic group. X₂ preferably represents a divalent organic group having an aliphatic chain structure having 4 to 40 carbon atoms, a divalent alicyclic aliphatic group having 4 to 40 carbon atoms, or a divalent aromatic group having 6 to 40 carbon atoms. X₂ further preferably represents a divalent organic group represented by the following formulae (19). X₂ may have one structure or a combination structure of two or more.

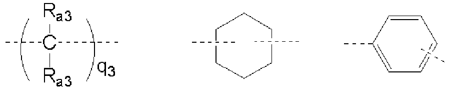

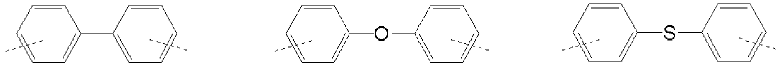

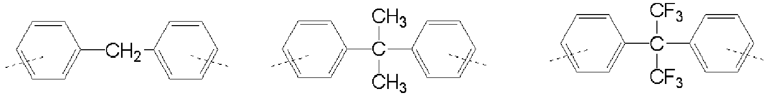

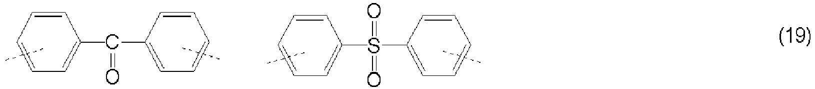

In the formulae, Rₐ₃ each independently represents a hydrogen atom, a fluorine atom, or an alkyl group having 1 to 6 carbon atoms, q₃ represents an integer of 1 to 30, and a dotted line represents an attachment point.

R₁ to R₄ in the general formula (2) are same as in the general formula (1).

X₃ in the general formula (3) represents a tetravalent organic group. X₃ may be same as or different from the X₁, and X₃ is not limited as long as X₃ represents the tetravalent organic group. X₃ preferably represents a tetravalent alicyclic aliphatic group having 4 to 40 carbon atoms or a tetravalent aromatic group having 6 to 40 carbon atoms, and optionally has a siloxane skeleton. X₃ further preferably represents a tetravalent organic group represented by the formulae (18). X₃ may have one structure or a combination structure of two or more.

"s" in the general formula (3) represents 0 or 1. In a case of s=0, the two aromatic rings in the general formula (3) are directly bonded via no divalent bonding group Z.

Meanwhile, in a case of s=1, the two aromatic rings in the general formula (3) are bonded via a divalent bonding group Z. Z is not limited as long as Z represents the divalent group. Z preferably represents a divalent alicyclic aliphatic group having 4 to 40 carbon atoms or a divalent aromatic group having 6 to 40 carbon atoms, and further preferably a divalent bonding group represented by the following formulae (20). Z may have one structure or a combination structure of two or more.

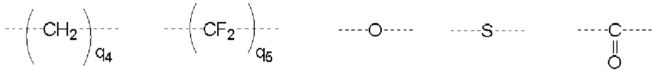

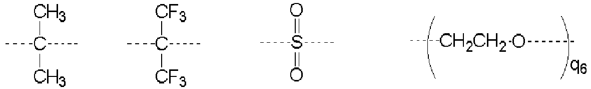

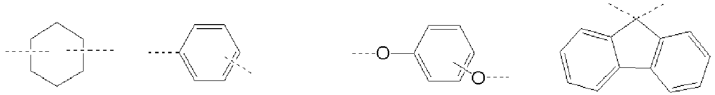

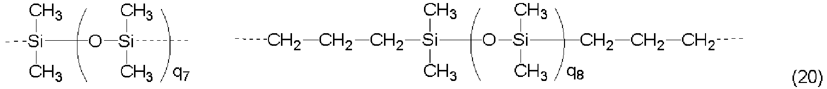

In the formulae, q₄, q₅, and q₆ represent an integer of 1 to 6, and q₇ and qe represents an integer of 1 to 10. The dotted line represents an attachment point.

The divalent bonding group Z particularly preferably represents a divalent group represented by the following general formulae (5), (6), (7), and (8). That is, the Z in the general formulae (3) and (4) preferably represents at least one bonding group selected from any one of the groups represented by the following formulae (5), (6), (7), and (8).

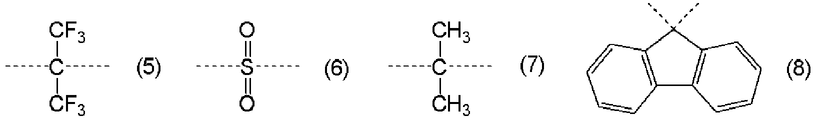

In the formulae, the dotted line represents an attachment point.

The divalent bonding group Z further preferably represents a divalent group represented by the general formula (5) or (6) .

The structural unit represented by the general formula (3) is preferably a structural unit represented by the following general formula (3-1) when Z in the general formula (3) represents the group represented by the formula (5), and is preferably a structural unit represented by the following general formula (3-2) when Z in the general formula (3) represents the group represented by the formula (6).

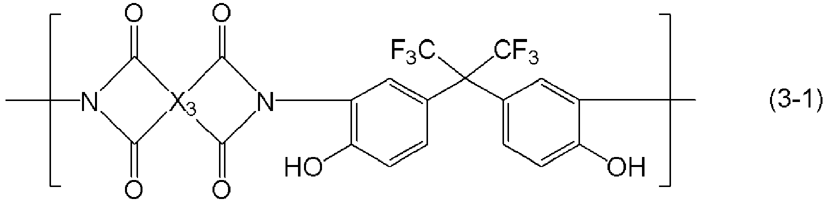

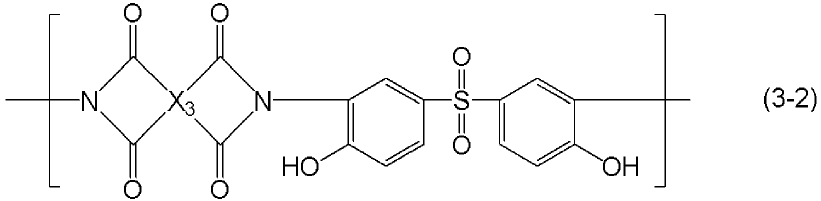

In the formulae, X₃ are same as above.

When the divalent bonding group Z represents a hexafluoropropylene group represented by the formula (5) positioned at a p-position relative to the phenolic hydroxy group as in the general formula (3-1), the hexafluoropropylene group is an electron-withdrawing group, and thereby the phenolic hydroxy group has high acidity. Thus, such a case is preferable because solubility in a developer being an alkaline aqueous solution is improved.

Similarly, when the divalent bonding group A represents a sulfone group represented by the formula (6) positioned at a p-position relative to the phenolic hydroxy group as in the general formula (3-2), the sulfone group is also an electron-withdrawing group, and thereby the phenolic hydroxy group has high acidity. Thus, such a case is preferable because solubility in a developer being an alkaline aqueous solution is improved.

X₄ in the general formula (4) represents a divalent organic group. X₄ may be same as or different from the X₂, and is not limited as long as X₄ represents the divalent organic group. X₄ preferably represents a divalent organic group having an aliphatic chain structure having 4 to 40 carbon atoms, a divalent alicyclic aliphatic group having 4 to 40 carbon atoms, or a divalent aromatic group having 6 to 40 carbon atoms. X₄ further preferably represents a divalent organic group represented by the formula (19). X₄ may have one structure or a combination structure of two or more.

A case where X₄ in the general formula (4) represents the divalent organic group being the aliphatic chain structure is preferable because the cured film of the negative-type photosensitive resin composition of the present invention has improved mechanical strength, specifically elongation.

"s" and Z in the general formula (4) are same as above, and Z is preferably the general formula (5) or (6) from the viewpoint of solubility in a developer being an alkaline aqueous solution.

The polymer (A) contained in the negative-type photosensitive resin composition of the present invention may further has any one or more structural units represented by the following general formulae (21) to (24) in addition to the structural unit represented by the general formulae (1), (2), (3), and (4).

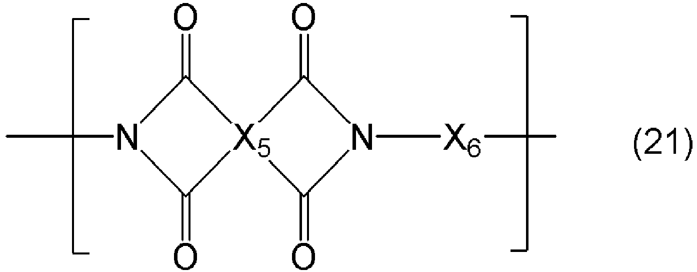

In the formula, X₅ represents a tetravalent organic group same as or different from the X₁; and X₆ represents a divalent organic group.

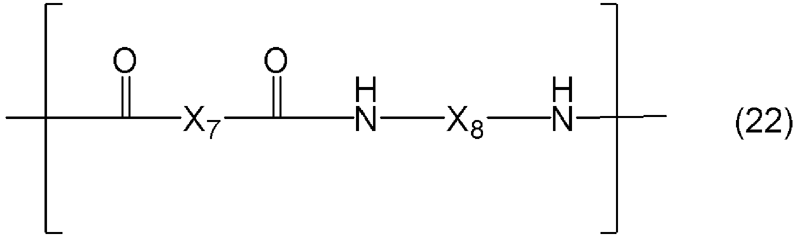

In the formula, X₇ represents a divalent organic group same as or different from the X₂; and X₈ represents a divalent organic group same as or different from the X₆.

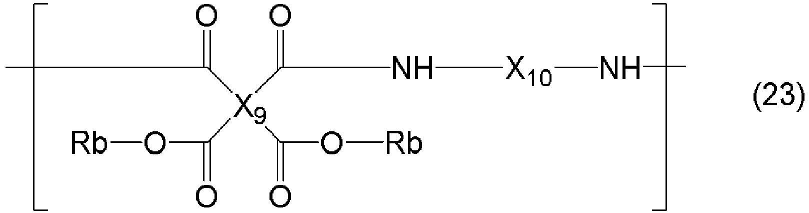

In the formula, X₉ represents a tetravalent organic group same as or different from the X₁; X₁₀ represents a divalent organic group same as or different from the X₆; Rb represents a hydrogen atom or an organic group having 1 to 10 carbon atoms, which may be same as or different from each other, which may have a heteroatom therebetween, and which may have a substituent.

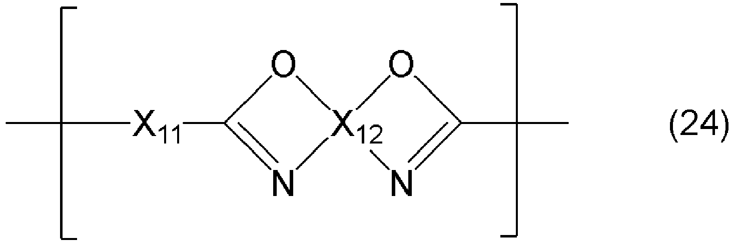

In the formula, X₁₁ represents a divalent organic group same as or different from the X₂; and X₁₂ represents a tetravalent organic group.

X₅ in the general formula (21) represents a tetravalent organic group. X₅ may be same as or different from the X₁, and is not limited as long as X₅ represents the tetravalent organic group. X₅ preferably represents a tetravalent alicyclic aliphatic group having 4 to 40 carbon atoms or a tetravalent aromatic group having 6 to 40 carbon atoms, and optionally has a siloxane skeleton, and further preferably the tetravalent organic group represented by the formulae (18). X₅ may have one structure or a combination structure of two or more.

X₆ in the general formula (21) represents a divalent organic group, and is not limited as long as X₆ represents the divalent organic group. X₆ preferably represents a divalent organic group having 6 to 40 carbon atoms. X₆ more preferably represents: a divalent cyclic organic group having one to four of aromatic rings or aliphatic rings having a substituent; or a divalent aliphatic group or siloxane group having no cyclic structure. Examples of the further preferable X₆ include a structure represented by the following formulae (25) or (26). X₆ may have one structure or a combination structure of two or more.

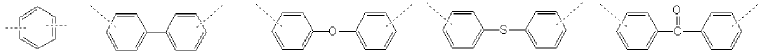

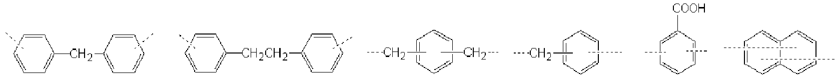

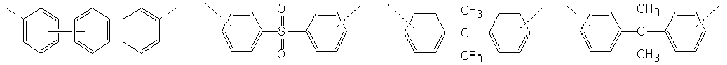

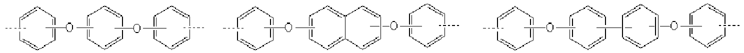

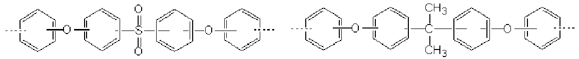

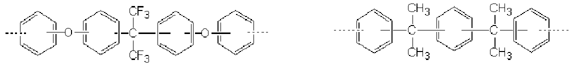

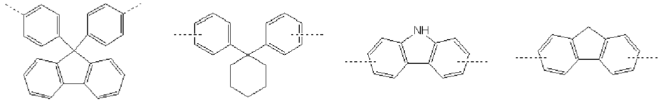

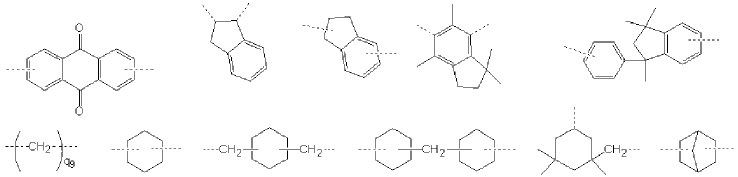

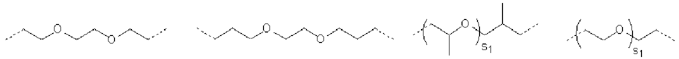

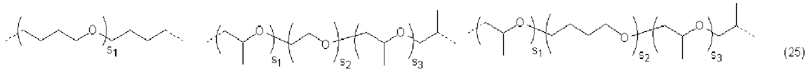

In the formulae, q₉ represents an integer of 1 to 20, s₁ represents an integer of 1 to 40, s₂ and s₃ each independently represent an integer of 0 to 40, and a dotted line represents an attachment point.

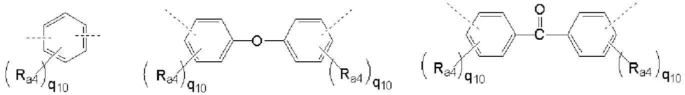

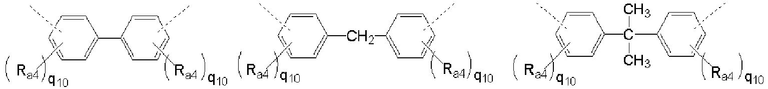

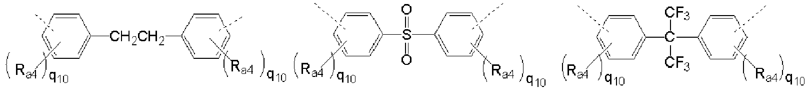

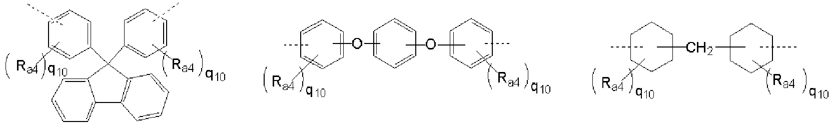

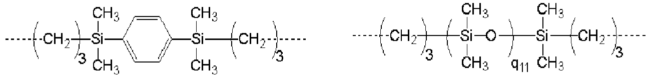

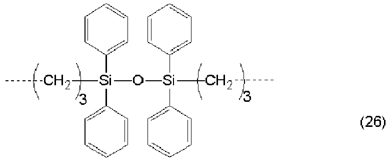

In the formulae, q₁₀ represents an integer of 1 to 4, Rₐ₄ represents a fluorine atom, a methyl group, an ethyl group, a propyl group, an n-butyl group, a methoxy group, an ethoxy group, a propoxy group, a butoxy group, or a trifluoromethyl group, when q₁₀ represents 2 or more, Rₐ₄ may be same as or different from each other, q₁₁ represents an integer of 1 to 40, and a dotted line represents an attachment point.

The negative-type photosensitive resin composition containing the polymer having the structural unit represented by the general formula (21) is preferable because the cured film obtained by the patterning can have improved mechanical properties, adhesive force to the substrate, and heat resistance. The structural unit (21) is preferable because a ring-closing reaction is not needed in post-curing, and a temperature for the curing reaction can be relatively lowered.

X₇ in the general formula (22) represents a divalent organic group. X₇ may be same as or different from the X₂, and is not limited as long as X₇ represents the divalent organic group. X₇ preferably represents a divalent organic group having an aliphatic chain structure having 4 to 40 carbon atoms, a divalent alicyclic aliphatic group having 4 to 40 carbon atoms, or a divalent aromatic group having 6 to 40 carbon atoms. X₇ further preferably represents a divalent organic group represented by the formulae (19). X₇ may have one structure or a combination structure of two or more.

X₈ in the general formula (22) represents a divalent organic group. X₈ may be same as or different from the X₆, and is not limited as long as X₈ represents the divalent organic group. X₈ preferably represents a divalent organic group having 6 to 40 carbon atoms, and preferably represents: a divalent cyclic organic group having one to four of aromatic rings or aliphatic rings having a substituent; or a divalent aliphatic group or siloxane group having no cyclic structure. Examples of the further preferable X₈ include a structure represented by the formulae (25) or (26). X₈ may have one structure or a combination structure of two or more.

The negative-type photosensitive resin composition containing the polymer having the structural unit represented by the general formula (22) is preferable because the cured film obtained by the patterning can have improved mechanical properties such as elongation and adhesive force to the substrate.

X₉ in the general formula (23) represents a tetravalent organic group. X₉ may be same as or different from the X₁, and is not limited as long as X₉ represents the tetravalent organic group. X₉ preferably represents a tetravalent alicyclic aliphatic group having 4 to 40 carbon atoms or an aromatic group having 6 to 40 carbon atoms, and optionally has a siloxane skeleton. X₉ further preferably represents a tetravalent organic group represented by the formulae (18). X₉ may have one structure or a combination structure of two or more.

X₁₀ in the general formula (23) represents a divalent organic group. X₁₀ may be same as or different from the X₆, and is not limited as long as X₁₀ represents the divalent organic group. X₁₀ preferably represents a divalent organic group having 6 to 40 carbon atoms, and preferably represents: a divalent cyclic organic group having one to four of aromatic rings or aliphatic rings having a substituent; or a divalent aliphatic group or siloxane group having no cyclic structure. Examples of the further preferable X₁₀ include a structure represented by the formulae (25) or (26). X₁₀ may have one structure or a combination structure of two or more.

The negative-type photosensitive resin composition containing the polymer having the structural unit represented by the general formula (23) is preferable because the cured film can have improved mechanical properties and adhesive force to the substrate.

X₁₁ in the general formula (24) represents a divalent organic group. X₁₁ may be same as or different from the X₂, and is not limited as long as X₁₁ represents the divalent organic group. X₁₁ preferably represents a divalent organic group having an aliphatic chain structure having 4 to 40 carbon atoms, a divalent alicyclic aliphatic group having 4 to 40 carbon atoms, or a divalent aromatic group having 6 to 40 carbon atoms. X₁₁ further preferably represents a divalent organic group represented by the formulae (19). X₁₁ may have one structure or a combination structure of two or more.

X₁₂ in the general formula (24) represents a tetravalent organic group. X₁₂ is not limited as long as X₁₂ represents the tetravalent organic group. X₁₂ preferably represents a tetravalent organic group having 6 to 40 carbon atoms, and more preferably represents: a tetravalent cyclic organic group having one to four of aromatic rings or aliphatic rings having a substituent; or a tetravalent aliphatic group or siloxane group having no cyclic structure. Examples of the further preferable X₁₂ include a structure represented by the following formulae (27). X₁₂ may have one structure or a combination structure of two or more.

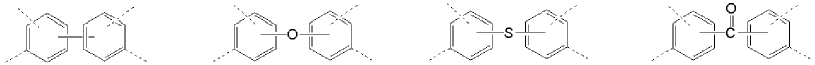

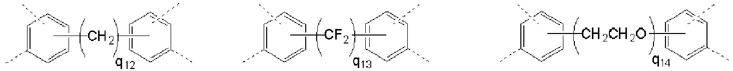

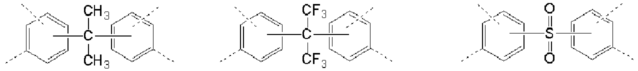

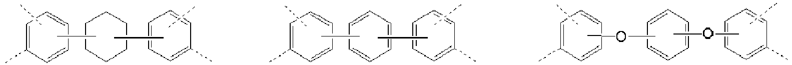

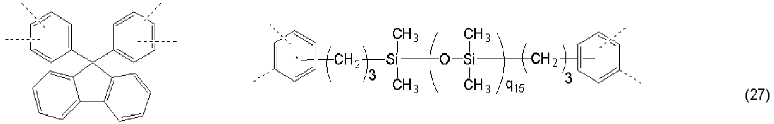

In the formulae, q₁₂, q₁₃, and q₁₄ represent an integer of 1 to 10, q₁₅ represents an integer of 1 to 20, and a dotted line represents an attachment point.

The negative-type photosensitive resin composition containing the polymer having the structural unit represented by the general formula (24) is preferable because the cured film obtained by the patterning can have improved mechanical properties, adhesive force to the substrate, and heat resistance. The composition having the structure represented by the formulae (27) is preferable because a ring-closing reaction is not needed in post-curing, and a temperature for the curing reaction can be relatively lowered.

A molecular weight of the polymer (A) is preferably 5,000 to 100,000, and more preferably 7,000 to 50,000. The molecular weight of 5,000 or more allows the negative-type photosensitive resin composition of the present invention containing the polymer (A) to easily form a film on the substrate with a desired film thickness. The molecular weight of 100,000 or less does not considerably increase a viscosity of the negative-type photosensitive resin composition, and causes no risk of failure of the film formation. In the present invention, the weight-average molecular weight is a value by gel permeation chromatography (GPC) in terms of polystyrene.

### Method for Manufacturing Polymer (A)

The polymer (A) has a structural unit represented by the following general formula (1) and/or (2) and a structural unit represented by the following general formula (3) and/or (4) .

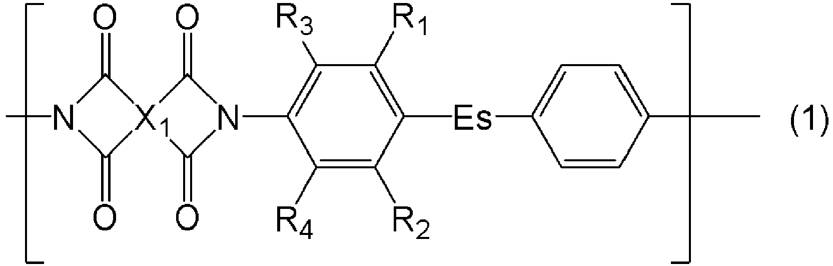

In the formula, X₁, R₁ to R₄, and Es are same as above.

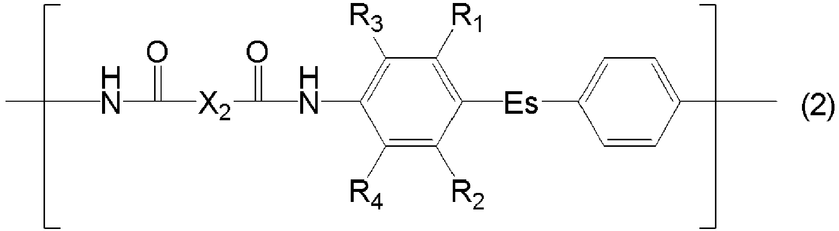

In the formula, X₂, R₁ to R₄, and Es are same as above.

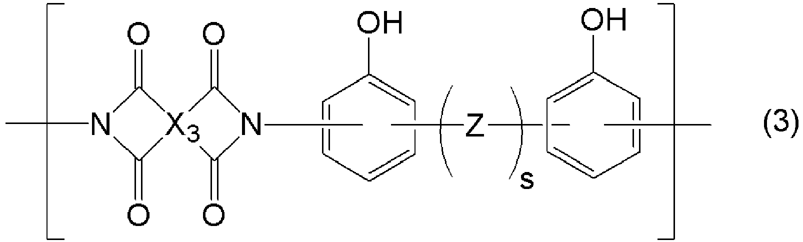

In the formula, X₃, Z, and "s" are same as above.

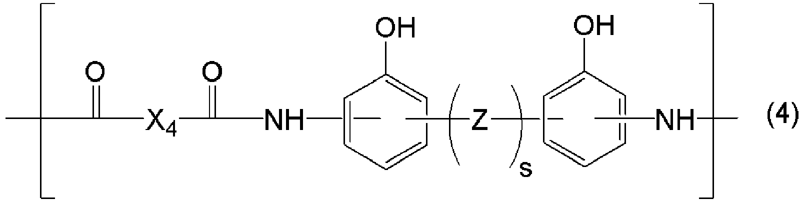

In the formula, X₄, Z, and "s" are same as above.

The polymer having the structural unit represented by the general formula (1) can be obtained by reacting a tetracarboxylic dianhydride represented by the following general formula (28) and a diamine represented by the following general formula (29). First, the tetracarboxylic dianhydride represented by the following general formula (28) and the diamine represented by the following general formula (29) are reacted to synthesize an amic acid, and then an imide ring is formed by heating-dehydration to obtain the polymer having the structural unit (1).

The structural unit (1) can be manufactured by dissolving the diamine in a solvent having a high boiling point and high polarity, such as γ-butyrolactone and N-methyl-2-pyrrolidone, then adding the acid anhydride, allowing a reaction at 0 to 80°C, preferably 10 to 50°C, to form the amic acid, then adding a nonpolar solvent such as xylene, and heating the mixture at 100 to 200°C, preferably 130 to 180°C, to perform an imidization reaction while removing water from the reaction system.

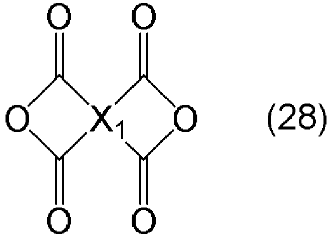

In the formula, X₁ is same as above.

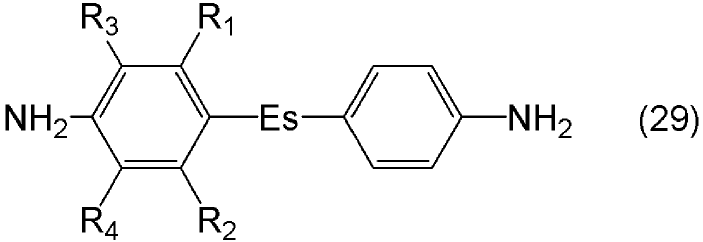

In the formula, R₁ to R₄ and Es are same as above.

Examples of the preferable tetracarboxylic dianhydride represented by the general formula (28) include an aromatic acid dianhydride, an alicyclic acid dianhydride, an aliphatic acid dianhydride, and a siloxane-skeleton-containing acid dianhydride.

Examples of the aromatic acid dianhydride include, but not limited to, pyromellitic dianhydride, 3,3',4,4'-biphenyltetracarboxylic dianhydride, 2,3,3',4'-biphenyltetracarboxylic dianhydride, 2,3,2',3'-biphenyltetracarboxylic dianhydride, 3,3',4,4'-terphenyltetracarboxylic dianhydride, 3,3',4,4'-oxyphthalic dianhydride, 2,3,3',4'-oxyphthalic dianhydride, 2,3,2',3'-oxyphthalic dianhydride, diphenylsulfone-3,3',4,4'-tetracarboxylic dianhydride, benzophenone-3,3',4,4'-tetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, 1,4-(3,4-dicarboxyphenoxy)benzene dianhydride, p-phenylenebis(trimellitic monoester anhydride), bis(1,3-dioxo-1,3-dihydroisobenzofuran-5-carboxylic acid)-1,4-phenylene, 2,2-bis(4-(4-aminophenoxy)phenyl)propane, 1,2,5,6-naphthalenetetracarboxylic dianhydride, 2,3,6,7-naphthalenedicarboxylic dianhydride, 9,9-bis(3,4-dicarboxyphenyl)fluorene dianhydride, 9,9-bis(4-(3,4-dicarboxyphenoxy)phenyl)fluorene dianhydride, 2,3,5,6-pyridinetetracarboxylic dianhydride, 3,4,9,10-perylenetetracarboxylic dianhydride, 2,2-bis(3,4-dicarboxyphenyl)hexafluoropropane dianhydride, 2,2-bis(4-(3,4-dicarboxybenzoyloxy)phenyl)hexafluoropropane dianhydride, 1,6-difluoropyromellitic dianhydride, 1-trifluoromethylpyromellitic dianhydride, 1,6-ditrifluoromethylpyromellitic dianhydride, 2,2'-bis(trifluoromethyl)-4,4'-bis(3,4-dicarboxyphenoxy)biphenyl dianhydride, 2,2'-bis[(dicarboxyphenoxy)phenyl]propane dianhydride, and 2,2'-bis[(dicarboxyphenoxy)phenyl]hexafluoropropane dianhydride, or acid dianhydride compounds in which these aromatic rings are substituted with an alkyl group, an alkoxy group, a halogen atom, etc.

Examples of the alicyclic acid dianhydride include, but not limited to, 1,2,3,4-cyclobutanetetracarboxylic dianhydride, 1,2,3,4-cyclopentanetetracarboxylic dianhydride, 1,2,4,5-cyclohexanetetracarboxylic dianhydride, 1,2,4,5-cyclopentanetetracarboxylic dianhydride, 1,2,3,4-tetramethyl-1,2,3,4-cyclobutanetetracarboxylic dianhydride, 1,2-dimethyl-1,2,3,4-cyclobutanetetracarboxylic dianhydride, 1,3-dimethyl-1,2,3,4-cyclobutanetetracarboxylic dianhydride, 1,2,3,4-cycloheptanetetracarboxylic dianhydride, 2,3,4,5-tetrahydrofurantetracarboxylic dianhydride, 3,4-dicarboxy-1-cyclohexylsuccinic dianhydride, 2,3,5-tricarboxycyclopentylacetic dianhydride, 3,4-dicarboxy-1,2,3,4-tetrahydro-1-naphthalenesuccinic dianhydride, bicyclo[3,3,0]octane-2,4,6,8-tetracarboxylic dianhydride, bicyclo[4,3,0]nonane-2,4,7,9-tetracarboxylic dianhydride, bicyclo[4,4,0]decane-2,4,7,9-tetracarboxylic dianhydride, bicyclo[4,4,0]decane-2,4,8,10-tetracarboxylic dianhydride, tricyclo[6,3,0,0^{2,6}]undecane-3,5,9,11-tetracarboxylic dianhydride, bicyclo[2,2,2]octane-2,3,5,6-tetracarboxylic dianhydride, bicyclo[2,2,2]oct-7-ene-2,3,5,6-tetracarboxylic dianhydride, bicyclo[2,2,1]heptanetetracarboxylic dianhydride, bicyclo[2,2,1]heptane-5-carboxymethyl-2,3,6-tricarboxylic dianhydride, 7-oxabicyclo[2,2,1]heptane-2,4,6,8-tetracarboxylic dianhydride, octahydronaphthalene-1,2,6,7-tetracarboxylic dianhydride, tetradecahydroanthracene-1,2,8,9-tetracarboxylic dianhydride, 3,3',4,4'-dicyclohexanetetracarboxylic dianhydride, 3,3',4,4'-oxydicyclohexanetetracarboxylic dianhydride, 5-(2,5-dioxotetrahydro-3-furanyl)-3-methyl-3-cyclohexene-1,2-dicarboxylic dianhydride, "RIKACID" (R) BT-100 (the above is a trade name, manufactured by New Japan Chemical Co., Ltd.), and derivatives thereof or acid dianhydride compounds in which these aliphatic rings are substituted with an alkyl group, an alkoxy group, a halogen atom, etc.

Examples of the aliphatic dianhydride include, but not limited to, 1,2,3,4-butanetetracarboxylic dianhydride, 1,2,3,4-pentanetetracarboxylic dianhydride, and derivatives thereof.

Examples of the siloxane-skeleton-containing acid dianhydride include, but not limited to, 1,3-bis(3,4-dicarboxyphenyl)-1,1,3,3-tetramethyldisiloxane dianhydride, 3,3'-((1,1,3,3-tetramethyl-1,3-disiloxanediyl)-di-3,1-propanediyl)-bis(dihydro-2,5-furandione), and derivatives thereof.

These aromatic acid dianhydride, alicyclic acid dianhydride, aliphatic acid dianhydride, and siloxane-skeleton-containing acid dianhydride may be used singly or may be used in combination of two or more.

Examples of the preferable diamine represented by the general formula (29) include, but not limited to, (2-methyl-4-amino)phenyl 4-aminobenzoate, (3-methyl-4-amino)phenyl 4-aminobenzoate, (2-ethyl-4-amino)phenyl 4-aminobenzoate, (3-ethyl-4-amino)phenyl 4-aminobenzoate, (2-propyl-4-amino)phenyl 4-aminobenzoate, (3-propyl-4-amino)phenyl 4-aminobenzoate, (2-isopropyl-4-amino)phenyl 4-aminobenzoate, (3-isopropyl-4-amino)phenyl 4-aminobenzoate, (2-butyl-4-amino)phenyl 4-aminobenzoate, (3-butyl-4-amino)phenyl 4-aminobenzoate, (2-isobutyl-4-amino)phenyl 4-aminobenzoate, (3-isobutyl-4-amino)phenyl 4-aminobenzoate, (2-pentyl-4-amino)phenyl 4-aminobenzoate, (3-pentyl-4-amino)phenyl 4-aminobenzoate, (2-hexyl-4-amino)phenyl 4-aminobenzoate, (3-hexyl-4-amino)phenyl 4-aminobenzoate, (2-methoxy-4-amino)phenyl 4-aminobenzoate, (3-methoxy-4-amino)phenyl 4-aminobenzoate, (2-ethoxy-4-amino)phenyl 4-aminobenzoate, (3-ethoxy-4-amino)phenyl 4-aminobenzoate, (2-propoxy-4-amino)phenyl 4-aminobenzoate, (3-propoxy-4-amino)phenyl 4-aminobenzoate, (2-butoxy-4-amino)phenyl 4-aminobenzoate, (3-butoxy-4-amino)phenyl 4-aminobenzoate, (2-pentoxy-4-amino)phenyl 4-aminobenzoate, (3-pentoxy-4-amino)phenyl 4-aminobenzoate, (2-phenyl-4-amino)phenyl 4-aminobenzoate, (3-phenyl-4-amino)phenyl 4-aminobenzoate, (2-methylphenyl-4-amino)phenyl 4-aminobenzoate, (3-methylphenyl-4-amino)phenyl 4-aminobenzoate, (2-ethylphenyl-4-amino)phenyl 4-aminobenzoate, (3-ethylphenyl-4-amino)phenyl 4-aminobenzoate, (2-propylphenyl-4-amino)phenyl 4-aminobenzoate, (3-propylphenyl-4-amino)phenyl 4-aminobenzoate, (2-butylphenyl-4-amino)phenyl 4-aminobenzoate, (3-butylphenyl-4-amino)phenyl 4-aminobenzoate, (2-fluorophenyl-4-amino)phenyl 4-aminobenzoate, (3-fluorophenyl-4-amino)phenyl 4-aminobenzoate, (2-chlorophenyl-4-amino)phenyl 4-aminobenzoate, (3-chlorophenyl-4-amino)phenyl 4-aminobenzoate, (2-bromophenyl-4-amino)phenyl 4-aminobenzoate, (3-bromophenyl-4-amino)phenyl 4-aminobenzoate, (2-methoxyphenyl-4-amino)phenyl 4-aminobenzoate, (3-methoxyphenyl-4-amino)phenyl 4-aminobenzoate, (2-ethoxyphenyl-4-amino)phenyl 4-aminobenzoate, (3-ethoxyphenyl-4-amino)phenyl 4-aminobenzoate, (2-aminophenyl-4-amino)phenyl 4-aminobenzoate, (3-aminophenyl-4-amino)phenyl 4-aminobenzoate, (2-nitrophenyl-4-amino)phenyl 4-aminobenzoate, (3-nitrophenyl-4-amino)phenyl 4-aminobenzoate, (2-cyanophenyl-4-amino)phenyl 4-aminobenzoate, (3-cyanophenyl-4-amino)phenyl 4-aminobenzoate, (2-phenylethyl-4-amino)phenyl 4-aminobenzoate, (3-phenylethyl-4-amino)phenyl 4-aminobenzoate, (2-phenylamino-4-amino)phenyl 4-aminobenzoate, (3-phenylamino-4-amino)phenyl 4-aminobenzoate, (2-(4,4'-biphenyl)-4-amino)phenyl 4-aminobenzoate, (3-(4,4'-biphenyl)-4-amino)phenyl 4-aminobenzoate, (2-naphthyl-4-amino)phenyl 4-aminobenzoate, (3-naphthyl-4-amino)phenyl 4-aminobenzoate, (2-methylphenoxy-4-amino)phenyl 4-aminobenzoate, (3-methylphenoxy-4-amino)phenyl 4-aminobenzoate, (2-ethylphenoxy-4-amino)phenyl 4-aminobenzoate, (3-ethylphenoxy-4-amino)phenyl 4-aminobenzoate, (2-propylphenoxy-4-amino)phenyl 4-aminobenzoate, (3-propylphenoxy-4-amino)phenyl 4-aminobenzoate, (2-methoxyphenoxy-4-amino)phenyl 4-aminobenzoate, (3-methoxyphenoxy-4-amino)phenyl 4-aminobenzoate, (2-ethoxyphenoxy-4-amino)phenyl 4-aminobenzoate, (3-ethoxyphenoxy-4-amino)phenyl 4-aminobenzoate, (2-benzyl-4-amino)phenyl 4-aminobenzoate, (3-benzyl-4-amino)phenyl 4-aminobenzoate, (2-methylbenzyl-4-amino)phenyl 4-aminobenzoate, (3-methylbenzyl-4-amino)phenyl 4-aminobenzoate, (2-ethylbenzyl-4-amino)phenyl 4-aminobenzoate, (3-ethylbenzyl-4-amino)phenyl 4-aminobenzoate, (2-propylbenzyl-4-amino)phenyl 4-aminobenzoate, (3-propylbenzyl-4-amino)phenyl 4-aminobenzoate, (2-methoxybenzyl-4-amino)phenyl 4-aminobenzoate, (3-methoxybenzyl-4-amino)phenyl 4-aminobenzoate, (2-ethoxybenzyl-4-amino)phenyl 4-aminobenzoate, (3-ethoxybenzyl-4-amino)phenyl 4-aminobenzoate, (2-aminobenzyl-4-amino)phenyl 4-aminobenzoate, (3-aminobenzyl-4-amino)phenyl 4-aminobenzoate, (2-nitrobenzyl-4-amino)phenyl 4-aminobenzoate, (3-nitrobenzyl-4-amino)phenyl 4-aminobenzoate, (2-cyanobenzyl-4-amino)phenyl 4-aminobenzoate, (3-cyanobenzyl-4-amino)phenyl 4-aminobenzoate, (2-benzyloxy-4-amino)phenyl 4-aminobenzoate, (3-benzyloxy-4-amino)phenyl 4-aminobenzoate, (2-methylbenzyloxy-4-amino)phenyl 4-aminobenzoate, (3-methylbenzyloxy-4-amino)phenyl 4-aminobenzoate, (2-ethylbenzyloxy-4-amino)phenyl 4-aminobenzoate, (3-ethylbenzyloxy-4-amino)phenyl 4-aminobenzoate, (2-propylbenzyloxy-4-amino)phenyl 4-aminobenzoate, (3-propylbenzyloxy-4-amino)phenyl 4-aminobenzoate, (2-methoxybenzyloxy-4-amino)phenyl 4-aminobenzoate, (3-methoxybenzyloxy-4-amino)phenyl 4-aminobenzoate, (2-ethoxybenzyloxy-4-amino)phenyl 4-aminobenzoate, and (3-ethoxybenzyloxy-4-amino)phenyl 4-aminobenzoate.

Meanwhile, the polymer having the structural unit represented by the general formula (2) can be obtained by reacting a dicarboxylic acid compound represented by the following general formula (30) and the diamine represented by the general formula (29).

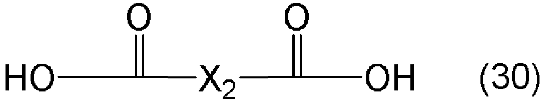

In the formula, X₂ is same as above.

Here, the polymer having the structural unit (2) can be obtained by, for example, reacting the dicarboxylic acid compound represented by the general formula (30) and the diamine represented by the general formula (29) in the presence of a dehydrative condensing agent. Specifically, the dicarboxylic acid compound represented by the general formula (30) is used for the reaction as a dissolved state in a reaction solvent, a known dehydrative condensing agent (for example, dicyclohexylcarbodiimide, 1-ethoxycarbonyl-2-ethoxy-1,2-dihydroquinoline, 1,1-carbonyldioxy-di-1,2,3-benzotriazole, N,N'-disuccineimidyl carbonate, etc.) is fed and mixed in the above reaction solution under ice cooling to convert the dicarboxylic compound represented by the general formula (30) into an acid anhydride, and a mixture in which the diamine represented by the general formula (29) is separately dissolved or dispersed is fed dropwise for polycondensation to obtain the polymer having the structural unit (2).

Another method for obtaining the polymer having the structural unit (2) by reacting the dicarboxylic acid compound represented by the general formula (30) and the diamine represented by the general formula (29) (diamine compound) is a synthesis method of converting the dicarboxylic acid compound represented by the general formula (30) into an acid chloride by using a chlorinating agent such as thionyl chloride or dichlorooxalic acid to react with the diamine represented by the general formula (29).

For the reaction of converting the above dicarboxylic acid compound into the acid chloride by using the chlorinating agent, a basic compound may be used. As this basic compound, pyridine, N,N-dimethyl-4-aminopyridine, triethylamine, etc. may be used, for example.

Then, the obtained acid chloride of the dicarboxylic acid compound is allowed to react with the diamine represented by the general formula (29) in the presence of a basic catalyst to obtain the target polymer having the structural unit (2). In this case, examples of the basic catalyst include pyridine, N,N-dimethyl-4-aminopyridine, 1,8-diazabicyclo[5.4.0]undec-7-ene, and 1,5-diazabicyclo[4.3.0]non-5-ene. These basic catalysts may be used singly, or may be used in combination of two or more.

In the method via the acid chloride among the methods for manufacturing the polymer (A), a used solvent is preferably a solvent that sufficiently dissolves the dicarboxylic acid compound, the acid chloride thereof, and the polymer obtained by the polycondensation reaction with the diamines. Specific examples thereof include N-methyl-2-pyrrolidone, N,N-dimethylacetamide, N,N-dimethylformamide, dimethyl sulfoxide, tetramethylurea, hexamethylphosphoric triamide, and γ-butyrolactone. Other than the polar solvents, ketones, esters, lactones, ethers, halogenated hydrocarbons, hydrocarbons, etc. may also be used. Examples thereof include acetone, diethyl ketone, methyl ethyl ketone, methyl isobutyl ketone, cyclohexanone, methyl acetate, ethyl acetate, butyl acetate, diethyl oxalate, diethyl malonate, diethyl ether, ethylene glycol dimethyl ether, diethylene glycol dimethyl ether, tetrahydrofuran, dichloromethane, 1,2-dichloroethane, 1,4-dichlorobutane, trichloroethane, chlorobenzene, o-dichlorobenzene, hexane, heptane, octane, benzene, toluene, and xylene. These organic solvents may be singly, or may be used in combination of two or more.

Examples of the preferable X₂ in the dicarboxylic acid compound represented by the general formula (30) include the above example.

Examples of the dicarboxylic acid compound represented by the general formula (30) include malonic acid, dimethylmalonic acid, ethylmalonic acid, isopropylmalonic acid, di-n-butylmalonic acid, succinic acid, tetrafluorosuccinic acid, methylsuccinic acid, 2,2-dimethylsuccinic acid, 2,3-dimethylsuccinic acid, dimethylmethylsuccinic acid, glutaric acid, hexafluoroglutaric acid, 2-methylglutaric acid, 3-methylglutaric acid, 2,2-dimethylglutaric acid, 3,3-dimethylglutaric acid, 3-ethyl-3-methylgluratic acid, adipic acid, octafluoroadipic acid, 3-methyladipic acid, pimelic acid, 2,2,6,6-tetramethylpimelic acid, suberic acid, dodecafluorosuberic acid, azelaic acid, sebacic acid, hexadecafluorosebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, eicosanedioic acid, henicosanedioic acid, docosanedioic acid, tricosanedioic acid, tetracosanedioic acid, pentacosanedioic acid, hexacosanedioic acid, heptacosanedioic acid, octacosanedioic acid, nonacosanedioic acid, triacontanedioic acid, hentriacontaneoic acid, dotriacontanedioic acid, and diglycolic acid.

Furthermore, examples of the dicarboxylic compound having an aromatic ring include, but not limited to, phthalic acid, isophthalic acid, terephthalic acid, 4,4'-diphenyl ether dicarboxylic acid, 3,4'-diphenyl ether dicarboxylic acid, 3,3'-diphenyl ether dicarboxylic acid, 4,4'-biphenyldicarboxylic acid, 3,4'-biphenyldicarboxylic acid, 3,3'-biphenyldicarboxylic acid, 4,4'-benzophenonedicarboxylic acid, 3,4'-benzophenonedicarboxylic acid, 3,3'-benzophenonedicarboxylic acid, 4,4'-hexafluoroisopropylidene dibenzoic acid, 4,4'-dicarboxyldiphenylamide, 1,4-phenylenediethanoic acid, bis(4-carboxyphenyl) sulfide, 2,2-bis(4-carboxyphenyl)-1,1,1,3,3,3-hexafluoropropane, bis(4-carboxyphenyl)tetraphenyldisiloxane, bis(4-carboxyphenyl)tetramethyldisiloxane, bis(4-carboxyphenyl) sulfone, bis(4-carboxyphenyl)methane, 5-tert-butylisophthalic acid, 5-bromoisophthalic acid, 5-fluoroisophthalic acid, 5-chloroisophthalic acid, 2,2-bis-(p-carboxylphenyl)propane, and 2,6-naphthalenedicarboxylic acid. These may be used singly, or may be used in combination of two or more.

Meanwhile, the polymer having the structural unit (3) can be obtained by performing the reaction procedure same as for the structural unit (1). Specifically, the polymer having the structural unit (3) can be obtained by reacting the tetracarboxylic dianhydride represented by the general formula (31) and a diamine represented by the following general formula (32). First, the tetracarboxylic dianhydride represented by the general formula (31) and the diamine represented by the following general formula (32) are reacted to synthesize an amic acid, and then an imide ring is formed by heating-dehydration to obtain the polymer having the structural unit (3).

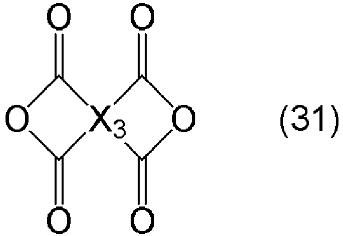

In the formula, X₃ is same as above.

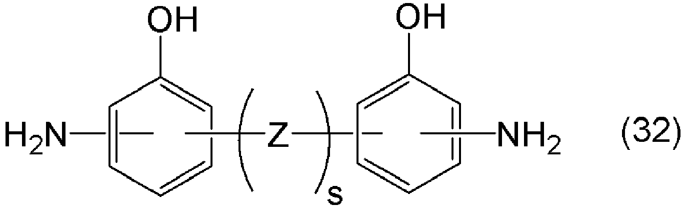

In the formula, "s" and Z are same as above.

Preferable examples of the tetracarboxylic dianhydride represented by the general formula (31) include the examples described in the tetracarboxylic dianhydride represented by the general formula (28).

Meanwhile, "s" in the general formula (32) represents 0 or 1, and in a case of s=0, the two aromatic rings in the general formula (32) are directly linked via no divalent bonding group Z.

When "s" in the general formula (32) is s=1, Z in the general formula (32) is not limited as long as Z represents the divalent group. As noted above, Z preferably represents the divalent alicyclic aliphatic group having 4 to 40 carbon atoms or the divalent aromatic group having 6 to 40 carbon atoms, and more preferably represents the divalent bonding group represented by the formula (20). Z may have one structure or a combination structure of two or more.

Further, a preferable example of the diamine represented by the general formula (32) is a compound represented by the following formula (33), (34), (35), or (36).

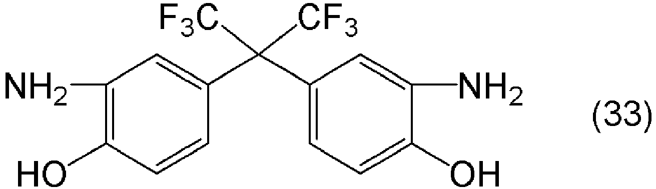

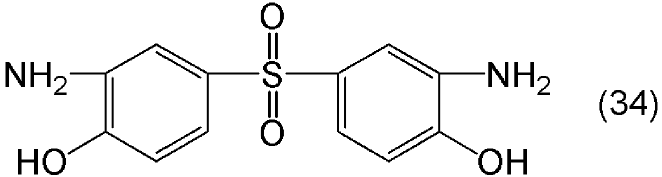

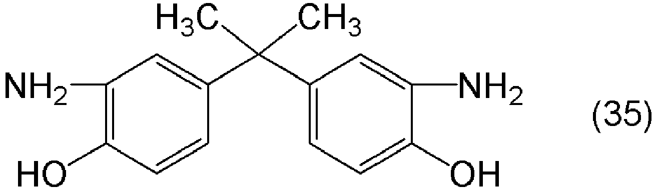

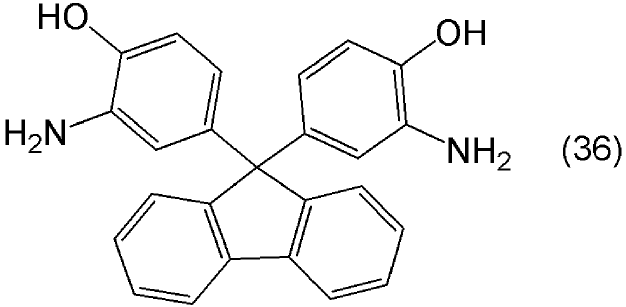

Further, a particularly preferable example of the diamine represented by the general formula (32) is the compounds represented by the formula (33) or (34).

The polymer obtained by reacting the diamine represented by the formula (33) and the tetracarboxylic dianhydride represented by the general formula (31) is the polymer having the structural unit represented by the general formula (3-1), which is a preferable structural unit.

Meanwhile, the polymer obtained by reacting the diamine represented by the formula (34) and the tetracarboxylic dianhydride represented by the general formula (31) is the polymer having the structural unit represented by the general formula (3-2), which is a preferable structural unit.

Meanwhile, the polymer having the structural unit (4) can be obtained by performing the reaction procedure same as for the structural unit (2). Specifically, the polymer having the structural unit (4) can be obtained by a reaction of a dicarboxylic acid compound represented by the following general formula (37) in the presence of a dehydrative crosslinking agent or by a reaction of converting the dicarboxylic acid compound into an acid chloride by using a chlorinating agent, and then reacting the acid chloride with the diamine represented by the general formula (32).

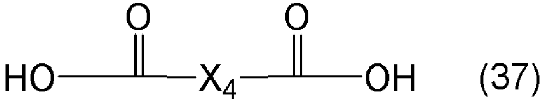

In the formula, X₄ is same as above.

Preferable examples of the dicarboxylic acid compound represented by the general formula (37) include the examples described as the dicarboxylic acid compound represented by the general formula (30).

As noted above, the polymer (A) contained in the negative-type photosensitive resin composition of the present invention may further have a structural unit represented by the following general formula (21) in addition to the structural units represented by the general formulae (1), (2), (3), and (4).

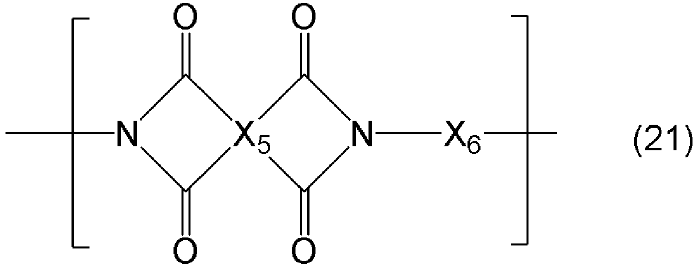

In the formula, X₅ and X₆ are same as above.

The polymer having the structural unit represented by the general formula (21) can be obtained by performing the reaction procedure same as for the structural unit (1). Specifically, the polymer having the structural unit represented by the general formula (21) can be obtained by a reaction between a tetracarboxylic dianhydride represented by the following general formula (38) and a diamine represented by the following general formula (39) to synthesize an amic acid, and then forming an imide ring via a heating-dehydration process.

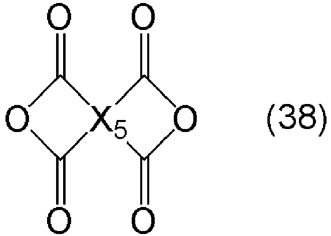

In the formula, X₅ is same as above.

**NH₂-X₆-NH₂** **(39)**

In the formula, X₆ is same as above.

Preferable examples of the tetracarboxylic dianhydride represented by the general formula (38) include the example described as the tetracarboxylic dianhydride represented by the general formula (28).

Examples of the diamine represented by the general formula (39) include an aromatic diamine, an alicyclic diamine, an aliphatic diamine, and a polyether diamine.

Examples of a preferable aromatic diamine include, but not limited to, 3,4'-diaminodiphenyl ether, 4,4'-diaminodiphenyl ether, 3,4'-diaminodiphenylmethane, 4,4'-diaminodiphenylmethane, 3,3'-diaminodiphenyl sulfone, 3,4'-diaminodiphenyl sulfone, 4,4'-diaminodiphenyl sulfone, 3,4'-diaminodiphenyl sulfide, 4,4'-diaminodiphenyl sulfide, 1,4-bis(4-aminophenoxy)benzene, benzidine, 2,2'-bis(trifluoromethyl)benzidine, 3,3'-bis(trifluoromethyl)benzidine, 2,2'-dimethylbenzidine, 3,3'-dimethylbenzidine, 2,2',3,3'-tetramethylbenzidine, 2,2'-dichlorobenzidine, 3,3'-dichlorobenzidine, 2,2',3,3'-tetrachlorobenzidine, m-phenylenediamine, p-phenylenediamine, 1,5-naphthalenediamine, 2,6-naphthalenediamine, bis(4-aminophenoxyphenyl) sulfone, bis(3-aminophenoxyphenyl) sulfone, bis[4-(3-aminophenoxy)phenyl] sulfone, bis(4-aminophenoxy)biphenyl, bis{4-(4-aminophenoxy)phenyl} ether, 1,4-bis(4-aminophenoxy)benzene, 9,9-bis(4-aminophenyl)fluorene, 2,2'-bis[3-(3-aminobenzamide)-4-hydroxyphenyl]hexafluoropropane, 4-aminophenyl 4'-aminobenzoate, and 4,4'-diaminobenzanilide, or diamine compounds in which these aromatic rings are substituted with an alkyl group, an alkoxy group, a halogen atom, etc.

Examples of the alicyclic diamine include, but not limited to, cyclobutanediamine, isophoronediamine, bicyclo[2,2,1]heptanebismethylamine, tricyclo [3,3,1,1^{3,7}]decane-1,3-diamine, 1,2-cyclohexyldiamine, 1,3-cyclohexyldiamine, 1,4-diaminocyclohexane, trans-1,4-diaminocyclohexane, cis-1,4-diaminocyclohexane, 4,4'-diaminocyclohexylmethane, 3,3'-dimethyl-4,4'-diaminodicyclohexylmethane, 3,3'-diethyl-4,4'-diaminodicyclohexylmethane, 3,3'5,5'-tetramethyl-4,4'-diaminodicyclohexylmethane, 3,3'5,5'-tetraethyl-4,4'-diaminodicyclohexylmethane, 3,5-diethyl-3',5'-dimethyl-4,4'-diaminodicyclohexylmethane, 4,4'-diaminodicyclohexyl ether, 3,3'-dimethyl-4,4'-diaminodicyclohexyl ether, 3,3'-diethyl-4,4'-diaminodicyclohexyl ether, 3,3',5,5'-tetramethyl-4,4'-diaminodicyclohexyl ether, 3,3',5,5'-tetraethyl-4,4'-diaminodicyclohexyl ether, 3,5-diethyl-3',5'-dimethyl-4,4'-diaminodicyclohexyl ether, 2,2-bis(4-aminocyclohexyl)propane, 2,2-bis(3-methyl-4-aminocyclohexyl)propane, 2,2-bis(3-ethyl-4-aminocyclohexyl)propane, 2,2-bis(3,5-dimethyl-4-aminocyclohexyl)propane, and 2,2-(3,5-diethyl-3',5'-dimethyl-4,4'-diaminodicyclohexyl)propane, or diamine compounds in which these aliphatic rings are substituted with an alkyl group, an alkoxy group, a halogen atom, etc.

Examples of the aliphatic diamine include, but not limited to: alkylenediamines, such as ethylenediamine, 1,3-diaminopropane, 1,4-diaminobutane, 1,5-diaminopentane, 1,6-diaminohexane, 1,7-diaminoheptane, 1,8-diaminooctane, 1,9-diaminononane, and 1,10-diaminodecane; bis(aminomethyl) ether, bis(2-aminoethyl) ether; and siloxanediamines, such as 1,3-bis(3-aminopropyl)tetramethyldisiloxane, 1,3-bis(4-aminobutyl)tetramethyldisiloxane, and α,ω-bis(3-aminopropyl)polydimethylsiloxane.

Examples of the polyetherdiamine include, but not limited to, 1,2-bis(aminoethoxy)ethane, HK-511, ED-600, ED-900, ED-2003, EDR-148, EDR-176, D-230, D-400, D-2000, THF-100, THF-140, THF-170, RE-600, RE-900, RE-2000, RP-405, RP-409, RP-2005, RP-2009, RT-1000, HE-1000, and HT-1700 (the above are trade names, manufactured by Huntsman Corporation). These may be used singly, or may be mixed for use.

These aromatic diamine, alicyclic diamine, aliphatic diamine, and polyetherdiamine may be used singly, or may be used in combination of two or more.

In addition, the siloxanediamines may also be suitably used.

As noted above, the polymer (A) contained in the negative-type photosensitive resin composition of the present invention may further have a structural unit represented by the following general formula (22) in addition to the structural units represented by the general formulae (1), (2), (3), and (4).

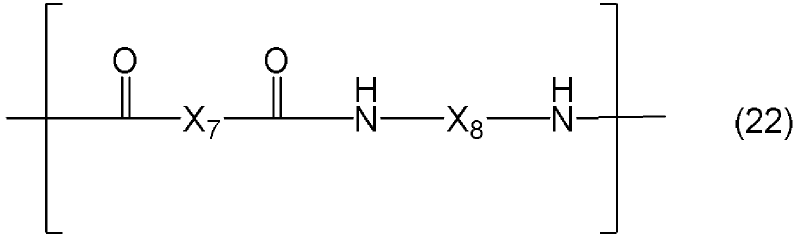

In the formula, X₇ and X₈ are same as above.

The polymer having the structural unit represented by the general formula (22) can be obtained by performing the reaction procedure same as for the structural unit (2). Specifically, the polymer having the structural unit represented by the general formula (22) can be obtained by a reaction of a dicarboxylic acid compound represented by the following general formula (40) in the presence of a dehydrative condensing agent or by a reaction of converting the dicarboxylic acid compound into an acid chloride by using a chlorinating agent, and then reacting the acid chloride with a diamine represented by the general formula (41).

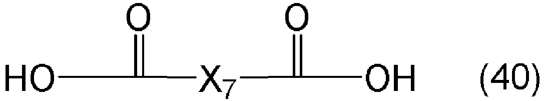

In the formula, X₇ is same as above.

**NH₂-X₈-NH₂** **(41)**

In the formula, X₈ is same as above.

Preferable examples of the dicarboxylic acid compound represented by the general formula (40) include the examples described as the dicarboxylic acid compound represented by the general formula (30).

Preferable examples of the diamine represented by the general formula (41) include the examples described as the diamine represented by the general formula (39).

As noted above, the polymer (A) contained in the negative-type photosensitive resin composition of the present invention may further have a structural unit represented by the following general formula (23) in addition to the structural units represented by the general formulae (1), (2), (3), and (4).

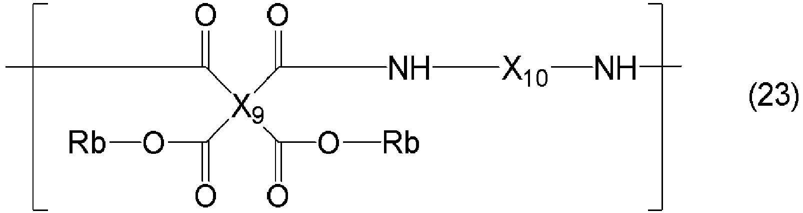

In the formula, X₉, X₁₀, and R_{b} are same as above.

The polymer having the structural unit represented by the general formula (23) can be obtained by performing the reaction procedure same as for the structural unit (2). Specifically, the polymer having the structural unit represented by the general formula (23) can be obtained by a reaction of a dicarboxylic acid diester compound represented by the following general formula (42) in the presence of a dehydrative condensing agent or by a reaction of converting the dicarboxylic acid diester compound into an acid chloride by using a chlorinating agent, and then reacting the acid chloride with the diamine represented by the general formula (43).

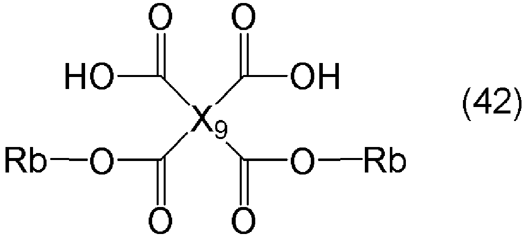

In the formula, R_{b} and X₉ are same as above.

H₂N-X₁₀-NH₂ (43)

In the formula, X₁₀ is same as above.

Examples of a method for manufacturing the tetracarboxylic acid diester compound represented by the general formula (42) include a method of introducing R_{b} by reacting a tetracarboxylic dianhydride represented by the following general formula (44) and a compound having a hydroxy group at a terminal, represented by the following general formula (45), in the presence of a basic catalyst such as pyridine. Here, the tetracarboxylic dianhydride represented by the following general formula (44) is a source of X₉ (for example, the tetravalent organic group represented by the formulae (18)) in the general formula (23).

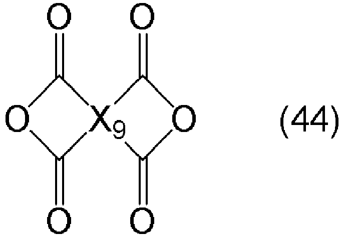

In the formula X₉ is same as above.

**HO-Rb** **(45)**

In the formula R_{b} is same as above.

Preferable examples of the tetracarboxylic dianhydride represented by the general formula (44) include the examples described as the tetracarboxylic dianhydride represented by the general formula (28).

In the reaction between the tetracarboxylic dianhydride represented by the general formula (44) and the compound having a hydroxy group at a terminal, represented by the following general formula (45), the tetracarboxylic dianhydride represented by the general formula (44) and the compound having a hydroxy group at a terminal, represented by the following general formula (45), are stirred, dissolved, and mixed in the presence of the basic catalyst such as pyridine in a reaction solvent at a reaction temperature of 20 to 50°C over 4 to 10 hours to proceed a half-esterification reaction of the acid dianhydride, and obtained is a solution in which the target tetracarboxylic acid diester compound represented by the general formula (42) is dissolved in the reaction solvent.

The obtained tetracarboxylic acid diester compound may be isolated, or the obtained solution may be used as it is for the aforementioned subsequent step of the reaction with the diamine.

The reaction solvent is preferably a solvent that sufficiently dissolves the tetracarboxylic acid diester compound and the polymer having the structural units of the polyimide precursor obtained by the subsequently performed polycondensation reaction between the tetracarboxylic acid diester compound and the diamines. Examples thereof include N-methyl-2-pyrrolidone, N,N-dimethylacetamide, N,N-dimethylformamide, dimethyl sulfoxide, tetramethylurea, and γ-butyrolactone. Ketones, esters, lactones, ethers, halogenated hydrocarbons, hydrocarbons, etc. may also be used. Specific examples thereof include acetone, methyl ethyl ketone, methyl isobutyl ketone, cyclohexanone, methyl acetate, ethyl acetate, butyl acetate, diethyl oxalate, ethylene glycol dimethyl ether, diethylene glycol dimethyl ether, tetrahydrofuran, dichloromethane, 1,2-dichloroethane, 1,4-dichlorobutane, chlorobenzene, o-dichlorobenzene, hexane, heptane, benzene, toluene, and xylene. These may be used singly, or may be used in combination of two or more as necessary.

Preferable examples of the diamine represented by the general formula (43) include the examples described as the diamine represented by the general formula (39).

As noted above, the polymer (A) contained in the negative-type photosensitive resin composition of the present invention may further have a structural unit represented by the following general formula (24) in addition to the structural units represented by the general formulae (1), (2), (3), and (4).

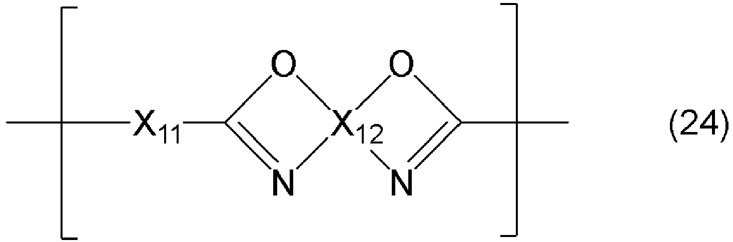

In the formula, X₁₁ and X₁₂ are same as above.

The polymer having the structural unit represented by the general formula (24) can be obtained by a reaction of a dicarboxylic acid compound represented by the following general formula (46) in the presence of a dehydrative condensing agent or by a reaction of converting the dicarboxylic acid compound into an acid chloride by using a chlorinating agent, and then reacting with a dihydroxydiamine compound represented by the general formula (47) to synthesize a hydroxyamide (polyoxazole precursor), and then forming an oxazole ring via a heating-dehydration process.

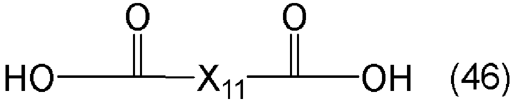

In the formula, X₁₁ is same as above.

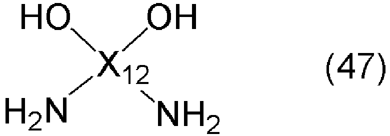

In the formula, X₁₂ is same as above.

Preferable examples of the dicarboxylic acid compound represented by the general formula (46) include the examples described as the dicarboxylic acid compound represented by the general formula (30).

Examples of the dihydroxydiamine compound represented by the general formula (47) include, but not limited to, 3,3'-diamino-4,4'-dihydroxybiphenyl, 3,3'-diamino-4,4'-dihydroxybiphenyl ether, 2,2'-(bis-3-amino-4-hydroxyphenyl) sulfide, 2,2'-(bis-3-amino-4-hydroxyphenyl) ketone, 3,3'-diamino-4,4'-dihydroxyphenylmethane, 1,2-bis(3-amino-4-hydroxyphenyl)ethane, 2,2'-bis(3-amino-4-hydroxyphenyl)difluoromethane, 4,4'-(1,1,2,2,3,3-hexafluoro-1,3-propanediyl)bis(2-aminophenol), 2,2'-bis(3-amino-4-hydroxyphenyl)propane, 2,2'-bis(3-amino-4-hydroxyphenyl)hexafluoropropane, 2,2'-bis(3-amino-4-hydroxyphenyl) sulfone, 1,1-bis(3-amino-4-hydroxyphenyl)cyclohexane, 4,4'-(1,4-phenylenebis(oxy))bis(2-aminophenol), and 9,9-bis(3-amino-4-hydroxyphenyl)fluorene. These may be use singly, or may be mixed for use.

### (Molecular Weight of Polymer and Introduction of Terminal-Blocking Agent)

A preferable molecular weight of the polymer is preferably 5,000 to 100,000, and more preferably 7,000 to 50,000. The molecular weight of 5,000 or more facilitates formation of a film of the negative-type photosensitive resin composition of the present invention using the polymer on the substrate at a desired film thickness. The molecular weight of 100,000 or less does not cause considerably high viscosity of the negative-type photosensitive resin composition, and does not cause a risk of failure of the film formation.

For a purpose of regulating the molecular weight in the polycondensation reaction and inhibiting change in the molecular weight of the obtained polymer with time, namely gelation, both terminals of the polymer may be blocked with a terminal-blocking agent. Examples of the terminal-blocking agent to react with the acid dianhydride include a monoamine and a monohydric alcohol. Examples of the terminal-blocking agent to react with the diamine compound include an acid anhydride, a monocarboxylic acid, a monoacid chloride compound, a mono-active ester compound, dicarbonate esters, and vinyl ethers. Reaction with the terminal-blocking agent can introduce various organic groups as the terminal group.

Examples of the monoamine used as the blocking agent for the acid anhydride terminal include, but not limited to, aniline, 5-amino-8-hydroxyquinoline, 4-amino-8-hydroxyquinoline, 1-hydroxy-8-aminonaphthalene, 1-hydroxy-7-aminonaphthalene, 1-hydroxy-6-aminonaphthalene, 1-hydroxy-5-aminonaphthalene, 1-hydroxy-4-aminonaphthalene, 1-hydroxy-3-aminonaphthalene, 1-hydroxy-2-aminonaphthalene, 1-amino-7-hydroxynaphthalene, 2-hydroxy-7-aminonaphthalene, 2-hydroxy-6-aminonaphthalene, 2-hydroxy-5-aminonaphtahlene, 2-hydroxy-4-aminonaphthalene, 2-hydroxy-3-aminonaphtahlene, 1-amino-2-hydroxynaphthalene, 1-carboxy-8-aminonaphthalene, 1-carboxy-7-aminonaphthalene, 1-carboxy-6-aminonaphthalene, 1-carboxy-5-aminonaphthalene, 1-carboxy-4-aminonaphthalene, 1-carboxy-3-aminonaphthalene, 1-carboxy-2-aminonaphthalene, 1-amino-7-carboxynaphthalene, 2-carboxy-7-aminonaphthalene, 2-carboxy-6-aminonaphthalene, 2-carboxy-5-aminonaphthalene, 2-carboxy-4-aminonaphthalene, 2-carboxy-3-aminonaphthalene, 1-amino-2-carboxynaphthalene, 2-aminoniconitic acid, 4-aminoniconitic acid, 5-aminoniconitic acid, 6-aminoniconitic acid, 4-aminosalicylic acid, 5-aminosalicylic acid, 6-aminosalicylic acid, ammelide, 2-aminobenzoic acid, 3-aminobenzoic acid, 4-aminobenzoic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 5-amino-8-mercaptoquinoline, 4-amino-8-mercaptoquinoline, 1-mercapto-8-aminonaphthalene, 1-mercapto-7-aminonaphthalene, 1-mercapto-6-aminonaphthalene, 1-mercapto-5-aminonaphthalene, 1-mercapto-4-aminonaphthalene, 1-mercapto-3-aminonaphthalene, 1-mercapto-2-aminonaphthalene, 1-amino-7-mercaptonaphthalene, 2-mercapto-7-aminonaphthalene, 2-mercapto-6-aminonaphthalene, 2-mercapto-5-aminonaphthalene, 2-mercapto-4-aminonaphthalene, 2-mercapto-3-aminonaphthalene, 1-amino-2-mercaptonaphthalene, 3-amino-4,6-dimercaptopyrimidine, 2-aminothiophenol, 3-aminothiophenol, 4-aminothiophenol, 2-ethynylaniline, 3-ethynylaniline, 4-ethynylaniline, 2,4-diethynylaniline, 2,5-diethynylaniline, 2,6-diethynylaniline, 3,4-diethynylaniline, 3,5-diethynylaniline, 1-ethynyl-2-aminonaphthalene, 1-ethynyl-3-aminonaphthalene, 1-ethynyl-4-aminonaphthalene, 1-ethynyl-5-aminonaphthalene, 1-ethynyl-6-aminonaphthalene, 1-ethynyl-7-aminonaphthalene, 1-ethynyl-8-aminonaphthalene, 2-ethynyl-1-aminonaphthalene, 2-ethynyl-3-aminonaphthalene, 2-ethynyl-4-aminonaphthalene, 2-ethynyl-5-aminonaphthalene, 2-ethynyl-6-aminonaphthalene, 2-ethynyl-7-aminonaphthalene, 2-ethynyl-8-aminonaphthalene, 3,5-diethynyl-1-aminonaphthalene, 3,5-diethynyl-2-aminonaphthalene, 3,6-diethynyl-1-aminonaphthalene, 3,6-diethynyl-2-aminonaphthalene, 3,7-diethynyl-1-aminonaphthalene, 3,7-diethynyl-2-aminonaphthalene, 4,8-diethynyl-1-aminonaphthalene, 4,8-diethynyl-2-aminonaphthalene, 4-fluoroaniline, 3-fluoroaniline, 2-fluoroaniline, 2,4-difluoroaniline, 3,4-difluoroaniline, 2,4,6-trifluoroaniline, 2,3,4-trifluoroaniline, and pentafluoroaniline. These may be used singly, or may be used in combination of two or more.

Meanwhile, examples of the monohydric alcohol used as the blocking agent for the acid anhydride group terminal include, but not limited to, methanol, ethanol, 1-propanol, 2-propanol, 1-butanol, 2-butanol, 1-pentanol, 2-pentanol, 3-pentanol, 1-hexanol, 2-hexanol, 3-hexanol, 1-heptanol, 2-heptanol, 3-heptanol, 1-octanol, 2-octanol, 3-octanol, 1-nonanol, 2-nonanol, 1-decanol, 2-decanol, 1-undecanol, 2-undecanol, 1-dodecanol, 2-dodecanol, 1-tridecanol, 2-tridecanol, 1-tetradecanol, 2-tetradecanol, 1-pentadecanol, 2-pentadecanol, 1-hexadecanol, 2-hexadecanol, 1-heptadecanol, 2-heptadecanol, 1-octadecanol, 2-octadecanol, 1-nonadecanol, 2-nonadecanol, 1-eicosanol, 2-methyl-1-propanol, 2-methyl-2-propanol, 2-methyl-1-butanol, 3-methyl-1-butanol, 2-methyl-2-butanol, 3-methyl-2-butanol, 2-propyl-1-pentanol, 2-ethyl-1-hexanol, 4-methyl-3-heptanol, 6-methyl-2-heptanol, 2,4,4-trimethyl-1-hexanol, 2,6-dimethyl-4-heptanol, isononyl alcohol, 3,7-dimethyl-3-octanol, 2,4-dimethyl-1-heptanol, 2-heptylundecanol, ethylene glycol monoethyl ether, ethylene glycol monomethyl ether, ethylene glycol monobutyl ether, propylene glycol 1-methyl ether, diethylene glycol monoethyl ether, diethylene glycol monomethyl ether, diethylene glycol monobutyl ether, cyclopentanol, cyclohexanol, cyclopentanemonomethylol, dicyclopentanemonomethylol, tricyclodecanemonomethylol, norborneneol, and terpineol. These may be used singly, or may be used in combination of two or more.

Examples of the acid anhydride, the monocarboxylic acid, the monoacid chloride compound, and the mono-active ester compound used as the blocking agent for the amino group terminal include: acid anhydrides, such as phthalic anhydride, maleic anhydride, nadic anhydride, cyclohexanedicarboxylic anhydride, and 3-hydroxyphthalic anhydride; monocarboxylic acids, such as 2-carboxyphenol, 3-carboxyphenol, 4-carboxyphenol, 2-carboxythiophenol, 3-carboxythiophenol, 4-carboxythiophenol, 1-hydroxy-8-carboxynaphthalene, 1-hydroxy-7-carboxynaphthalene, 1-hydroxy-6-carboxynaphthalene, 1-hydroxy-5-carboxynaphthalene, 1-hydroxy-4-carboxynaphthalene, 1-hydroxy-3-carboxynaphthalene, 1-hydroxy-2-carboxynaphthalene, 1-mercapto-8-carboxynaphthalene, 1-mercapto-7-carboxynaphthalene, 1-mercapto-6-carboxynaphthalene, 1-mercapto-5-carboxynaphthalene, 1-mercapto-4-carboxynaphthalene, 1-mercapto-3-carboxynaphthalene, 1-mercapto-2-carboxynaphthalene, 2-carboxybenzenesulfonic acid, 3-carboxybenzenesulfonic acid, 4-carboxybenzenesulfonic acid, 2-ethynylbenzoic acid, 3-ethynylbenzoic acid, 4-ethynylbenzoic acid, 2,4-diethynylbenzoic acid, 2,5-diethynylbenzoic acid, 2,6-diethynylbenzoic acid, 3,4-diethynylbenzoic acid, 3,5-diethynylbenzoic acid, 2-ethynyl-1-naphthoic acid, 3-ethynyl-1-naphthoic acid, 4-ethynyl-1-naphthoic acid, 5-ethynyl-1-naphthoic acid, 6-ethynyl-1-naphthoic acid, 7-ethynyl-1-naphthoic acid, 8-ethynyl-1-naphthoic acid, 2-ethynyl-2-naphthoic acid, 3-ethynyl-2-naphthoic acid, 4-ethynyl-2-naphthoic acid, 5-ethynyl-2-naphthoic acid, 6-ethynyl-2-naphthoic acid, 7-ethynyl-2-naphthoic acid, and 8-ethynyl-2-naphthoic acid, and monoacid chloride compounds in which these carboxy groups form an acid chloride; monoacid chloride compounds in which only the monocarboxylic group of dicarboxylic acids, such as terephthalic acid, phthalic acid, maleic acid, cyclohexanedicarboxylic acid, 3-hydroxyphtahlic acid, 5-norbornene-2,3-diacarboxylic acid, 1,2-dicarboxynaphthalene, 1,3-dicarboxynaphthalene, 1,4-dicarboxynaphthalene, 1,5-dicarboxynaphthalene, 1,6-dicarboxynaphthalene, 1,7-dicarboxynaphthalene, 1,8-dicarboxynaphthalene, 2,3-dicarboxynaphthalene, 2,6-dicarboxynaphthalene, and 2,7-dicarboxynaphthalene, is acid-chlorinated; and the mono-active ester compound obtained by a reaction between the monoacid chloride compound and N-hydroxybenzotriazole or N-hydroxy-5-norbornene-2,3-dicarboxyimide.

Examples of the dicarbonate ester compound used for the blocking agent for the amino group terminal include di-tert-butyl dicarbonate, dibenzyl dicarbonate, dimethyl dicarbonate, and diethyl dicarbonate.

Examples of the vinyl ether compound used as the blocking agent for the amino group terminal include butyl vinyl ether, cyclohexyl vinyl ether, ethyl vinyl ether, 2-ethylhexyl vinyl ether, isobutyl vinyl ether, isopropyl vinyl ether, n-propyl vinyl ether, tert-butyl vinyl ether, and benzyl vinyl ether.

Examples of other compounds used as the blocking agent for the amino group terminal include: benzoyl chloride; chloroformate esters, such as fluorenylmethyl chloroformate, 2,2,2-trichloroethyl chloroformate, tert-butyl chloroformate, n-butyl chloroformate, isobutyl chloroformate, benzyl chloroformate, allyl chloroformate, ethyl chloroformate, and isopropyl chloroformate; isocyanate compounds, such as butyl isocyanate, 1-naphthyl isocyanate, octadecyl isocyanate, and phenyl isocyanate; and methanesulfonyl chloride and p-toluenesulfonyl chloride.

An introducing proportion of the blocking agent for the acid anhydride group terminal is preferably within a range of 0.1 to 60 mol%, particularly preferably 5 to 50 mol%, and further preferably 5 to 20 mol% relative to a total amount of the tetracarboxylic dianhydride component and the dicarboxylic acid component. An introducing proportion of the blocking agent for the amino group terminal is preferably within a range of 0.1 to 100 mol%, and particularly preferably 5 to 90 mol% relative to the diamine component. A plurality of different terminal groups may be introduced by reacting a plurality of the terminal blocking agents.

### Photoacid Generator (B)

The Photoacid generator (B) contained in the negative-type photosensitive resin composition of the present invention is not particularly limited, and usable is a compound that generates an acid by irradiation with light at a wavelength of 190 to 500 nm to allow this acid to be a curing catalyst. Examples thereof include an onium salt, a diazomethane derivative, a glyoxime derivative, an oxime sulfonate derivative, a β-ketosulfone derivative, a disulfone derivative, a nitrobenzylsulfonate derivative, a sulfonate ester derivative, an imid-yl sulfonate derivative, an iminosulfonate derivative, and a triazine derivative. As described in detail below, these may be used singly or two or more may be mixed for use.

Examples of the onium salt include a compound represented by the following general formula (48).

(R²⁶)ⱼM⁺K⁻ (48)

In the formula, R²⁶ represents a linear, branched, or cyclic alkyl group having 1 to 12 carbon atoms, an aryl group having 6 to 12 carbon atoms, or an aralkyl group having 7 to 12 carbon atoms, these groups are optionally having a substituent; M⁺ represents an iodonium ion or a sulfonium ion; K⁻ represents a non-nucleophilic counter ion; and "j" represents 2 or 3.

For the R₂₆, examples of the linear, branched, or cyclic alkyl group having 1 to 12 carbon atoms include a methyl group, an ethyl group, a propyl group, a butyl group, a cyclohexyl group, a 2-oxocyclohexyl group, a norbornyl group, and an adamantyl group. Examples of the aryl group having 6 to 12 carbon atoms include: a phenyl group; alkoxyphenyl groups, such as an o-, m-, or p-methoxyphenyl group, an ethoxyphenyl group, and a m- or p-tert-butoxyphenyl group; and alkylphenyl groups, such as 2-, 3-, or 4-methylphenyl group, an ethylphenyl group, a 4-tert-butylphenyl group, a 4-butylphenyl group, and a dimethylphenyl group. Examples of the aralkyl group having 7 to 12 carbon atoms include groups such as a benzyl group and a phenethyl group.

Examples of the non-nucleophilic counter ion K-include: halide ions, such as a chloride ion and a bromide ion; fluoroalkylsulfonates, such as triflate, 1,1,1-trifluoroethanesulfonate, and nonafluorobutanesulfonate; arylsulfonates, such as tosylate, benzenesulfonate, 4-fluorobenzenesulfonate, and 1,2,3,4,5-pentafluorobenzenesulfonate; and alkylsulfonates, such as mesylate and butanesulfonate.

Examples of the diazomethane derivative include a compound represented by the following general formula (49) .

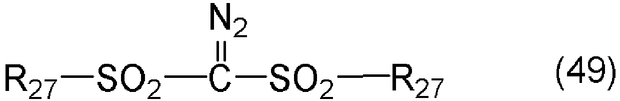

In the formula, R₂₇ may be same or different, and represents a linear, branched, or cyclic alkyl group or halogenated alkyl group having 1 to 12 carbon atoms, an aryl group or halogenated aryl group having 6 to 12 carbon atoms, or an aralkyl group having 7 to 12 carbon atoms.

For the R₂₇, the linear, branched, or cyclic alkyl group having 1 to 12 carbon atoms include a methyl group, an ethyl group, a propyl group, a butyl group, an amyl group, a cyclopentyl group, a cyclohexyl group, a norbornyl group, and an adamantyl group. Examples of the linear, branched, or cyclic halogenated alkyl group having 1 to 12 carbon atoms include a trifluoromethyl group, a 1,1,1-trifluoroethyl group, a 1,1,1-trichloroethyl group, and a nonafluorobutyl group. Examples of the aryl group having 6 to 12 carbon atoms include: a phenyl group; alkoxyphenyl groups, such as an o-, m-, or p-methoxyphenyl group, an ethoxyphenyl group, and a m- or p-tert-butoxyphenyl group; and alkylphenyl groups, such as 2-, 3-, or 4-methylphenyl group, an ethylphenyl group, a 4-tert-butylphenyl group, a 4-butylphenyl group, and a dimethylphenyl group. Examples of the halogenated aryl group having 6 to 12 carbon atoms include a fluorophenyl group, a chlorophenyl group, and 1,2,3,4,5-pentafluorophenyl group. Examples of the aralkyl group having 7 to 12 carbon atoms include a benzyl group and a phenethyl group.

Preferably usable as such photoacid generators specifically include: onium salts, such as diphenyliodonium trifluoromethanesulfonate, (p-tert-butoxyphenyl)phenyliodonium trifluoromethanesulfonate, diphenyliodonium p-toluenesulfonate, (p-tert-butoxyphenyl)phenyliodonium p-toluenesulfonate, triphenylsulfonium trifluoromethanesulfonate, (p-tert-butoxyphenyl)diphenylsulfonium trifluoromethanesulfonate, bis(p-tert-butoxyphenyl)phenylsulfonium trifluoromethanesulfonate, tris(p-tert-butoxyphenyl)sulfonium trifluoromethanesulfonate, triphenylsulfonium p-toluenesulfonate, (p-tert-butoxyphenyl)diphenylsulfonium p-toluenesulfonate, bis(p-tert-butoxyphenyl)phenylsulfonium p-toluenesulfonate, tris(p-tert-butoxyphenyl)sulfonium p-toluenesulfonate, triphenylsulfonium nonafluorobutanesulfonate, triphenylsulfonium butanesulfonate, trimethylsulfonium trifluoromethanesulfonate, trimethylsulfonium p-toluenesulfonate, cyclohexylmethyl(2-oxocyclohexyl)sulfonium trifluoromethanesulfonate, cyclohexylmethyl(2-oxocyclohexyl)sulfonium p-toluenesulfonate, dimethylphenylsulfonium trifluoromethanesulfonate, dimethylphenylsulfonium p-toluenesulfonate, dicyclohexylphenylsulfonium trifluoromethanesulfonate, dicyclohexylphenylsulfonium p-toluenesulfonate, and diphenyl(4-thiophenoxyphenyl)sulfonium hexafluoroantimonate; diazomethane derivatives, such as bis(benzenesulfonyl)diazomethane, bis(p-toluenesulfonyl)diazomethane, bis(xylenesulfonyl)diazomethane, bis(cyclohexylsulfonyl)diazomethane, bis(cyclopentylsulfonyl)diazomethane, bis(n-butylsulfonyl)diazomethane, bis(isobutylsulfonyl)diazomethane, bis(sec-butylsulfonyl)diazomethane, bis(n-propylsulfonyl)diazomethane, bis(isopropylsulfonyl)diazomethane, bis(tert-butylsulfonyl)diazomethane, bis(n-amylsulfonyl)diazomethane, bis(isoamylsulfonyl)diazomethane, bis(sec-amylsulfonyl)diazomethane, bis(tert-amylsulfonyl)diazomethane, 1-cyclohexylsulfonyl-1-(tert-butylsulfonyl)diazomethane, 1-cyclohexylsulfonyl-1-(tert-amylsulfonyl)diazomethane, and 1-tert-amylsulfonyl-1-(tert-butylsulfonyl)diazomethane; glyoxime derivatives, such as bis-o-(p-toluenesulfonyl)-α-dimethylglyoxime, bis-o-(p-toluenesulfonyl)-α-diphenylglyoxime, bis-o-(p-toluenesulfonyl)-α-dicyclohexylglyoxime, bis-o-(p-toluenesulfonyl)-2,3-pentanedioneglyoxime, bis-o-(p-toluenesulfonyl)-2-methyl-3,4-pentanedioneglyoxime, bis-o-(n-butanesulfonyl)-α-dimethylglyoxime, bis-o-(n-butanesulfonyl)-α-diphenylglyoxime, bis-o-(n-butanesulfonyl)-α-dicyclohexylglyoxime, bis-o-(n-butanesulfonyl)-2,3-pentanedioneglyoxime, bis-o-(n-butanesulfonyl)-2-methyl-3,4-pentanedioneglyoxime, bis-o-(methanesulfonyl)-α-dimethylglyoxime, bis-o-(trifluoromethanesulfonyl)-α-dimethylglyoxime, bis-o-(1,1,1-trifluoroethanesulfonyl)-α-dimethylglyoxime, bis-o-(tert-butanesulfonyl)-α-dimethylglyoxime, bis-o-(perfoluorooctanesulfonyl)-α-dimethylglyoxime, bis-o-(cyclohexanesulfonyl)-α-dimethylglyoxime, bis-o-(benzenesulfonyl)-α-dimethylglyoxime, bis-o-(p-fluorobenzenesulfonyl)-α-dimethylglyoxime, bis-o-(p-tert-butylbenzenesulfonyl)-α-dimethylglyoxime, bis-o-(xylenesulfonyl)-α-dimethylglyoxime, and bis-o-(camphorsulfonyl)-α-dimethylglyoxime; oximesulfonate derivatives, such as α-(benzenesulfoniumoxyimino)-4-methylphenylacetonitrile; β-ketosulfone derivatives, such as 2-cyclohexylcarbonyl-2-(p-toluenesulfonyl)propane and 2-isopropylcarbonyl-2-(p-toluenesulfonyl)propane; disulfone derivatives, such as diphenyl disulfone and dicyclohexyl disulfone; nitrobenzylsulfonate derivatives, such as 2,6-dinitrobenzyl p-toluenesulfonate and 2,4-dinitrobenzyl p-toluenesulfonate; sulfonate ester derivatives, such as 1,2,3-tris(methanesulfonyloxy)benzene, 1,2,3-tris(trifluoromethanesulfonyloxy)benzene, and 1,2,3-tris(p-toluenesulfonyloxy)benzene; imid-yl sulfonate derivatives, such as phthalimid-yl triflate, phthalimid-yl tosylate, 5-norbornene-2,3-dicarboxyimid-yl triflate, 5-norbornene-2,3-dicarboxyimid-yl tosylate, 5-norbornene-2,3-dicarboxyimid-yl n-butylsulfonate, and n-trifluoromethylsulfonyloxynaphthylimide; iminosulfonate derivatives, such as (5-(4-methylphenyl)sulfonyloxyimino-5H-thiophen-2-ylidene)-(2-methylphenyl)acetonitrile and (5-(4-(4-methylphenylsulfonyloxy)phenylsulfonyloxyimino)-5H-thiophen-2-ylidene)-(2-methylphenyl)-acetonitrile; and 2-methyl-2-[(4-methylphenyl)sulfonyl]-1-[(4-methylthio)phenyl]-1-propane. Among these, the imid-yl sulfonate derivatives, the imino sulfonate derivatives, oxime sulfonate derivatives, etc. are preferably used. One or two or more types of the photoacid generator may be used.

A blending amount of the photoacid generator being the component (B) is preferably 0.05 to 20 parts by mass, and particularly preferably 0.2 to 5 parts by mass relative to 100 parts by mass of the component (A) in the negative-type photosensitive resin composition of the present invention from the viewpoints of light absorption of the photoacid generator itself and photo-curability of a thick film.

### Crosslinking Agent (C)

The crosslinking agent (C) contained in the negative-type photosensitive resin composition of the present invention may be any compound as long as the compound has a group that is crosslinkable with the component (A). The component (C) is preferably one or two or more crosslinking agents selected from: an amino condensate modified with formaldehyde or formaldehyde-alcohol; a phenol compound having two or more methylol groups or alkoxymethylol groups in average in one molecule; a compound in which a hydrogen atom in a hydroxy group of a polyvalent phenol is substituted with a glycidyl group; a compound in which a hydrogen atom in a hydroxy group of a polyvalent phenol or in a hydroxy group of a polyhydric alcohol is substituted with a substituent represented by the following general formula (C-1); and a compound having two or more nitrogen atoms having a glycidyl ether represented by the following formula (C-2).

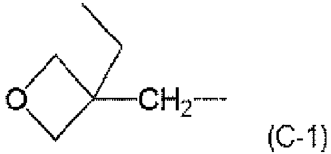

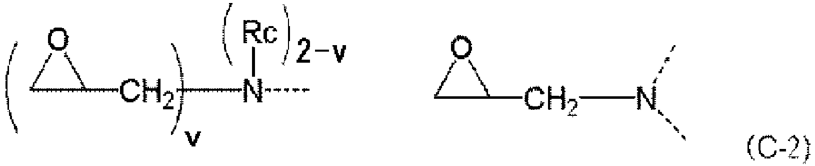

In the formulae, a dotted line represents an attachment point; Rc represents a linear, branched, or cyclic alkyl group having 1 to 6 carbon atoms; and "v" represents 1 or 2.

Examples of the amino condensate modified with formaldehyde or formaldehyde-alcohol include: a melamine condensate modified with formaldehyde or formaldehyde-alcohol; or a urea condensate modified with formaldehyde or formaldehyde-alcohol.

For preparing the melamine condensate modified with formaldehyde or formaldehyde-alcohol, for example, a melamine monomer is modified by methylolation with formalin according to a known method, or further modified by alkoxylation with an alcohol to form a modified melamine represented by the following general formula (50). The alcohol is preferably a lower alcohol, for example, an alcohol having 1 to 4 carbon atoms. 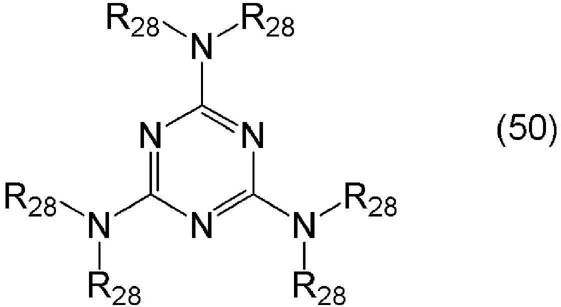 In the formula, R₂₈, which may be same as or different from each other, represents a methylol group, an alkoxymethyl group having an alkoxy group having 1 to 4 carbon atoms, or a hydroxy group. At least one of R₂₈ represents the methylol group or the alkoxymethyl group.

Examples of the R₂₈ include: alkoxymethyl groups having an alkoxy group having 1 to 4 carbon atoms, such as a methylol group, a methoxymethyl group, and an ethoxymethyl group; and a hydrogen atom.

Specific examples of the modified melamine represented by the general formula (50) include trimethoxymethylmonomethylolmelamine, dimethoxymethylmonomethylolmelamine, trimethylolmelamine, hexamethylolmelamine, and hexamethoxymethylolmelamine. Then, the modified melamine represented by the general formula (50) or its multimer (for example, an oligomer such as a dimer or a trimer) is subjected to addition polycondensation with formaldehyde until a desired molecular weight according to a common method to obtain the melamine condensate modified with formaldehyde or formaldehyde-alcohol.

For preparing the urea condensate modified with formaldehyde or formaldehyde-alcohol, for example, a urea condensate having a desired molecular weight is modified with methylolation with formaldehyde according to a known method, or further modified by alkoxylation with an alcohol.

Specific examples of the urea condensate modified with formaldehyde or formaldehyde-alcohol include a methoxymethylated urea condensate, an ethoxymethylated urea condensate, and a propoxymethylated urea condensate.

These modified melamine condensates and modified urea condensates may be used single, or two or more thereof may be mixed for use.

Then, examples of the phenol compound having two or more methylol groups or alkoxymethylol groups in average in one molecule include (2-hydroxy-5-methyl)-1,3-benzenedimethanol, 2,2',6,6'-tetramethoxymethylbisphenol A, and compounds represented by the following formulae (C-3) to (C-7).

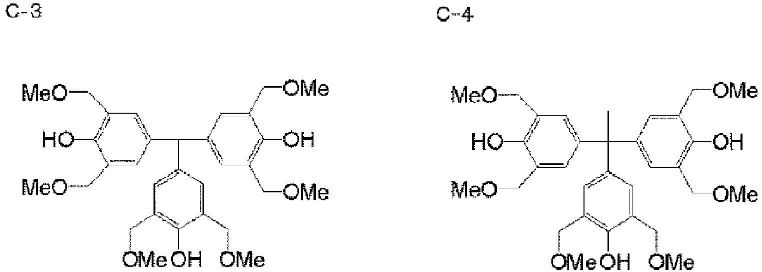

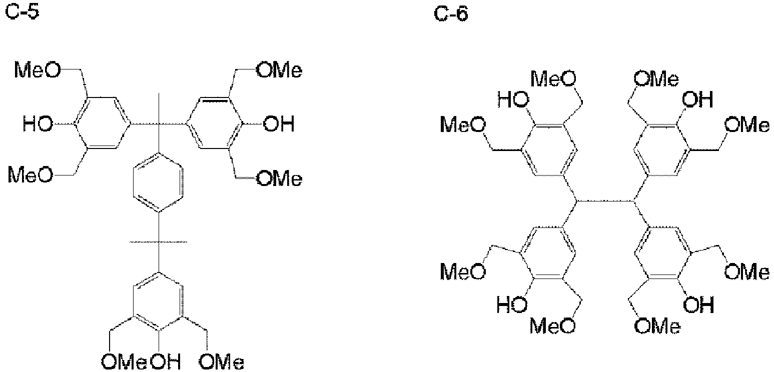

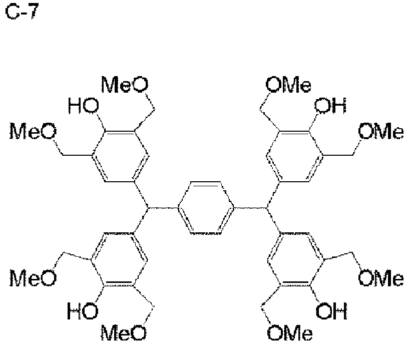

In the formulae, Me represents a methyl group.

The phenol compound having two or more methylol groups or alkoxymethylol groups in average in one molecule may be used singly, or may be used in combination of two or more.

Meanwhile, examples of the compound in which a hydrogen atom in a hydroxy group of a polyvalent phenol is substituted with a glycidyl group include a compound obtained by reacting a hydroxy group of bisphenol A, tris(4-hydroxyphenyl)methane, or 1,1,1-tris(4-hydroxyphenyl)ethane with epichlorohydrin in the presence of a base. Preferable examples of the compound in which a hydrogen atom in a hydroxy group of a polyvalent phenol is substituted with a glycidyl group include compounds represented by the following formulae (C-8) to (C-14).

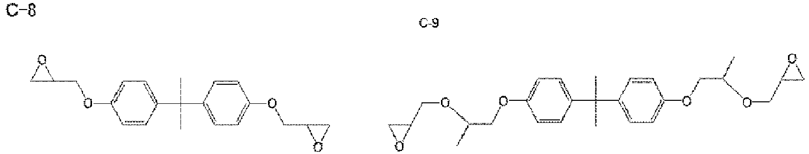

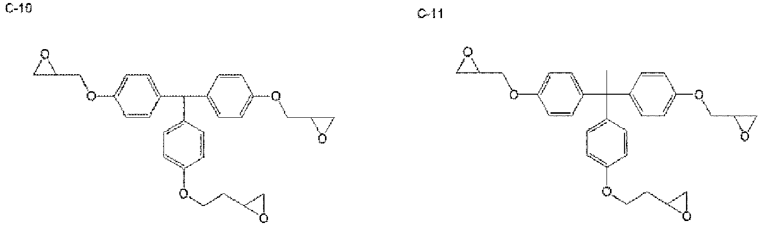

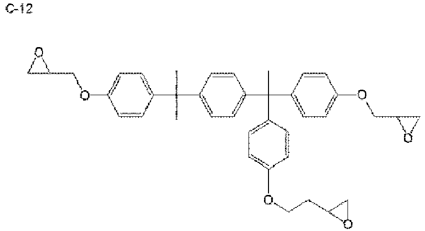

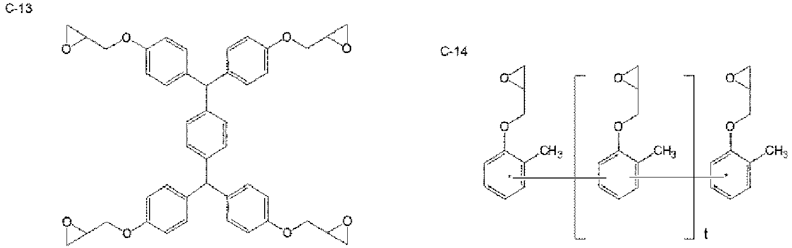

In the formula, "t" satisfies 2≤t≤3.

One or combination of two or more of these compounds in which a hydroxy group of a polyvalent phenol is substituted with a glycidoxy group (compounds in which a hydrogen atom in a hydroxy group of a polyvalent phenol is substituted with a glycidyl group) may be used as the crosslinking agent.

Examples of the compound in which a hydrogen atom in a hydroxy group of a polyvalent phenol or in a hydroxy group of a polyhydric alcohol is substituted with a substituent represented by the following formula (C-1) include a compound having two or more of the substituents and represented by the following general formula (C-15) .

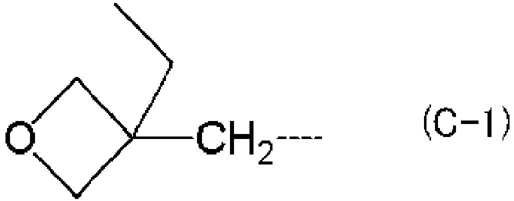

In the formula, a dotted line represents an attachment point.

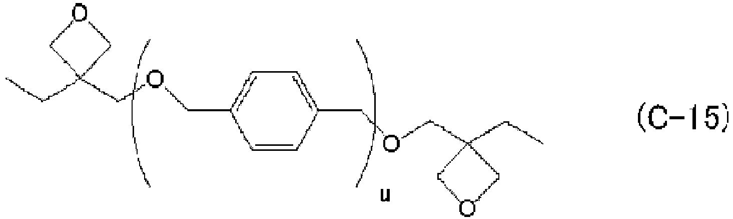

In the formula, 1≤u≤3.

One or combination of two or more of the compound in which a hydrogen atom in a hydroxy group of a polyvalent phenol or in a hydroxy group of a polyhydric alcohol is substituted with the substituent represented by the formula (C-1) may be used as the crosslinking agent.

Meanwhile, examples of the compound having two or more nitrogen atoms having a glycidyl group represented by the following formula (C-2) include compounds represented by the following general formula (C-16).

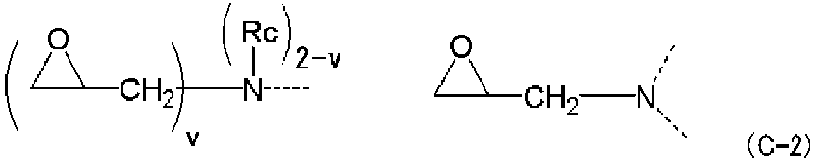

In the formula, a dotted line represents an attachment point; Rc represents a linear, branched, or cyclic alkyl group having 1 to 6 carbon atoms; and "v" represents 1 or 2.

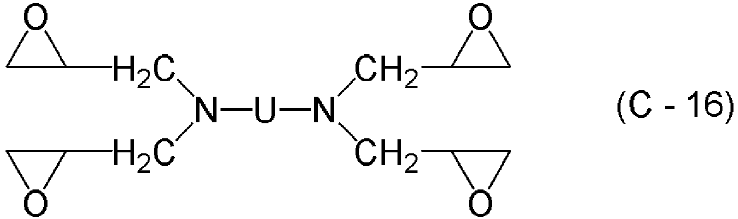

In the formula, U represents a linear, branched, or cyclic alkylene group having 2 to 12 carbon atoms, or a divalent aromatic group having 6 to 12 carbon atoms.

Examples of the compound represented by the general formula (C-16) include compounds represented by the following formulae (C-17) to (C-20).

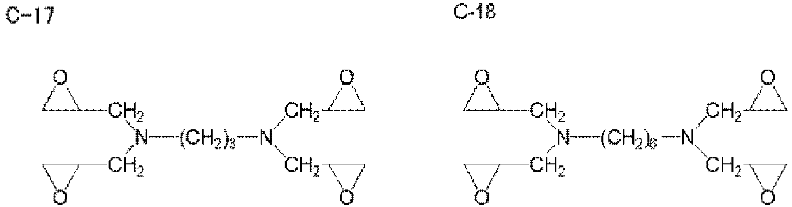

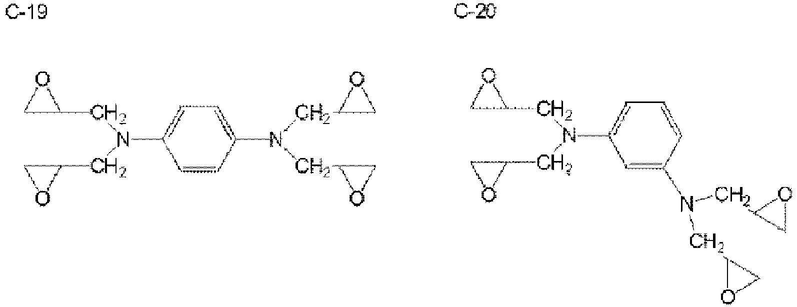

Meanwhile, as the compound having two or more nitrogen atoms having a glycidyl group represented by the formula (C-2), a compound represented by the following formula (C-21) may also be preferably used.

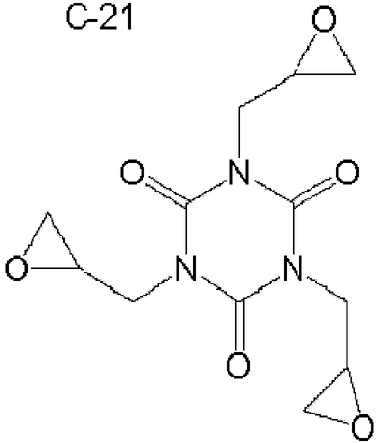

One or combination of two or more of these compounds having two or more nitrogen atoms having a glycidyl group represented by the formula (C-2) may be used as the crosslinking agent.

As noted above, the component (C) of the negative-type photosensitive resin composition of the present invention is a compound that not only can form a negative-type pattern by crosslinking the crosslinking group of the component (C) with the polymer of the component (A) with the acid generated from the component (B) as the catalyst, and after the patterning, that causes a crosslinking reaction in post-curing to further increase strength of the cured product. A weight-average molecular weight of such a component (C) is preferably 150 to 10,000, and particularly preferably 200 to 3,000 from the viewpoints of photo-curability and heat resistance.

A blending amount of the component (C) is preferably 0.5 to 50 parts by mass, and particularly preferably 1 to 30 parts by mass relative to 100 parts by mass of the component (A) in the negative-type photosensitive resin composition of the present invention.

### Solvent (D)

The solvent of the component (D) of the present invention is not limited as long as the solvent dissolves the component (A), the component (B), and the component (C). Examples of the solvent include: ketones, such as cyclohexanone, cyclopentanone, and methyl-2-n-amyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters, such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol mono-tert-butyl ether acetate, and γ-butyrolactone. One or more of these may be used. Particularly, ethyl lactate, cyclohexanone, cyclopentanone, propylene glycol monomethyl ether acetate, γ-butyrolactone, or a mixed solvent thereof is preferable.

A blending amount of the component (D) is preferably 50 to 2,000 parts by mass, and particularly preferably 100 to 1,000 parts by mass relative to 100 parts by mass of a total blending amount of the component (A) and the component (B).

### Crosslinkable Polymer Compound (E)

The negative-type photosensitive resin composition of the present invention may contain a crosslinkable polymer compound (E). That is, the negative-type photosensitive resin composition preferably further contains a crosslinkable polymer compound (E) having a structural unit represented by the following general formula (9) and having a group that is crosslinkable with the component (A).

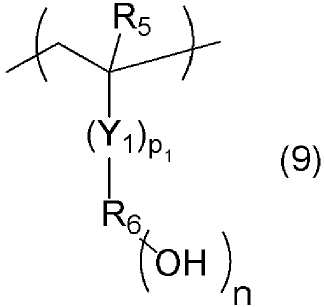

In the formula, R₅ represents a hydrogen atom or a methyl group; R₆ represents a (n+1)-valent linear, branched, or cyclic aliphatic saturated hydrocarbon group having 1 to 15 carbon atoms, aromatic hydrocarbon group having 6 to 15 carbon atoms, a benzyl group, or a naphthalenemethyl group, and a carbon atom in the aliphatic saturated hydrocarbon group is optionally substituted with an oxygen atom; "n" represents an integer of 1 to 5; Y₁ each represents -C(=O)-O-, -C(=O)-NH-, or -C(=O)-N(R₇OH)-; R₇ represents a divalent linear, branched, or cyclic aliphatic saturated hydrocarbon group having 1 to 12 carbon atoms or an aromatic hydrocarbon group having 6 to 12 carbon atoms, and a carbon atom in the aliphatic saturated hydrocarbon group is optionally substituted with an oxygen atom; and "pi" represents 0 or 1.

Preferably usable examples for the structure represented by the general formula (9) specifically include the following examples.

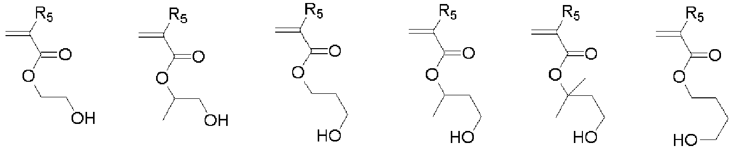

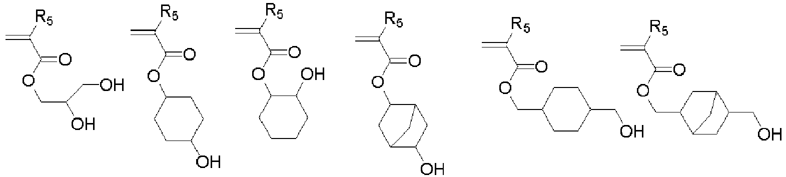

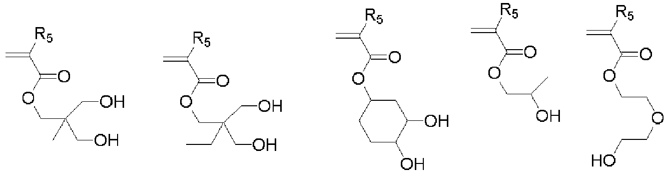

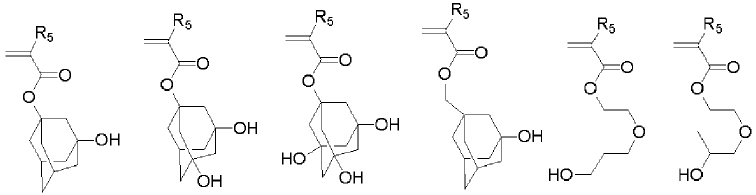

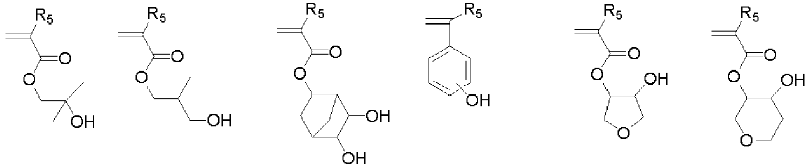

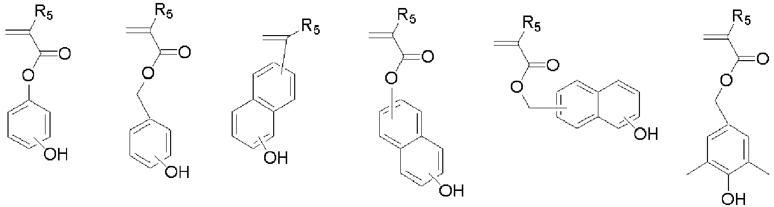

In the formulae, R₅ is same as above.

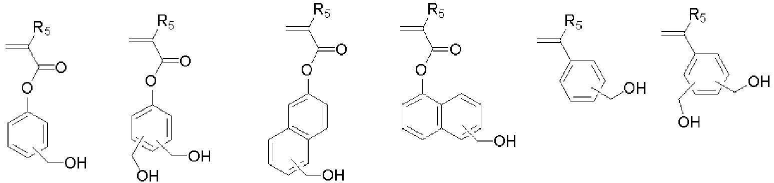

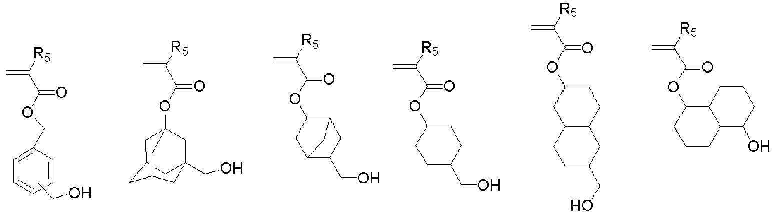

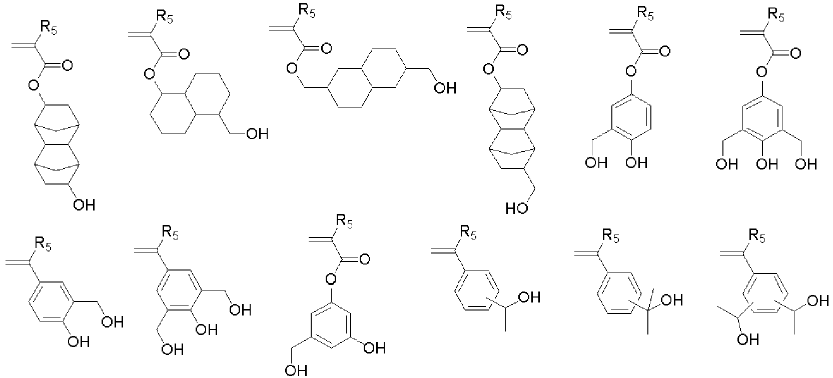

In the formulae, R₅ is same as above.

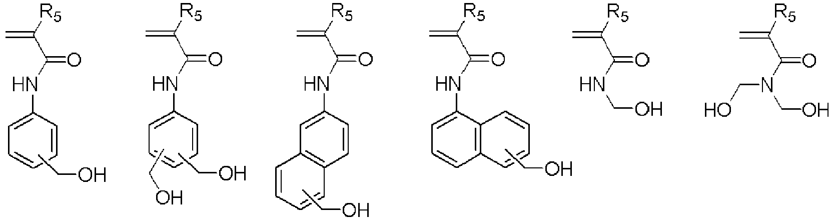

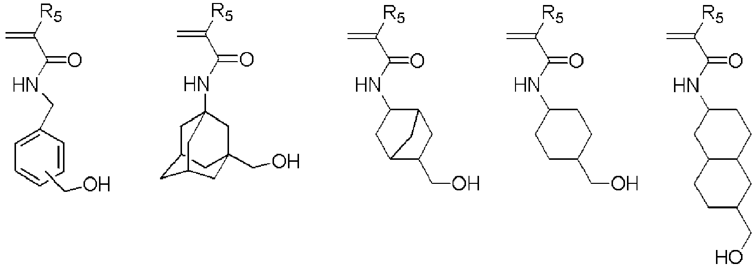

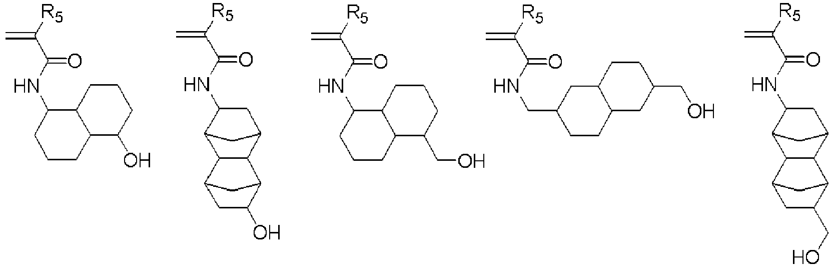

In the formulae, R₅ is same as above.

The crosslinkable polymer compound (E) contained in the negative-type photosensitive resin composition of the present invention is more preferably a crosslinkable polymer compound further having a structural unit represented by the following general formula (10) and a structural unit represented by the following general formula (11) having a group that is crosslinkable with the component (A) in order to improve the crosslinking density while keeping the alkali solubility.

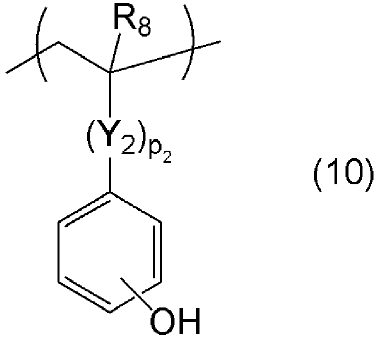

In the formula, R₈ represents a hydrogen atom or a methyl group; Y₂ each represents -C(=O)-O-, -C(=O)-NH-, or -C(=O)-N(RgOH)-; R₉ represents a divalent linear, branched, or cyclic aliphatic saturated hydrocarbon group having 1 to 12 carbon atoms or an aromatic hydrocarbon group having 6 to 12 carbon atoms, and a carbon atom in the aliphatic saturated hydrocarbon group is optionally substituted with an oxygen atom; and p₂ represents 0 or 1.

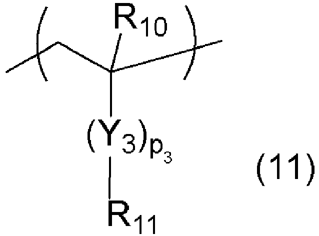

In the formula, R₁₀ represents a hydrogen atom or a methyl group; R₁₁ represents a group having an oxazoline group, an isocyanate group, a block isocyanate group, an oxetanyl group, or an epoxy group; Y₃ represents -C(=O)-O-, a phenylene group, or a naphthylene group; and p₃ represents 0 or 1.

The above block isocyanate group refers to an organic group in which an isocyanate group (-N=C=O) is blocked with an appropriate protective group. For the block isocyanate group, the isocyanate group and a blocking agent may be reacted to form the block isocyanate group.

When reacting with a hydroxy group or a carboxy group in the component (A), the blocking agent is eliminated and allows the reaction between the hydroxy group or the carboxy group and the isocyanate group to form the crosslinked structure. The blocking agent is an active-hydrogen-containing compound that can react with an isocyanate, and examples thereof include an alcohol, a phenol, a polycyclic phenol, an amide, an imide, an imine, a thiol, an oxime, a lactam, an active-hydrogen-containing heteroring, and an active-methylene-containing compound.

Preferable block isocyanate groups are described in paragraphs [0015] to [0025] in JP 6601628 B2, and compounds thereof may be used.

Meanwhile, when the structure represented by the general formula (10) has a carbonyl group or an amide group, which is an electron withdrawing group, at a p-position relative to a phenolic hydroxy group, acidity of the phenolic hydroxy group increases to improve solubility in an alkaline aqueous solution developer. Preferably usable examples specifically include, but not limited to, the following examples.

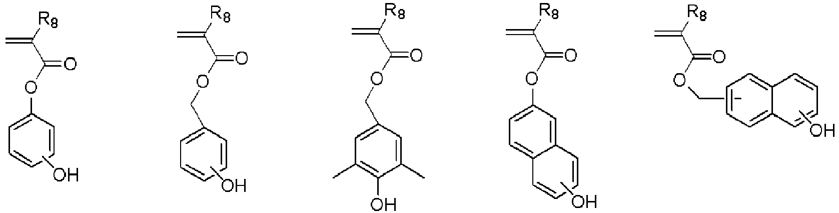

In the formulae, R₈ is same as above.

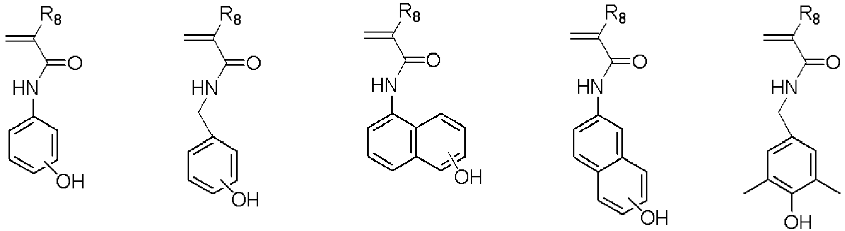

In the formulae, R₈ is same as above.

The general formula (10) is effective as a unit for enhancing the crosslinking in addition to the alkali solubility, and the curability can be furthermore improved by combination with the crosslinking group.

The crosslinkable polymer compound (E) contained in the negative-type photosensitive resin composition of the present invention is preferably a crosslinkable polymer compound further having a structural unit represented by the following general formula (12) and having an epoxy group or an oxetanyl group in order to improve the crosslinking density.

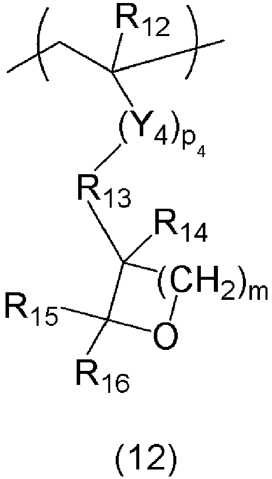

In the general formula (12), R₁₂ represents a hydrogen atom or a methyl group; Y₄ each represents - C(=O)-O-, a phenylene group, or a naphthylene group; R₁₃ represents a linear, branched, or cyclic alkylene group having 1 to 15 carbon atoms and optionally having a hydroxy group, an ester group, an ether group, or an aromatic hydrocarbon; R₁₄ represents a hydrogen atom or a linear, branched, or cyclic alkyl group having 1 to 6 carbon atoms, and is optionally bonded to R₁₃ to form a ring; R₁₅ represents a hydrogen atom or a linear, branched, or cyclic alkyl group having 1 to 6 carbon atoms; R₁₆ represents a hydrogen atom or a linear alkyl group having 1 to 6 carbon atoms, and is optionally bonded to R₁₃ to form a ring; "m" represents 0 or 1; and p₄ represents 0 or 1.

Examples of the unit represented by the general formula (12) include the following units.

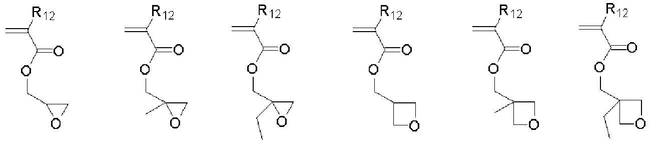

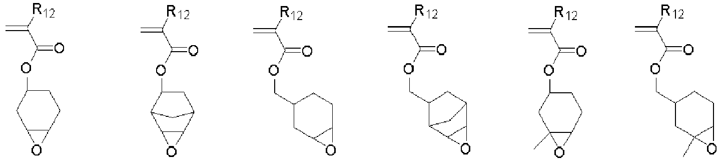

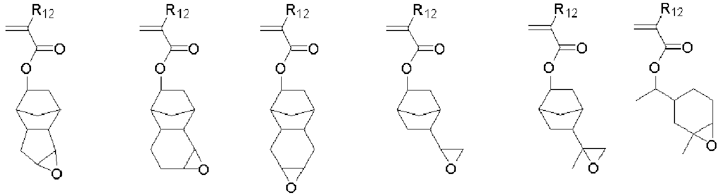

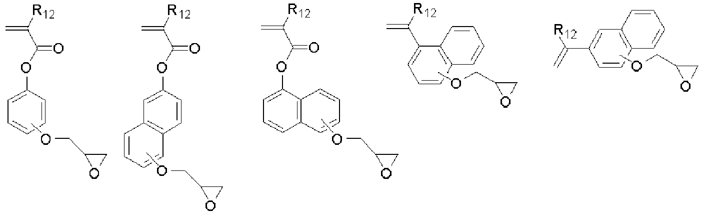

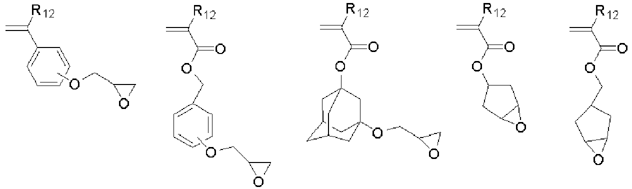

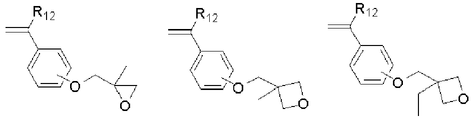

In the formulae, R₁₂ is same above.

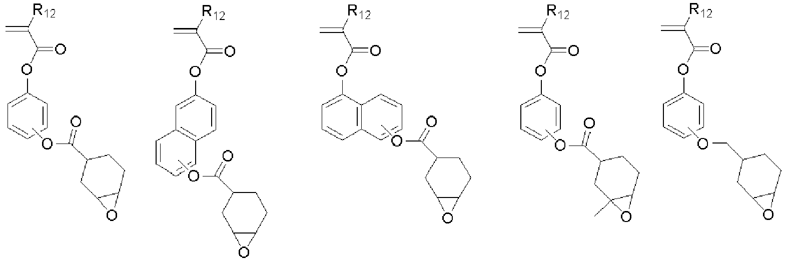

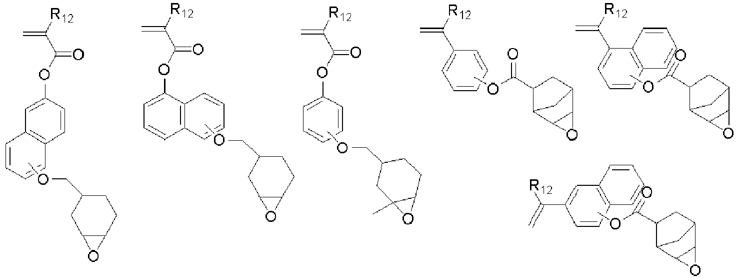

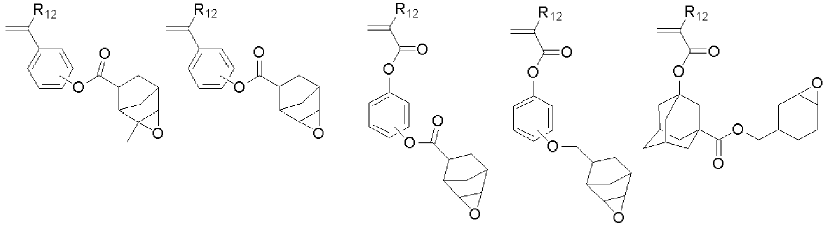

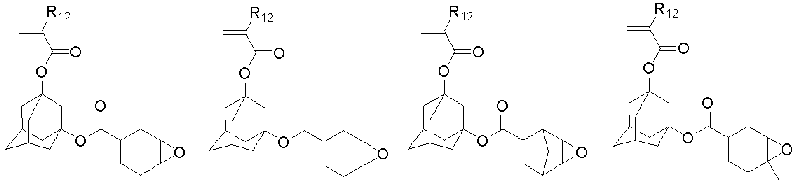

In the formulae, R₁₂ is same above.

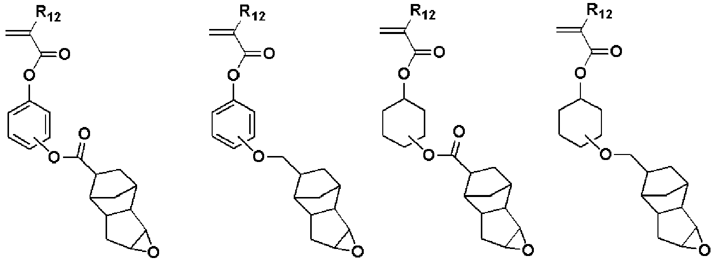

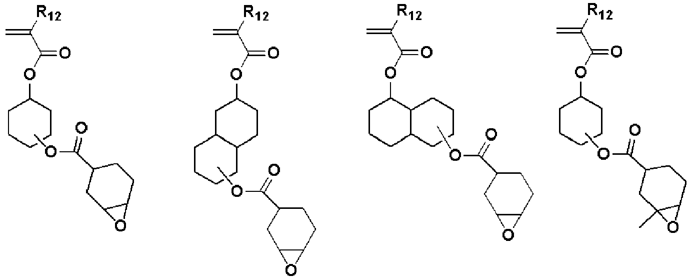

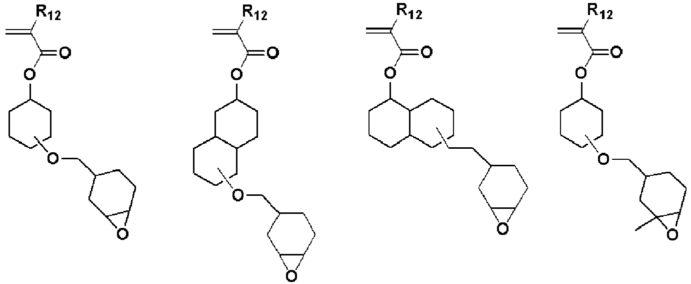

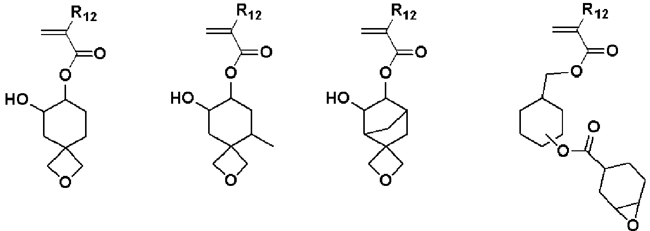

In the formulae, R₁₂ is same above.

Some monomers to obtain the repeating unit having an epoxy group or an oxetanyl group are disclosed in JP 2003-055362 A, JP 2005-008847 A, and JP 2005-018012 A.

The structural unit represented by the general formula (10) has excellent solvent solubility and alkali solubility but has no crosslinking ability, and thus is preferably copolymerized with the structural unit having the crosslinking ability represented by the general formula (12). A polymer composed of only an epoxy group or an oxetanyl group, which has crosslinking ability, represented by the general formula (12), has excellent crosslinking ability but having no alkali solubility, and thus preferably copolymerized with the structural unit represented by the general formula (10).

Therefore, when the repeating units are copolymerized as above, the component (E) is preferably a crosslinkable polymer compound having the structural units represented by the following general formula (10) and the following general formula (12).

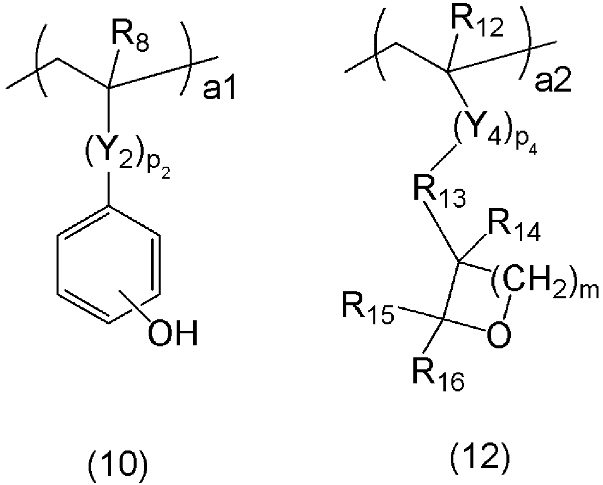

In the formulae, R₈ to R₁₆, Y₂, Y₄, "m", p₂, and p₄ are same as above, 0<a1<1.0, 0<a2<1.0, and 0<a1+a2≤1.0.

The crosslinkable polymer compound (E) contained in the negative-type photosensitive resin composition of the present invention is more preferably a crosslinkable polymer compound further having a structural unit represented by the following general formula (13) from the viewpoint of further improvement of crosslinking reactivity in lithographic patterning to improve dissolution contrast of unexposed/exposed portions in an alkaline developer.

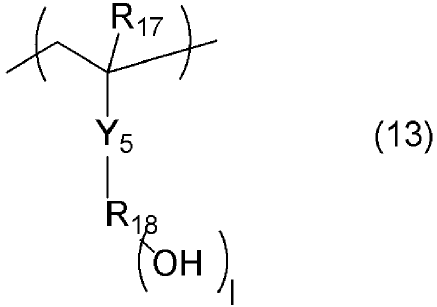

In the formula, R₁₇ represents a hydrogen atom or a methyl group; R₁₈ represents a single bond or a (l+1)-valent linear, branched, or cyclic aliphatic saturated hydrocarbon group having 1 to 13 carbon atoms, and a carbon atom in the aliphatic saturated hydrocarbon group is optionally substituted with an oxygen atom; Y₅ each represents -C(=O)-O-, -C(=O)-O-R₁₉-, -C(=O)-NH-, -C (=0) - N(R₁₉OH)-, a phenylene group, or a naphthylene group; R₁₉ represents a divalent linear, branched, or cyclic aliphatic saturated hydrocarbon group having 1 to 12 carbon atoms or an aromatic hydrocarbon group having 6 to 12 carbon atoms, and a carbon atom in the aliphatic saturated hydrocarbon group is optionally substituted with an oxygen atom; and "l" represents 0 or 1.

Examples of the unit of the general formula (13) include those having no aromatic hydrocarbon group among units described as the examples of the unit of the general formula (9).

The crosslinkable polymer compound (E) contained in the negative-type photosensitive resin composition of the present invention is more preferably a crosslinkable compound further having at least one or more structural units selected from the group consisting of cyclization-polymerized structural units represented by the following general formula (14), the following general formula (15), the following general formula (16), and the following general formula (17) from the viewpoint of improving adhesiveness to the substrate and heat resistance.

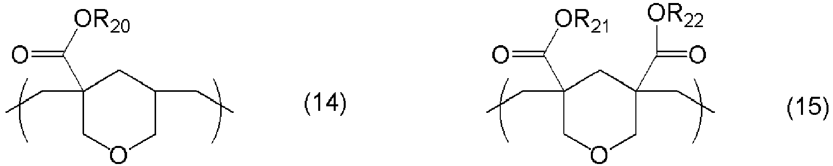

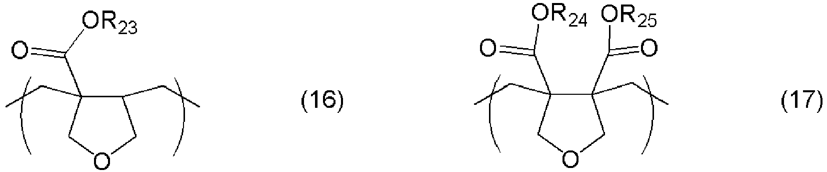

In the formulae, R₂₀, R₂₁, R₂₂, R₂₃, R₂₄, and R₂₅ each independently represent a hydrogen atom or a linear or branched alkyl group having 1 to 5 carbon atoms.

Structural units formed by cyclization polymerization of a monomer unit represented by the following general formula (51) or (52) are particularly preferable. These monomers may be used singly, or may be used in combination of two or more.

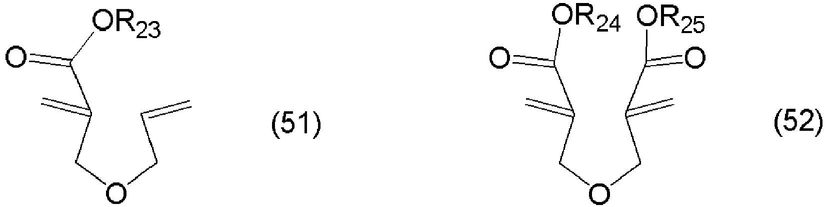

In the formulae, R₂₃, R₂₄, and R₂₅ are same as above.

Particularly, specific examples of commercially available usable monomers include ACRYCURE RD series and ACRYCURE RE series (trade names, manufactured by NIPPON SHOKUBAI CO., LTD.).

The above monomer unit (51) to be cyclization-polymerized to form the structural unit of the general formula (16) is more preferable from the viewpoints of polymerizability and stability.

The component (E) is preferably a crosslinkable polymer compound having structural units represented by the following general formula (10), the following general formula (12), the following general formula (13), and the following general formula (16) in order to achieve all of mechanical properties, alkali solubility, and crosslinking ability.

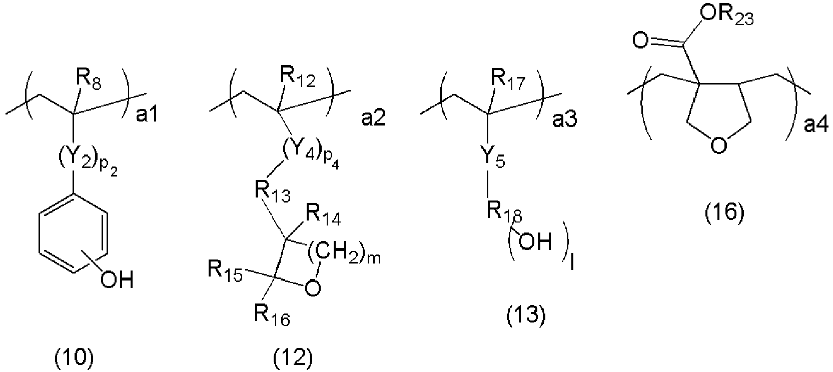

Here, 0<a1<1.0, 0<a2<1.0, 0<a3<1.0, 0<a4<1.0, and 0<a1+a2+a3+a4≤1.0. In the formulae (10), (12), (13), and (16), R₈, R₁₂ to R₁₈, R₂₃, Y₂, Y₄, Y₅, "m", p₂, p₄, "l" are same as above.

The crosslinkable polymer compound (E) contained in the negative-type photosensitive resin composition of the present invention may further have a structural unit represented by the following general formula (53) from the viewpoints of improvement of adhesiveness to the substrate and flexibility of the cured film to more improve mechanical properties and heat and impact resistance.

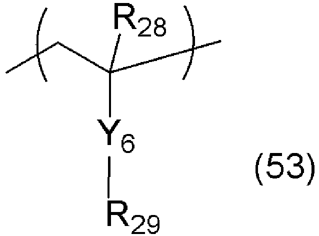

In the general formula (53), R₂₈ represents a hydrogen atom or a methyl group; R₂₉ represents a monovalent organic group having a primary, secondary, or tertiary amino group, an alkyl group having 4 to 20 carbon atoms, an aryl group having 6 to 10 carbon atoms, or an alicyclic group having 6 to 10 carbon atoms; and Y₆ represents -C(=O)-O- or -C(=O)-NH-.

Specific examples of a monomer to yield the repeating unit represented by the general formula (53) include aminoethyl (meth)acrylate, N-methylaminoethyl (meth)acrylate, N,N-dimethylaminoethyl (meth)acrylate, N-ethylaminoethyl (meth)acrylate, N,N-diethylaminoethyl (meth)acrylate, aminopropyl (meth)acrylate, N-methylaminopropyl (meth)acrylate, N,N-dimethylaminopropyl (meth)acrylate, N-ethylaminopropyl (meth)acrylate, N,N-diethylaminopropyl (meth)acrylate, aminoethyl(meth)acrylamide, N-methylaminoethyl(meth)acrylamide, N,N-dimethylaminoethyl(meth)acrylamide, N-ethylaminoethyl(meth)acrylamide, N,N-diethylaminoethyl(meth)acrylamide, aminopropyl(meth)acrylamide, N-methylaminopropyl(meth)acrylamide, N,N-dimethylaminopropyl(meth)acrylamide, N-ethylaminopropy(meth)acrylamide, N,N-diethylaminopropyl(meth)acrylamide, piperidin-4-yl (meth)acrylate, 1-methylpiperidin-4-yl (meth)acrylate, 2,2,6,6-tetramethylpiperidin-4-yl (meth)acrylate, 1,2,2,6,6-pentamethylpiperidin-4-yl (meth)acrylate, (piperidin-4-yl)methyl (meth)acrylate, and 2-(piperidin-4-yl)ethyl (meth)acrylate.

Specific examples of the (meth)acrylic acid alkyl ester further include (meth)acrylic acid butyl ester, (meth)acrylic acid pentyl ester, (meth)acrylic acid hexyl ester, (meth)acrylic acid heptyl ester, (meth)acrylic acid octyl ester, (meth)acrylic acid nonyl ester, (meth)acrylic acid decyl ester, (meth)acrylic acid undecyl ester, (meth)acrylic acid dodecyl ester, (meth)acrylic acid tridecyl ester, (meth)acrylic acid tetradecyl ester, (meth)acrylic acid pentadecyl ester, (meth)acrylic acid hexadecyl ester, (meth)acrylic acid heptadecyl ester, (meth)acrylic acid octadecyl ester, (meth)acrylic acid nonadecyl ester, and (meth)acrylic acid eicosyl ester.

For a purpose of improving mechanical strength of the cured film, olefins having an aromatic group, such as styrenes, vinylnaphthalenes, vinylanthracenes, vinylcarbazoles, acenaphthylenes, and indenes; and alicyclic olefins, such as norbornenes and norbornadiene, may be further copolymerized.

The crosslinkable polymer compound (E) contained in the negative-type photosensitive resin composition of the present invention has a weight-average molecular weight in terms of polystyrene by gel permeation chromatography (GPC) of preferably 1,000 to 500,000, and particularly preferably 2,000 to 30,000. The weight-average molecular weight of 1,000 or more raises a glass transition temperature to prevent deformation of the pattern in thermal crosslinking after development of the negative-type photosensitive resin composition. The weight-average molecular weight of 500,000 or less causes no pinhole failure in applying. Two or more polymers having different composition ratios, molecular weight distributions, or molecular weights may be blended.

In this case, an addition amount of the crosslinkable polymer compound (E) is preferably 10 parts by mass or more and 100 parts by mass or less relative to 100 parts by mass of the polymer (A). The addition amount of 10 parts by mass or more yields high toughness in the aforementioned cured film with the polymer (A), and the addition amount of 100 parts by mass or less causes no deterioration of tensile strength of the cured film. Therefore, the addition amount of the crosslinkable polymer compound (E) is preferably within the above range. The addition amount of the crosslinkable polymer compound (E) is more preferably 10 parts by mass or more and 70 parts by mass or less, and further preferably 30 parts by mass or more and 50 parts by mass or less. This range yields good balance between the lithographic patterning performance and physical properties of the cured film.

The negative-type photosensitive resin composition of the present invention may further contain one or more selected from a basic compound (F), a thermal acid generator (G), an oxidation inhibitor (H), and a silane compound (I) in addition to the essential components being the above components (A), (B), (C), and (D), and the component (E), which is preferably contained. Hereinafter, the components (F), (G), (H), and (I) will be described in detail.

### Basic Compound (F)

Suitable for the basic compound of the component (F) is a compound that can reduce diffusion rate in diffusion of the acid generated from the photoacid generator (B) in the photosensitive resin composition. Blending such a basic compound (F) reduces the diffusion rate of the acid in the photosensitive resin composition to improve resolution, inhibit change in sensitivity after light exposure, and reduce dependency on the substrate and environment, which can improve light exposure latitude, pattern profile, etc.

Examples of the basic compound (F) include ammonia, primary, secondary, or tertiary aliphatic amines, hybrid amines, aromatic amines, heterocyclic amines, nitrogen-containing compounds having a carboxy group, nitrogen-containing compounds having a sulfonyl group, nitrogen-containing compounds having a hydroxy group, nitrogen-containing compounds having a hydroxyphenyl group, alcoholic nitrogen-containing compounds, amide derivatives, and imide derivatives.

Specific examples of the primary aliphatic amines include methylamine, ethylamine, n-propylamine, isopropylamine, n-butylamine, isobutylamine, sec-butylamine, tert-butylamine, pentylamine, tert-amylamine, cyclopentylamine, hexylamine, cyclohexylamine, heptylamine, octylamine, nonylamine, decylamine, dodecylamine, cetylamine, methylenediamine, ethylenediamine, and tetraethylenepentamine. Specific examples of the secondary aliphatic amines include dimethylamine, diethylamine, di-n-propylamine, diisopropylamine, di-n-butylamine, diisobutylamine, di-sec-butylamine, dipentylamine, dicyclopentylamine, dihexylamine, dicyclohexylamine, diheptylamine, dioctylamine, dinonylamine, didecylamine, didodecylamine, dicetylamine, N,N-dimethylmethylenediamine, N,N-dimethylethylenediamine, and N,N-dimethyltetraethylenepentamine. Specific examples of the tertiary aliphatic amines include trimethylamine, triethylamine, tri-n-propylamine, triisopropylamine, tri-n-butylamine, triisobutylamine, tri-sec-butylamine, tripentylamine, tricyclopentylamine, trihexylamine, tricyclohexylamine, triheptylamine, trioctylamine, trinonylamine, tridecylamine, tridodecylamine, tricetylamine, N,N,N',N'-tetramethylmethylenediamine, N,N,N',N'-tetramethylethylenediamine, and N,N,N',N'-tetramethyltetraethylenepentamine.

Examples of the hybrid amines include dimethylethylamine methylethylpropylamine, benzylamine, phenethylamine, and benzyldimethylamine.

Specific examples of the aromatic amines and heterocyclic amines include aniline derivatives (for example, aniline, N-methylaniline, N-ethylaniline, N-propylaniline, N,N-dimethylaniline, 2-methylaniline, 3-methylaniline, 4-methylaniline, ethylaniline, propylaniline, trimethylaniline, 2-nitroaniline, 3-nitroaniline, 4-nitroaniline, 2,4-dinitroaniline, 2,6-dinitroaniline, 3,5-dinitroaniline, N,N-dimethyltoluidine, etc.), diphenyl(p-tolyl)amine, methyldiphenylamine, triphenylamine, phenylenediamine, naphthylamine, diaminonaphthalene, pyrrole derivatives (for example, pyrrole, 2H-pyrrole, 1-methylpyrrole, 2,4-dimethylpyrrole, 2,5-dimethylpyrrole, N-methylpyrrole, etc.), oxazole derivatives (for example, oxazole, isoxazole, etc.), thiazole derivatives (for example, thiazole, isothiazole, etc.), imidazole derivatives (for example, imidazole, 4-methylimidazole, 4-methyl-2-phenylimidazole, etc.), pyrazole derivatives, furazan derivatives, pyrroline derivatives (for example, pyrroline, 2-methyl-1-pyrroline, etc.), pyrrolidine derivatives (for example, pyrrolidine, N-methylpyrrolidine, pyrrolidinone, N-methylpyrrolidone, etc.), imidazoline derivatives, imidazolidine derivatives, pyridine derivatives (for example, pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridine, 4-pyrolidinopyridine, 1-methyl-4-phenylpyridine, 2-(1-ethylpropyl)pyridine, aminopyridine, dimethylaminopyridine, etc.), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (for example, quinoline, 3-quinolinecarbonitrile, etc.), isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, and uridine derivatives.

Examples of the nitrogen-containing compound having a carboxy group further include aminobenzoic acid, indolecarboxylic acid, and amino acid derivatives (for example, nicotinic acid, alanine, arginine, aspartic acid, glutamic acid, glycine, histidine, isoleucine, glycylleucine, leucine, methionine, phenylalanine, threonine, lysine, 3-aminopyradine-2-carboxylic acid, and methoxyalanine).

Examples of the nitrogen-containing compound having a sulfonyl group include 3-pyridinesulfonic acid and pyridinium p-toluenesulfonate.

Examples of the nitrogen-containing compound having a hydroxy group, the nitrogen-containing compound having a hydroxyphenyl group, and the alcoholic nitrogen-containing compound include 2-hydroxypyridine, aminocresol, 2,4-quinolinediol, 3-indolemethanol hydrate, monoethanolamine, diethanolamine, triethanolamine, N-ethyldiethanolamine, N,N-diethylethanolamine, triisopropanolamine, 2,2'-iminodiethanol, 2-aminoethanol, 3-amino-1-propanol, 4-amino-1-butanol, 4-(2-hydroxyethyl)morpholine, 2-(2-hydroxyethyl)pyridine, 1-(2-hydroxyethyl)piperazine, 1-[2-(2-hydroxyethoxy)ethyl]piperazine, piperidineethanol, 1-(2-hydroxyethyl)pyrrolidine, 1-(2-hydroxyethyl)-2-pyrolidinone, 3-piperidino-1,2-propanediol, 3-pyrrolidino-1,2-propanediol, 8-hydroxyjulolidine, 3-quinuclidinol, 3-tropanol, 1-methyl-2-pyrrolidineethanol, 1-aziridineethanol, N-(2-hydroxyethyl)phthalimide, and N-(2-hydroxyethyl)isonicotinamide.

Examples of the amide derivatives include formamide, N-methylformamide, N,N-dimethylformamide, acetamide, N-methylacetamide, N,N-dimethylacetamide, propionamide, and benzamide.

Examples of the imide derivatives include phthalimide, succinimide, and maleimide.

The basic compound (F) may be used singly, or in combination of two or more. The blending amount is preferably 0 to 2 parts by mass, and when blended, 0.01 to 2 parts by mass, and particularly preferably 0.01 to 1 part by mass relative to 100 parts by mass of the polymer of the component (A). The blending amount of 2 parts by mass or less does not deteriorate sensitivity.

### Thermal Acid Generator (G)

The negative-type photosensitive resin composition of the present invention may further contain the thermal acid generator (G). The thermal acid generator of the component (G) may be added in a step of heating and post-curing at a temperature of 100 to 300°C performed after patterning, described later, for a purpose of thermally enhancing the crosslinking reactions between the component (A) and the component (C), and the component (E).

The component (G) is particularly preferably a component that does not enhance the curing of the film before patterning with development and that does not inhibit the patterning. To achieve this requirement, the component (G) is preferably a component that does not generate an acid at a temperature in a drying step after applying the photosensitive resin composition, and then removing the solvent, and that firstly generates an acid by thermal treatment after the patterning to enhance of curing of the pattern or film of the negative-type photosensitive resin composition. Specifically, preferable is a compound that is decomposed by a thermal treatment at 100°C to 300°C, preferably 150°C to 300°C, to generate an acid. Containing such a component (G) can convert the pattern or film of the negative-type photosensitive resin composition into a pattern or film with further proceeded crosslinking and curing reactions in the step of heating and post-curing at a temperature of 100 to 300°C performed after the patterning. The component (G) can furthermore proceed the crosslinking and curing reactions to furthermore improve mechanical strength, chemical resistance, adhesiveness, etc. of the obtained pattern or film.

As the preferable thermal acid generator (G), compounds described in paragraphs [0061] to [0085] in JP 2007-199653 A may be used.

A blending amount of the thermal acid generator (G) is preferably 0.1 part by mass or more, more preferably 0.5 parts by mass or less, preferably 30 parts by mass or less, and more preferably 5 parts by mass or less relative to 100 parts by mass of the component (A) in the negative-type photosensitive resin composition of the present invention. The blending amount of 0.1 part by mass or more enhances the crosslinking reaction. The blending amount of 30 parts by mass or less does not deteriorate the alkali developability of the composition and not cause development residue.

### Oxidation Inhibitor (H)

The negative-type photosensitive resin composition of the present invention may further contain the oxidation inhibitor (H). Containing the oxidation inhibitor of the component (H) inhibits oxidative deterioration of the aliphatic group or phenolic hydroxy group in the component (A). In addition, the antirust effect to the metal material can inhibit metal oxidation due to external moisture, the photoacid generator, the thermal acid generator, etc. and can inhibit adhesiveness deterioration and peeling due to the metal oxidation.

Here, specific examples of the usable oxidation inhibitor (H) preferably include hindered-phenol-type oxidation inhibitors, phosphorus-type oxidation inhibitors, and sulfur-type oxidation inhibitors. The oxidation inhibitor (H) is not limited thereto. These oxidation inhibitors (H) may be used singly, or may be used in combination of two or more.

Among the specific examples of the oxidation inhibitor (H), examples of the hindered-phenol-type oxidation inhibitors include pentaerythritol tetrakis[3-(3,5-di-tert-butyl-4-hydroxyphenyl)propionate] (BASF Japan Ltd., Irganox 1010 (trade name)), thiodiethylene bis[3-(3,5-di-tert-butyl-4-hydroxyphenyl)propionate] (BASF Japan Ltd., Irganox 1035 (trade name)), octadecyl [3-(3,5-di-tert-butyl-4-hydroxyphenyl)propionate] (BASF Japan Ltd., Irganox 1076 (trade name)), octyl-3,5-di-tert-butyl-4-hydroxy-hydrocinnamate (BASF Japan Ltd., Irganox 1135 (trade name)), 4,6-bis(octylthiomethyl-o-cresol) (BASF Japan Ltd., Irganox 1520L), SUMILIZER GA80 (manufactured by SUMITOMO CHEMICAL COMPANY, LIMITED, trade name), ADK STAB AO-20 (manufactured by ADEKA CORPORATION, trade name), ADK STAB AO-30 (manufactured by ADEKA CORPORATION, trade name), ADK STAB AO-40 (manufactured by ADEKA CORPORATION, trade name), ADK STAB AO-50 (manufactured by ADEKA CORPORATION, trade name), ADK STAB AO-60 (manufactured by ADEKA CORPORATION, trade name), ADK STAB AO-80 (manufactured by ADEKA CORPORATION, trade name), ADK STAB AO-330 (manufactured by ADEKA CORPORATION, trade name), and hindered-phenol-type oxidation inhibitors described in WO 2017/188153 A1.

Among the specific examples of the oxidation inhibitor (H), examples of the phosphorus-type oxidation inhibitor include triphenylphosphite, tris(methylphenyl)phosphite, triisooctylphosphite, tridecylphosphite, tris(2-ethylhexyl)phosphite, tris(nonylphenyl)phosphite, tris(octylphenyl)phosphite, tris[decylpoly(oxyethylene)]phosphite, tris(cyclohexylphenyl)phosphite, tricyclohexylphosphite, tri(decyl)thiophosphite, triisodecylthiophosphite, phenyl-bis(2-ethylhexyl)phosphite, phenyl-diisodecylphosphite, tetradecylpoly(oxyethylene)-bis(ethylphenyl)phosphite, phenyl-dicyclohexylphosphite, phenyl-diisooctylphosphite, phenyl-di(tridecyl)phosphite, diphenyl-cyclohexylphosphite, diphenyl-isooctylphosphite, diphenyl-2-ethylhexylphosphite, diphenyl-isodecylphosphite, diphenyl-cyclohexylphenylphosphite, and diphenyl-(tridecyl)thiophosphite.

Among the specific examples of the oxidation inhibitor (H), examples of the sulfur-type oxidation inhibitor include ADK STAB AO-412S (manufactured by ADEKA CORPORATION, trade name), AO-503S (manufactured by ADEKA CORPORATION, trade name), and SUMILIZER TP-D (manufactured by SUMITOMO CHEMICAL COMPANY, LIMITED, trade name).

The sulfur-type oxidation inhibitor and the phosphorus-type oxidation inhibitor are expected to have an effect of decomposing a peroxide.

A content of the oxidation inhibitor (H) is preferably 0.1 to 10 parts by mass, and more preferably 0.2 to 5 parts by mass relative to 100 parts by mass of the polymer of the component (A). The content of 0.1 part by mass or more improves adhesiveness to a metal material and inhibits peeling. The content of 10 parts by mass or less does not deteriorate the alkali developability of the composition and toughness of the cured film.

### Silane Compound (I)

The negative-type photosensitive resin composition of the present invention may further contain the silane compound (I). Containing the silane compound of the component (I) not only can improve adhesiveness to a metal material but also can inhibit peeling of the cured film in reliability tests such as a thermal impact test and a high-temperature high-humidity test.

The usable silane compound (I) is not particularly limited, but preferably has an alkoxysilyl group. Preferable specific examples thereof include, but not limited to, γ-glycidoxypropyltriethoxysilane, γ-glycidoxypropyltrimethoxysilane, 2-(3,4-epoxycyclohexyl)ethyltrimethoxysilane, bis(2-hydroxyethyl)-3-aminopropyl-triethoxysilane, γ-aminopropyltrimethoxysilane, γ-aminopropyltriethoxysilane, vinyltriethoxysilane, vinyltrimethoxysilane, γ-methacryloxypropyltrimethoxysilane, γ-acryloxypropyltrimethoxysilane, 3-mercaptopropyltrimethoxysilane, 3-isocyanatepropyltriethoxysilane, bis(2-hydroxyethyl)-3-aminopropyltriethoxysilane, ethyl triethoxysilylpropylcarbamate, 3-(triethoxysilyl)propylsuccinic anhydride, phenyltriethoxysilane, phenyltrimethoxysilane, N-phenyl-3-aminopropyltrimethoxysilane, 3-triethoxysilyl-N-(1,3-dimethylbutylidene)propylamine, amide-group-containing silane compounds described in JP 6414060 B2, thiourea-group-containing silane compounds described in WO 2016/140024 A1 and JP 5987984 B2, and thiol-group-containing silane compounds described in JP 2017-044964 A. Further, these silane compounds (I) may be singly, or use in combination of two or more.

A content of the silane compound (I) is preferably 0.1 to 20 parts by mass, more preferably 1 to 10 parts by mass, and further preferably 3 to 6 parts by mass relative to 100 parts by mass of the polymer of the component (A). The content of 0.1 part by mass or more can impart more sufficient adhesiveness to the substrate, and the content of 20 parts by mass or less can more inhibit problems such as increase in viscosity during storage at room temperature. The content of 10 parts by mass or less does not deteriorate the alkali developability of the composition and not cause development residue.

### Other Components

The negative-type photosensitive resin composition may further contain components other than the component (A), the component (B), the component (C), the component (D), the component (E), the component (F), the component (G), the component (H), and the component (I). Examples of the other components include a surfactant (J) and a dissolution inhibitor (K). Compounds exemplified below can be suitably used. The compounds are not limited thereto.

### Surfactant (J)

The surfactant (J) is preferably a nonionic surfactant, and examples thereof include fluorine-based surfactants, specifically a perfluoroalkylpolyoxyethyleneethanol, a fluorinated alkyl ester, a perfluoroalkylamine oxide, a fluorine-containing organosiloxane compound, and non-fluorine organosiloxane compound.

As these surfactants (J), commercially available compounds may be used. Examples thereof include Fluorad FC-4430 (manufactured by Sumitomo 3M Limited, trade name), PF-6320 (manufactured by OMNOVA Inc., trade name), PF-636 (manufactured by OMNOVA Inc., trade name), Surflon S-141 and S-145 (the above are manufactured by Asahi Glass Co., Ltd., trade name), UNIDYNE DS-401, DS-4031, and DS-451 (the above are manufactured by DAIKIN INDUSTRIES, LTD., trade name), and MEGAFACE F-8151 (manufactured by DIC Corporation, trade name), and X-70-093 and KP-341 (manufactured by Shin-Etsu Chemical Co., Ltd., trade name). Among these, preferable are Fluorad FC-4430 (manufactured by Sumitomo 3M Limited, trade name), PF-6320 (manufactured by OMNOVA Inc., trade name), PF-636 (manufactured by OMNOVA Inc., trade name), and KP-341 (manufactured by Shin-Etsu Chemical Co., Ltd., trade name).

A blending amount of the surfactant (J) is preferably 0.01 to 0.05 parts by mass relative to 100 parts by mass relative to the polymer of the component (A). The blending amount within this range has an advantage of improving applicability to the substrate without impairing the patterning performance and characteristics of the cured film.

### Dissolution Inhibitor (K)

Examples of the dissolution inhibitor (K) include: compounds in which a hydrogen atom in a phenolic hydroxy group of a compound having two or more of the phenolic hydroxy groups in the molecule is substituted with an acid-labile group at a proportion of 0 to 100 mol% as an entirety in average; or compounds in which a hydrogen atom in a carboxy group of a compound having the carboxy group in the molecule is substituted with an acid-labile group at a proportion of 50 to 100 mol% as an entirety in average, the compounds having a weight-average molecular weight of 100 to 1,000, preferably 150 to 800.

The substitution proportion of the hydrogen atom in the phenolic hydroxy group with the acid-labile group is 0 mol% or more, preferably 30 mol% or more, and the upper limit is 100 mol%, and more preferably 80 mol% in average in the entirety of the phenolic hydroxy group. The substitution proportion of the hydrogen atom in the carboxy group with the acid-labile group is 50 mol% or more, preferably 70 mol% or more, and the upper limit is 100 mol% as an entirety in average in the carboxy group.

In this case, compounds represented by the following formulae (K1) to (K14) are preferable as such a compound having two or more phenolic hydroxy groups or such a compound having a carboxy group.

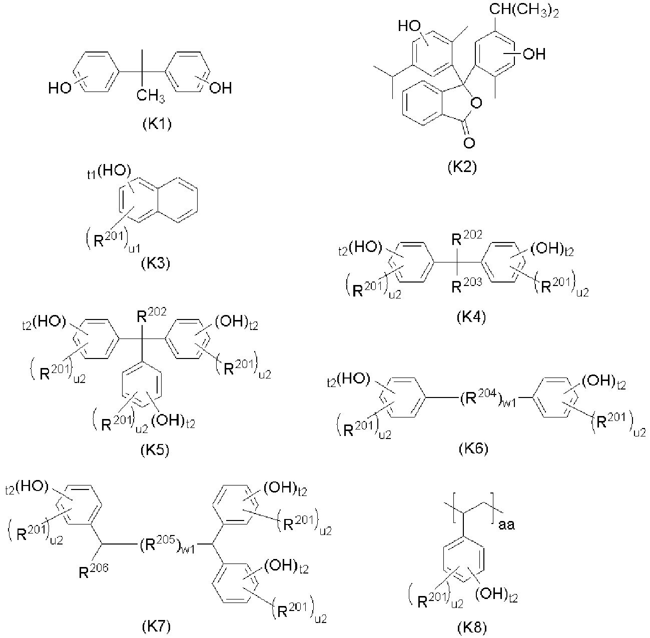

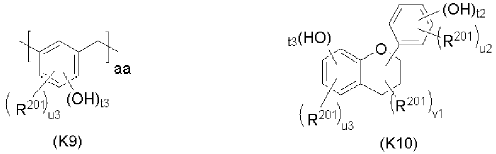

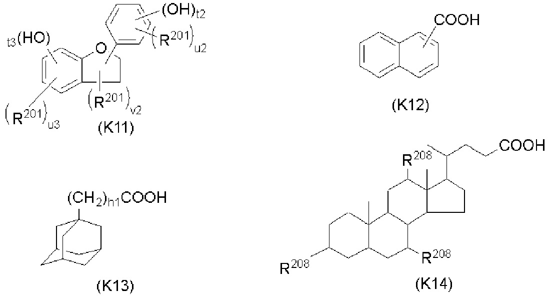

Note that. in the formulae, R²⁰¹ and R²⁰² each represent a hydrogen atom or a linear or branched alkyl group or alkenyl group having 1 to 8 carbon atoms. R²⁰³ represents a hydrogen atom or a linear or branched alkyl group or alkenyl group having 1 to 8 carbon atoms. R²⁰⁴ represents -(CH₂)ᵢ₁- (i1 = 2 to 10), an arylene group having 6 to 10 carbon atoms, a carbonyl group, a sulfonyl group, an oxygen atom, or a sulfur atom. R²⁰⁵ represents an alkylene group having 1 to 10 carbon atoms, an arylene group having 6 to 10 carbon atoms, a carbonyl group, a sulfonyl group, an oxygen atom, or a sulfur atom. R²⁰⁶ represents a hydrogen atom, a linear or branched alkyl group having 1 to 8 carbon atoms, an alkenyl group, or a phenyl group or a naphthyl group each substituted with a hydroxy group. R²⁰⁸ represents a hydrogen atom or a hydroxy group. v1 represents an integer of 0 to 2, and v2 represents 0 or 1. w1 and h1 represents 0 or 1. t1, u1, t2, u2, t3, and u3 each satisfy t1+u1=8, t2+u2=5, and t3+u3=4, and represent a number such that at least one hydrogen group is present in each phenyl skeleton. "aa" represents a number such that a molecular weight of the compound of the formula (K8) or (K9) is 100 to 1,000.

A blending amount of the dissolution inhibitor (K) is more than 0 parts by mass and 50 parts by mass or less, preferably 5 to 50 parts by mass, and more preferably 5 to 20 parts by mass relative to 100 parts by mass of the polymer of the component (A). The dissolution inhibitor (K) may be used singly, or two or more may be mixed for use. Blending the component (K) improves dissolution, and the blending amount of 50 parts by mass or less does not cause film reduction of the pattern and not deteriorate the dissolution.

### (Patterning Method)

The present invention provides a patterning method comprising steps of:
(1) applying the aforementioned negative-type photosensitive resin composition on a substrate to form a photosensitive film;
(2) after a subsequent heating treatment, subjecting the photosensitive film to light exposure through a photomask by using high-energy ray having a wavelength of 190 to 500 nm or electron beam; and
(3) after the light exposure, subjecting the substrate to a heating treatment, and performing development by using a developer of an alkaline aqueous solution.

Hereinafter, the patterning method using the negative-type photosensitive resin composition of the present invention will be described.

With the negative-type photosensitive resin composition of the present invention, a pattern can be formed by adopting a known lithography technique. For example, the negative-type photosensitive resin composition is applied on a silicon wafer, a SiO₂ substate, a SiN substrate, or a substrate in which a pattern such as copper wiring is formed, in a manner of spin-coating (spin-coating method), and prebaking is performed under conditions at 80 to 130°C for approximately 50 to 600 seconds to form a photosensitive film having a thickness of 1 to 50 um, preferably 1 to 30 um, and further preferably 5 to 20 um.

In the spin-coating method, approximately 5 mL of the photosensitive resin composition is dispensed on the silicon substrate, and then the substrate is rotated to apply the photosensitive resin composition on the substate. In this case, regulating a rotation speed can easily regulate the film thickness of the photosensitive film on the substrate.

Then, a photomask for forming a target pattern is held over the photosensitive film, and exposure is performed by irradiation with high energy ray at a wavelength of 190 to 500 nm, such as i-line and g-line, or electron beam so that an exposure dose is appropriately 1 to 5,000 mJ/cm², and preferably approximately 100 to 2,000 mJ/cm².

Then, post exposure baking (PEB) is performed on a hotplate at 60 to 150°C for 1 to 10 minutes, preferably 80 to 120°C for 1 to 5 minutes.

Thereafter, development is performed. The negative-type photosensitive resin composition of the present invention can be subjected to alkaline development with a developer of an alkaline aqueous solution.

Meanwhile, a preferable developer of the alkaline aqueous solution usable for the alkaline development is a 2.38% tetramethylhydroxyammonium (TMAH) aqueous solution. The development may be performed by a common method such as a spraying method and a paddle method, immersion in the developer, etc. Thereafter, washing, rinsing, drying, etc. are performed as necessary to obtain the photosensitive film having the desired pattern.

### (Method for Forming Cured Film)

The present invention provides a method for forming a cured film comprising a step of heating and post-curing the patterned photosensitive film obtained by the aforementioned patterning method at a temperature of 100 to 300°C.

Specifically, the patterned photosensitive film obtained by the above patterning method is heated and post-cured by using an oven or a hotplate at a temperature of 100 to 300°C, preferably 150 to 300°C, and further preferably 180 to 250°C to form a cured film. The post-curing temperature of 100 to 300°C can increase a crosslinking density of the film of the photosensitive resin composition to remove a remained volatile component, and is preferable from the viewpoints of adhesive force to the substrate, heat resistance, strength, and electric properties. The post-curing time may be 10 minutes to 10 hours.

The formed pattern is used for a purpose of a protective film covering wiring, a circuit, a substrate, etc., and the formed pattern and the protective film have excellent insulability and exhibit excellent adhesive force on a metal layer such as Cu of the wiring and circuit to be covered, a metal electrode present on the substrate, or an insulative substrate present in the wiring and circuit to be covered, such as SiN. In addition, the pattern and the protective film can remarkably improve resolution performance to achieve further finer patterning while having mechanical strength suitable as the protective film.

### (Cured Film)

The cured film obtained as above has excellent adhesiveness to the substrate, heat resistance, electric properties, mechanical strength, and chemical resistance against an alkaline remover etc. In addition, a semiconductor device having the cured film as the protective film also has excellent reliability, specifically can prevent cracking in a temperature cycle test. The cured film is suitably used as a protective film (an interlayer insulative film or a surface-protective film) for electric and electronic components, a semiconductor device, etc.

Specifically, the present invention provides an interlayer insulative film or surface-protective film being a cured film formed by curing the above negative-type photosensitive resin composition.

The protective film has heat resistance, chemical resistance, and insulability, and therefore is effective for use of an insulative film for a semiconductor device including rewiring use, an insulative film for a multilayer printed substrate, a solder mask, a cover lay film, etc.

### (Electronic Component)

The present invention provides an electronic component comprising the above interlayer insulative film or the above surface-protective film. Such an electronic component has the protective film (the interlayer insulative film or the surface-protective film) having heat resistance, chemical resistance, and insulability, and therefore exhibits excellent reliability.

### EXAMPLE

Hereinafter, the present invention will be specifically described with showing Synthesis Examples, Comparative Synthesis Examples, Examples, and Comparative Examples, but the present invention is not limited to the following examples. A weight-average molecular weight is a value in terms of polystyrene by gel permeation chromatography (GPC).

### I. Synthesis of Polymer (Resin)

Chemical structural formulae and names of compounds used in the following Synthesis Examples will be described below. 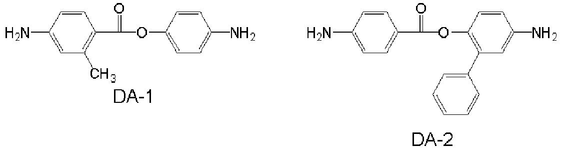 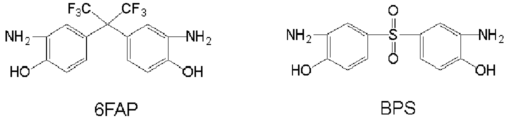 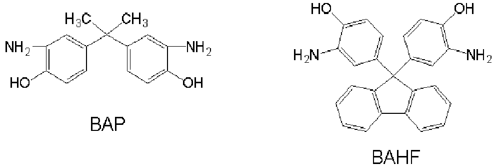 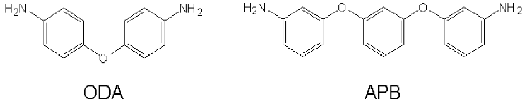 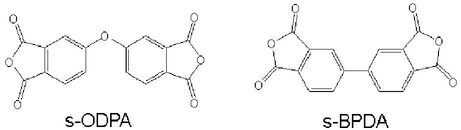 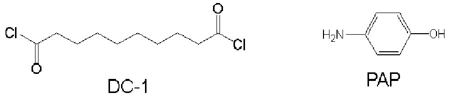 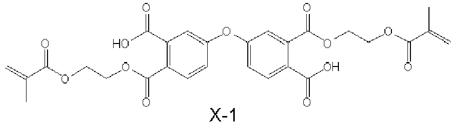
DA-1: 4-Aminophenyl 4-amino-2-methylbenzoate
DA-2: (2-Phenyl-4-aminophenyl) 4-aminobenzoate
6FAP: 2,2-Bis(3-amino-4-hydroxyphenyl)hexafluoropropane
BPS: Bis(3-amino-4-hydroxyphenyl) sulfone
BAP: 2,2-Bis(3-amino-4-hydroxyphenyl)propane
BAHF: 9,9-Bis(3-amino-4-hydroxyphenyl)fluorene
ODA: 4,4'-Diaminodiphenyl ether
APB: 1,3-Bis(3-aminophenoxy)benzene
s-ODPA: 3,3',4,4'-Oxydiphthalic dianhydride
s-BPDA: 3,3',4,4'-Biphenyltetracarboxylic dianhydride
DC-1: Sebacic dichloride
PAP: 4-Aminophenol
X-1: Tetracarboxylic acid diester compound synthesized in the following Synthesis Example 14

In addition to the above, D-400 and RT-1000 (both are diamines manufactured by Huntsman Corporation) were used.

### Synthesis Example 1: Synthesis of Polyimide Resin (A-1)

Into a 1-L flask equipped with a stirrer and a thermometer, 2.5 g (9.6 mmol) of DA-1, 30.0 g (81.9 mmol) of 6FAP, 1.0 g (9.6 mmol) of PAP, and 134 g of N-methyl-2-pyrrolidone were added, and stirred and dissolved at room temperature. Then, under room temperature, a solution in which 29.9 g (96.4 mmol) of s-ODPA was dissolved in 269 g of N-methyl-2-pyrrolidone was added dropwise, and after the dropwise addition was completed, the mixture was stirred under room temperature for 1 hour. Thereafter, 20 g of xylene was added into this reaction liquid, and the mixture was heated with reflux at 170°C for 3 hours while removing generated water outside the system. After cooling to room temperature, this reaction liquid was added dropwise into 2 L of stirred ultrapure water, a precipitate was filtered, appropriately washed with water, and dried under a reduced pressure at 40°C for 48 hours to obtain a polyimide resin (A-1). A molecular weight of this polymer was measured by GPC to find the weight-average molecular weight of 34,000 in terms of polystyrene.

### Synthesis Example 7: Synthesis of Polyamideimide Resin (A-7)

Into a 1-L flask equipped with a stirrer and a thermometer, 2.5 g (9.6 mmol) of DA-1, 30.0 g (81.9 mmol) of 6FAP, 1.0 g (9.6 mmol) of PAP, and 134 g of N-methyl-2-pyrrolidone were added, and stirred and dissolved at room temperature. Then, under room temperature, a solution in which 23.9 g (77.1 mmol) of s-ODPA was dissolved in 215 g of N-methyl-2-pyrrolidone was added dropwise, and after the dropwise addition was completed, the mixture was stirred under room temperature for 1 hour. Thereafter, 20 g of xylene was added into this reaction liquid, and the mixture was heated with reflux at 170°C for 3 hours while removing generated water outside the system. After cooling to room temperature, 3.1 g (38.6 mmol) of pyridine was added, and 4.6 g (19.3 mmol) of DC-1 was added dropwise so as to keep the temperature at 20°C or lower. After the dropwise addition was completed, this reaction liquid was added dropwise into 2 L of stirred ultrapure water, a precipitate was filtered, appropriately washed with water, and dried under a reduced pressure at 40°C for 48 hours to obtain a polyamideimide resin (A-7). A molecular weight of this polymer was measured by GPC to find the weight-average molecular weight of 33,000 in terms of polystyrene.

### Synthesis Example 13: Synthesis of Polyamide Resin (A-13)

Into a 1-L flask equipped with a stirrer and a thermometer, 2.9 g (9.6 mmol) of DA-2, 30.0 g (81.9 mmol) of 6FAP, 1.0 g (9.6 mmol) of PAP, and 136 g of N-methyl-2-pyrrolidone were added, and stirred and dissolved at room temperature. Then, 15.3 g (192.8 mmol) of pyridine was added, and 23.1 g (96.4 mmol) of DC-1 was added dropwise so as to keep the temperature at 20°C or lower. After the dropwise addition was completed, this reaction liquid was added dropwise into 2 L of stirred ultrapure water, a precipitate was filtered, appropriately washed with water, and dried under a reduced pressure at 40°C for 48 hours to obtain a polyamide resin (A-13). A molecular weight of this polymer was measured by GPC to find the weight-average molecular weight of 38,000 in terms of polystyrene.

### Synthesis Example 14: Synthesis of Tetracarboxylic Acid Diester Compound (X-1)

Into a 3-L flask equipped with a stirrer and a thermometer, 100 g (322 mmol) of s-ODPA, 65.2 g (644 mmol) of triethylamine, 39.3 g (322 mmol) of N,N-dimethyl-4-aminopyridine, and 400 g of γ-butyrolactone were added, and while the mixture is stirred at room temperature, 83.8 g (644 mmol) of hydroxyethyl methacrylate (HEMA) was added dropwise. After the dropwise addition, the mixture was stirred at room temperature for 24 hours. Thereafter, 370 g of 10% hydrochloric acid aqueous solution was added dropwise under ice cooling to terminate the reaction. Into the reaction liquid, 800 g of 4-methyl-2-pentanone was added, and the organic layer was separated and then washed with 600 g of water six times. The solvent in the obtained organic layer was distilled off to obtain 180 g of a tetracarboxylic acid diester compound (X-1).

### Synthesis Example 15: Synthesis of Polyimide Resin (A-15)

Into a 1-L flask equipped with a stirrer and a thermometer, 44.0 g (77.1 mmol) of X-1 and 176 g of N-methyl-2-pyrrolidone were added, and stirred and dissolved at room temperature. Then, under ice cooling, 18.8 g (158.1 mmol) of thionyl chloride was added dropwise so as to keep the reaction solution temperature at 10°C or lower, and after the dropwise addition was completed, the mixture was stirred for 2 hours under ice cooling. Subsequently, 4.6 g (19.3 mmol) of DC-1 was added, and then a solution in which 2.9 g (9.6 mmol) of DA-2, 30.0 g (81.9 mmol) of 6FAP, 1.0 g (9.6 mmol) of PAP, and 15.3 g (192.8 mmol) of pyridine were dissolved in 136 g of N-methyl-2-pyrrolidone was added dropwise so as to keep the reaction solution temperature at 10°C or lower under ice cooling. After the dropwise addition was completed, the temperature was turned to room temperature, and this reaction liquid was added dropwise into 3 L of stirred water, a precipitate was filtered, appropriately washed with water, and dried under a reduced pressure at 40°C for 48 hours to obtain a polyimide resin (A-15). A molecular weight of this polymer was measured by GPC to find the weight-average molecular weight of 35,000 in terms of polystyrene.

### Synthesis Examples 2 to 6, 8 to 12, and Comparative Examples 1 and 2: Synthesis of Polyimide Resins or Polyamideimide Resins (A-2) to (A-6), (A-8) to (A-12), (A-16), and (A-17)

Compounds at a weight shown in the following Table 1 were used as diamine compounds, monoamine compounds, tetracarboxylic dianhydrides, and dicarboxylic dichlorides to obtain resins (A-2) to (A-6), (A-8) to (A-12), (A-16), and (A-17) in the same manner as in Synthesis Example 1 in a case of the polyimide resin or in the same manner as in Synthesis Example 7 in a case of the polyamideimide resin. A molecular weight of each polymer was measured by GPC. The weight-average molecular weight in terms of polystyrene is shown in Table 1.

**[Table 1]**

| | | Diamine compound | | | Monoami ne compoun d | Tetracarboxylic dianhydride | | Dicarboxyl ic dichloride | Tetra-carboxylat e diester compound | Molecu lar weight |
|---|---|---|---|---|---|---|---|---|---|---|
| Synthesis Example 1 | A-1 | DA-1 2.5 g (9.6 mmol) | 6FAP 30.0 g (81.9 mmol) | | PAP 1.0 g (9.6 mmol) | s-ODPA 29.9 g (96.4 mmol) | | | | 34,000 |
| Synthesis Example 2 | A-2 | DA-2 2.9 g (9.6 mmol) | 6FAP 30.0 g (81.9 mmol) | | PAP 1.0 g (9.6 mmol) | s-ODPA 29.9 g (96.4 mmol) | | | | 33,000 |
| Synthesis Example 3 | A-3 | DA-2 2.9 g (9.6 mmol) | 6FAP 30.0 g (81.9 mmol) | | PAP 1.0 g (9.6 mmol) | | s-BPDA 2.8 g (9.6 mmol) | | | 31,000 |
| Synthesis Example 4 | A-4 | DA-2 2.9 g (9.6 mmol) | BPS 23.0 g (81.9 mmol) | | PAP 1.0 g (9.6 mmol) | s-ODPA 29.9 g (96.4 mmol) | | | | 32,000 |
| Synthesis Example 5 | A-5 | DA-2 2.9 g (9.6 mmol) | BAP 21.2 g (81.9 mmol) | | PAP 1.0 g (9.6 mmol) | s-ODPA 29.9 g (96.4 mmol) | | | | 33,000 |
| Synthesis Example 6 | A-6 | DA-2 2.9 g (9.6 mmol) | BAHF 31.2 g (81.9 mmol) | | PAP 1.0 g (9.6 mmol) | s-ODPA 29.9 g (96.4 mmol) | | | | 31,000 |
| Synthesis Example 7 | A-7 | DA-1 2.5 g (9.6 mmol) | 6FAP 30.0 g (81.9 mmol) | | PAP 1.0 g (9.6 mmol) | s-ODPA 23.9 g (77.1 mmol) | | DC-1 4.6 g (19.3 mmol) | | 33,000 |
| Synthesis Example 8 | A-8 | DA-2 2.9 g (9.6 mmol) | 6FAP 30.0 g (81.9 mmol) | | PAP 1.0 g (9.6 mmol) | s-ODPA 23.9 g (77.1 mmol) | | DC-1 4.6 g (19.3 mmol) | | 32,000 |
| Synthesis Example 9 | A-9 | DA-2 2.9 g (9.6 mmol) | 6FAP 26.5 g (72.3 mmol) | ODA 1.9 g (9.6 mmol) | PAP 1.0 g (9.6 mmol) | s-ODPA 23.9 g (77.1 mmol) | | DC-1 4.6 g (19.3 mmol) | | 32,000 |
| Synthesis Example 10 | A-10 | DA-2 2.9 g (9.6 mmol) | 6FAP 26.5 g (72.3 mmol) | APB 2.8 g (9.6 mmol) | PAP 1.0 g (9.6 mmol) | s-ODPA 23.9 g (77.1 mmol) | | DC-1 4.6 g (19.3 mmol) | | 33,000 |
| Synthesis Example 11 | A-11 | DA-2 2.9 g (9.6 mmol) | 6FAP 26.5 g (72.3 mmol) | D-400 3.8 g (9.6 mmol) | PAP 1.0 g (9.6 mmol) | s-ODPA 23.9 g (77.1 mmol) | | DC-1 4.6 g (19.3 mmol) | | 33,000 |
| Synthesis Example 12 | A-12 | DA-2 2.9 g (9.6 mmol) | 6FAP 26.5 g (72.3 mmol) | RT-1000 9.6 g (9.6 mmol) | PAP 1.0 g (9.6 mmol) | s-ODPA 23.9 g (77.1 mmol) | | DC-1 4.6 g (19.3 mmol) | | 34,000 |
| Synthesis Example 13 | A-13 | DA-2 2.9 g (9.6 mmol) | 6FAP 30.0 g (81.9 mmol) | | PAP 1.0 g (9.6 mmol) | | | DC-1 4.6 g (19.3 mmol) | | 38,000 |
| Synthesis Example 15 | A-15 | DA-2 2.9 g (9.6 mmol) | 6FAP 30.0 g (81.9 mmol) | | PAP 1.0 g (9.6 mmol) | | | DC-1 4.6 g (19.3 mmol) | X-1 44.0 g (77.1 mmol) | 35,000 |
| Comparative Synthesis Example 1 | A-16 | | 6FAP 30.0 g (81.9 mmol) | ODA 1.9 g (9.6 mmol) | PAP 1.0 g (9.6 mmol) | s-ODPA 29.9 g (96.4 mmol) | | | | 34,000 |
| Comparative Synthesis Example 2 | A-17 | | 6FAP 30.0 g (81.9 mmol) | ODA 1.9 g (9.6 mmol) | PAP 1.0 g (9.6 mmol) | s-ODPA 23.9 g (77.1 mmol) | | DC-1 4.6 g (19.3 mmol) | | 33,000 |

### II. Synthesis of Crosslinkable Polymer Compound (E)

As crosslinkable polymer compounds (polymer additives), the monomers were combined and subjected to a copolymerization reaction in a tetrahydrofuran solvent, and the product was crystallized with hexane and dried to obtain polymer compounds (Polymers E1 to E8) having a composition shown below. The compositions of the obtained polymer compounds were determined by 1H-NMR, and the molecular weights were determined by gel permeation chromatography.

### Synthesis Example 16: Polymer E1

### Molecular weight (Mw) = 11,600

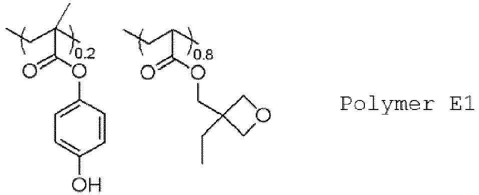

### Synthesis Example 17: Polymer E2

### Molecular weight (Mw) = 11,800

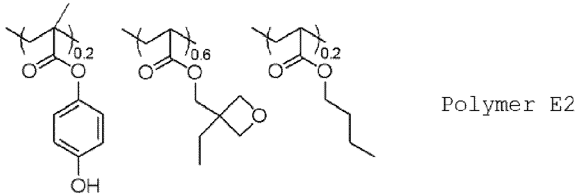

### Synthesis Example 18: Polymer E3

### Molecular weight (Mw) = 11,300

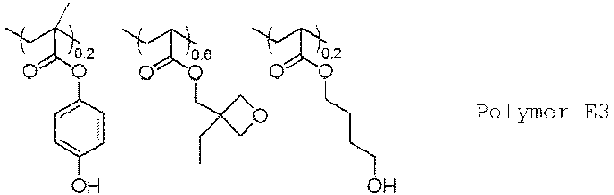

### Synthesis Example 19: Polymer E4

### Molecular weight (Mw) = 12,300

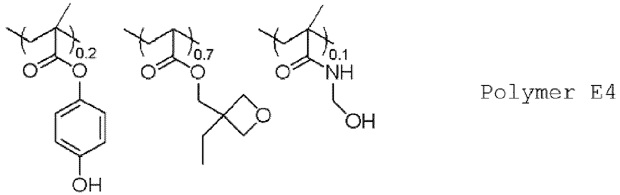

### Synthesis Example 20: Polymer E5

### Molecular weight (Mw) = 11,400

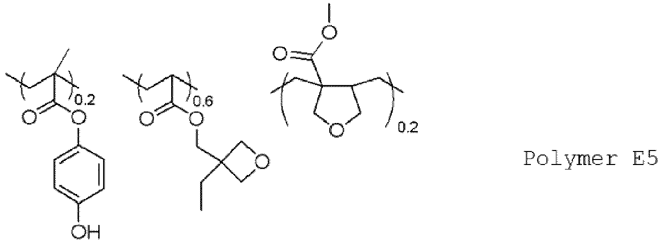

### Synthesis Example 21: Polymer E6

### Molecular weight (Mw) = 12,000

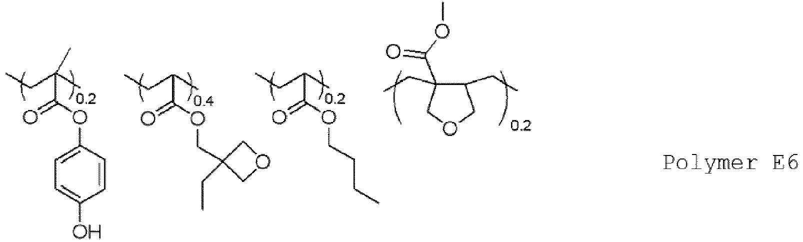

### Synthesis Example 22: Polymer E7

### Molecular weight (Mw) = 11,500

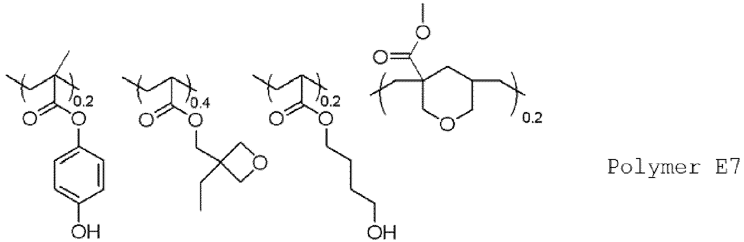

### Synthesis Example 23: Polymer E8

### Molecular weight (Mw) = 12,000

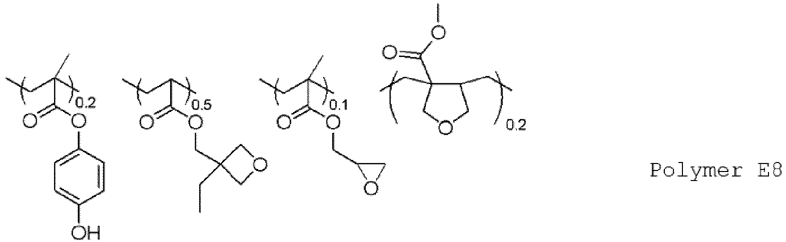

### III. Preparation of Photosensitive Resin Composition

The resins synthesized in Synthesis Examples 1 to 15 and Comparative Synthesis Examples 1 and 2 and the crosslinkable polymer compounds (E1) to (E8) synthesized in Synthesis Examples 16 to 23 were used as base resins, and resin compositions were prepared at 20 mass% in terms of resin with the composition and the blending amount described in Table 2. Thereafter, the mixture was stirred, mixed, dissolved, and then precisely filtered with a 0.5-um filter made of Teflon(R) to obtain photosensitive resin compositions. As "Solvent" in Table 2, PGMEA refers to propylene glycol monomethyl ether acetate and GBL refers to γ-butyrolactone.

**[Table 2]**

| | Base resin | | Acid generator | Crosslinking agent | | | compound | Thermal acid generator | oxidation inhibitor | Silane compound | Dissolution inhibitor | Surfactant | Solvent | |
|---|---|---|---|---|---|---|---|---|---|---|---|---|---|---|
| | Component (A) | Component (E) | Component (B) | Component (C) | | | Component (F) | Component (G) | Component (H) | Component (I) | Component (K) | Component (J) | Component (D) | |
| Photosensitive resin composition 1 | A1 100 parts by weight | | PAG-1 3 parts by weight | CL-1 5 parts by weight | CL-2 5 parts by weight | | F-1 1 part by weight | | | | | 1 0.02 parts by weight | PGMEA 320 parts by weight | GBL 80 parts by weight |
| Photosensitive resin composition 2 | A2 100 parts by weight | | PAG-1 3 parts by weight | CL-1 5 parts by weight | CL-2 5 parts by weight | | F-1 1 part by weight | | | | | J-1 0.02 parts by weight | PGMEA 320 parts by weight | GBL 80 parts by weight |
| Photosensitive resin composition 3 | A1 70 parts by weight | E1 30 parts by weight | PAG-1 3 parts by weight | CL-1 5 parts by weight | CL-2 5 parts by weight | | F-1 1 part by weight | | | | | 1 0.02 parts by weight | PGMEA 320 parts by weight | GBL 80 parts by weight |
| Photosensitive resin composition 4 | A2 70 parts by weight | C1 30 parts by weight | PAG-1 3 parts by weight | CL-1 5 parts by weight | CL-2 5 parts by weight | | F-1 1 part by weight | | | | | 1 0.02 parts by weight | PGMEA 320 parts by weight | GBL 80 parts by weight |
| Photosensitive resin composition 5 | A3 70 parts by weight | C1 30 parts by weight | PAG-1 3 parts by weight | CL-1 5 parts by weight | CL-2 5 parts by weight | | F-1 1 part by weight | | | | | 1 0.02 parts by weight | PGMEA 320 parts by weight | GBL 80 parts by weight |
| Photosensitive resin composition 6 | A4 70 parts by weight | E1 30 parts by weight | PAG-1 3 parts by weight | CL-1 5 parts by weight | CL-2 5 parts by weight | | F-1 1 part by weight | | | | | 1 0.02 parts by weight | PGMEA 320 parts by weight | GBL 80 parts by weight |
| Photosensitive resin composition 7 | A5 70 parts by weight | C1 30 parts by weight | PAG-1 3 parts by weight | CL-1 5 parts by weight | CL-2 5 parts by weight | | F-1 1 part by weight | | | | | 1 0.02 parts by weight | PGMEA 320 parts by weight | GBL 80 parts by weight |
| Photosensitive resin composition 8 | A6 70 parts by weight | E1 30 parts by weight | PAG-1 3 parts by weight | CL-1 5 parts by weight | CL-2 5 parts by weight | | F-1 1 part by weight | | | | | 1 0.02 parts bv weight | PGMEA 320 parts by weight | GBL 80 parts by weight |
| Photosensitive resin composition 9 | A7 70 parts by weight | C1 30 parts by weight | PAG-1 3 parts by weight | CL-1 5 parts by weight | CL-2 5 parts by weight | | F-1 1 part by weight | | | | | 1 0.02 parts by weight | PGMEA 320 parts by weight | GBL 80 parts by weight |
| Photosensitive resin composition 10 | A8 70 parts by weight | E1 30 parts by weight | PAG-1 3 parts by weight | CL-1 5 parts by weight | CL-2 5 parts by weight | | F-1 1 part by weight | | | | | 1 0.02 parts by weight | PGMEA 320 parts by weight | GBL 80 parts by weight |
| Photosensitive resin composition 11 | A9 70 parts by weight | C1 30 parts by weight | PAG-1 3 parts by weight | CL-1 5 parts by weight | CL-2 5 parts by weight | | F-1 1 part by weight | | | | | 1 0.02 parts by weight | PGMEA 320 parts by weight | GBL 80 parts by weight |
| Photosensitive resin composition 12 | A10 70 parts by weight | E1 30 parts by weight | PAG-1 3 parts by weight | CL-1 5 parts by weight | CL-2 5 parts by weight | | F-1 1 part by weight | | | | | 1 0.02 parts by weight | PGMEA 320 parts by weight | GBL 80 parts by weight |
| Photosensitive resin composition 13 | A11 70 parts by weight | C1 30 parts by weight | PAG-1 3 parts by weight | CL-1 5 parts by weight | CL-2 5 parts by weight | | F-1 1 part by weight | | | | | 1 0.02 parts by weight | PGMEA 320 parts by weight | GBL 80 parts by weight |
| Photosensitive resin composition 14 | A12 70 parts by weight | E1 30 parts by weight | PAG-1 3 parts by weight | CL-1 5 parts by weight | CL-2 5 parts by weight | | F-1 1 part by weight | | | | | 1 0.02 parts bv weight | PGMEA 320 parts by weight | GBL 80 parts by weight |
| Photosensitive resin composition 15 | A13 70 parts by weight | C1 30 parts by weight | PAG-1 3 parts by weight | CL-1 5 parts by weight | CL-2 5 parts by weight | | F-1 1 part by weight | | | | | 1 0.02 parts by weight | PGMEA 320 parts by weight | GBL 80 parts by weight |
| Photosensitive resin composition 16 | A15 70 parts by weight | E1 30 parts by weight | PAG1 3 parts by weight | CL-1 5 parts by weight | CL-2 5 parts by weight | | F-1 1 part by weight | | | | | 1 0.02 parts by weight | PGMEA 320 parts by weight | GBL 80 parts by weight |
| Photosensitive resin composition 17 | A8 70 parts by weight | E2 30 parts by weight | PAG-1 3 parts by weight | CL-1 5 parts by weight | CL-2 5 parts by weight | CL-3 10 parts by weight | F-1 1 part by weight | G-1 1 part by weight | | | | 1 0.02 parts by weight | PGMEA 320 parts by weight | GBL 80 parts by weight |
| Photosensitive resin composition 18 | A8 70 parts by weight | E3 30 parts by weight | PAG-1 3 parts by weight | CL-1 5 parts by weight | CL-2 5 parts by weight | CL-3 10 parts by weight | F-1 1 part by weight | G-1 1 part by weight | | | | 1 0.02 parts by weight | PGMEA 320 parts by weight | GBL 80 parts by weight |
| Photosensitive resin composition 19 | A8 70 parts by weight | E4 30 parts by weight | PAG-1 3 parts by weight | CL-1 5 parts by weight | CL-2 5 parts by weight | CL-3 10 parts by weight | F-1 1 part by weight | G-1 1 part by weight | | | | 1 0.02 parts by weight | PGMEA 320 parts by weight | GBL 80 parts by weight |
| Photosensitive resin composition 20 | A8 70 parts by weight | C5 30 parts by weight | PAG-1 3 parts by weight | CL-1 5 parts by weight | CL-2 5 parts by weight | CL-3 10 parts by weight | F-1 1 part by weight | G-2 1 part by weight | H-1 1 part by weight | I-1 0. 5parts by weight | K-1 5parts by weight | 1 0.02 parts by weight | PGMEA 320 parts by weight | GBL 80 parts by weight |
| Photosensitive resin composition 21 | A8 70 parts by weight | E6 30 parts by weight | PAG-1 3 parts by weight | CL-1 5 parts by weight | CL-2 5 parts by weight | CL-3 10 parts by weight | F-1 1 part by weight | G-1 1 part by weight | H-1 1 part by weight | I-1 0. 5parts by weight | K-1 5parts by weight | 1 0.02 parts by weight | PGMEA 320 parts by weight | GBL 80 parts by weight |
| Photosensitive resin composition 22 | A8 70 parts by weight | E7 30 parts by weight | PAG-1 3 parts by weight | CL-1 5 parts by weight | CL-2 5 parts by weight | CL-3 10 parts by weight | F-1 1 part by weight | G-1 1 part by weight | | | | 1 0.02 parts by weight | PGMEA 320 parts by weight | GBL 80 parts by weight |
| Photosensitive resin composition 23 | A8 70 parts by weight | E8 30 parts by weight | PAG-1 3 parts by weight | CL-1 5 parts by weight | CL-2 5 parts by weight | CL-3 10 parts by weight | F-1 1 part by weight | G-1 1 part by weight | | | | 1 0.02 parts by weight | PGMEA 320 parts by weight | GBL 80 parts by weight |
| Comparative photosensitive resin comoosition 1 | A16 70 parts by weight | C1 30 parts by weight | PAG-1 3 parts by weight | CL-1 5 parts by weight | CL-2 5 parts by weight | | F-1 1 part by weight | | | | | 1 0.02 parts by weight | PGMEA 320 parts by weight | GBL 80 parts by weight |
| Comparative photosensitive resin composition 2 | A17 70 parts by weight | C5 30 parts by weight | PAG-1 3 parts by weight | CL-1 5 parts by weight | CL-2 5 parts by weight | | F-1 1 part by weight | | | | | 1 0.02 parts by weight | PGMEA 320 parts by weight | GBL 80 parts by weight |
| Comparative photosensitive resin composition 3 | A16 100 parts by weight | | PAG-1 3 parts by weight | CL-1 5 parts by weight | CL-2 5 parts by weight | | F-1 1 part by weight | | | | | 1 0.02 parts by weight | PGMEA 320 parts by weight | GBL 80 parts by weight |

In Table 2, details of the photoacid generator (PAG-1) being an oxime sulfonate compound, the crosslinking agents (CL-1), (CL-2), and (CL-3), the basic compound (F-1), the thermal acid generators (G-1) and (G-2), the oxidation inhibitor (H-1), the silane compound (I-1), the dissolution inhibitor (K-1), and the surfactant (J-1) were as follows. The term "parts by weight" has the same mean as "parts by mass".

### Photoacid generator (PAG-1)

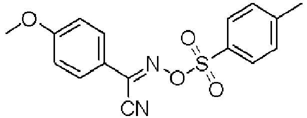

### Crosslinking agent (CL-1)

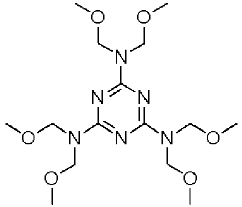

### Crosslinking agent (CL-2)

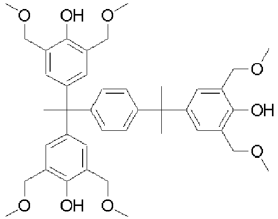

### Crosslinking agent (CL-3)

### Epoxy resin: EP4000L, manufactured by ADEKA CORPORATION

### Basic compound (F-1)

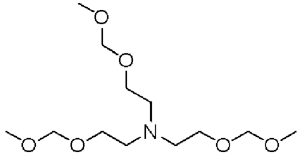

### Thermal acid generator (G-1)

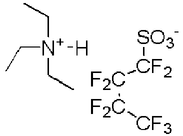

### Thermal acid generator (G-2)

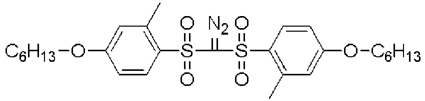

### Oxidation inhibitor (H-1)

### Hindered-phenol-type oxidation inhibitor: SUMILIZER GA80, manufactured by SUMITOMO CHEMICAL COMPANY, LIMITED

### Silane compound (I-1)

Aminosilane coupling agent: KBM-573, manufactured by Shin-Etsu Chemical Co., Ltd.

### Dissolution inhibitor (K-1)

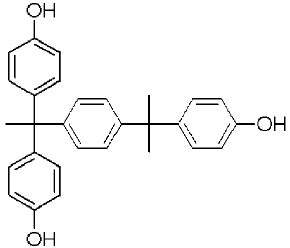

### Surfactant (J-1)

Fluorine-based surfactant: PF-6320, manufactured by OMNOVA Inc.

### IV. Patterning

The photosensitive resin compositions 1 to 23 and the comparative photosensitive resin compositions 1 to 3 were each applied on a hexamethyldisilazane-treated silicon substrate by dispensing 5 mL of the composition and then rotating the substate, namely a spin-coating method, so that a film thickness was 2 um after post-curing heating performed after patterning. Specifically, reduction in the film thickness after the post-curing step had been investigated in advance, and a number of rotation during applying was adjusted so that the finishing film thickness was 2 um after the post-curing.

Then, prebaking was performed on a hotplate at 100°C for 2 minutes. Thereafter, exposure to i-line was performed by using an i-line stepper AP300E, manufactured by Veeco Instruments Inc. After the exposure, post-exposure baking (PEB) was performed at 110°C for 2 minutes, and then cooling was performed.

For patterning, a mask for a negative-type pattern was used. The mask had a pattern that was able to form a line-and-space pattern with 2 um in 1:1 length and breadth (hereinafter, referred to as "LS pattern") and that was able to form the LS pattern with each 1 um from 10 um to 2 µm.

Thereafter, paddle development was performed with a 2.38% tetramethylammonium hydroxide (TMAH) aqueous solution as a developer for 1 minute until the applied film in the unexposed portion was dissolved, and then rinsing was performed with ultrapure water.

Then, post-curing of the patterned substrate was performed by using an oven at 180°C for 2 hours while nitrogen purge.

Then, each of the substrates was cut out so that a shape of the obtained LS pattern was able to be observed, and the LS pattern shape was observed by using a scanning electron microscope (SEM). The shape of the 2-um LS pattern after the post-curing was evaluated. Table 3 shows sensitivity and times of development with which the 2-um pattern was able to be formed, together with the above results.

The shape of the LS pattern was evaluated on the following criteria, and the evaluation results are shown in Table 3. A cross section of the minimum LS pattern was observed for comparison between widths of the highest portion and the lowest portion of the cross section of the pattern. A pattern with the difference of 0 um or more and 0.2 um or less was evaluated as "A", a pattern with the difference of more than 0.2 um and 0.5 um or less was evaluated as "B", a pattern with the difference of more than 0.5 um and 1.0 um or less was evaluated as "C", and a pattern with the difference of more than 1.0 um was evaluated as "D".

### V. Breakage Elongation and Tensile Strength

The photosensitive resin compositions 1 to 23 and the comparative photosensitive resin compositions 1 to 3 were each applied by spin-coating on an aluminum substrate so that a finishing film thickness after curing was 10 um. Then, prebaking was performed on a hotplate at 100°C for 4 minutes to obtain a photosensitive resin film.

Thereafter, the entire substrate was subjected to contact exposure by using a contact aligner UL-7000, manufactured by Neutronix Quintel Corporation, with a broadband wavelength at an exposure dose of 500 mJ/cm². After the exposure, a PEB treatment was performed at 110°C for 4 minutes, and then cooling was performed. Thereafter, curing was performed by using an oven at 190°C for 2 hours while nitrogen purge to obtain a photosensitive resin cured film. Then, the wafer with the cured film was cut to a stripe shape with 10 mm in width and 60 mm in length, and immersed in 20 mass% hydrochloric acid to remove the cured film from the substrate. The obtained cured film was subjected to measurements of breakage elongation and tensile strength by using autograph AGX-1KN, manufactured by SHIMADZU CORPORATION. The measurement was performed ten times on one sample, and an average value thereof is shown in Table 3.

**[Table 3]**

| | | Pattern shape | Development times (Puddle times) | Sensitivity (mJ/cm²) | Breakage elongation (%) | Tensile strength (MPa) |
|---|---|---|---|---|---|---|
| Example 1 | Photosensitive resin composition 1 | C | 60 sec × 3 | 980 | 40 | 105 |
| Example 2 | Photosensitive resin composition 2 | C | 60 sec × 3 | 980 | 45 | 110 |
| Example 3 | Photosensitive resin composition 3 | A | 60 sec × 3 | 900 | 45 | 114 |
| Example 4 | Photosensitive resin composition 4 | A | 60 sec × 3 | 880 | 55 | 108 |
| Example 5 | Photosensitive resin composition 5 | B | 60 sec × 3 | 900 | 50 | 118 |
| Example 6 | Photosensitive resin composition 6 | A | 60 sec × 2 | 920 | 52 | 116 |
| Example 7 | Photosensitive resin composition 7 | A | 60 sec × 3 | 860 | 54 | 112 |
| Example 8 | Photosensitive resin composition 8 | B | 60 sec × 4 | 900 | 48 | 115 |
| Example 9 | Photosensitive resin composition 9 | A | 60 sec × 3 | 800 | 50 | 115 |
| Example 10 | Photosensitive resin composition 10 | A | 60 sec × 3 | 780 | 60 | 118 |
| Example 11 | Photosensitive resin composition 11 | A | 60 sec × 4 | 800 | 55 | 110 |
| Example 12 | Photosensitive resin composition 12 | A | 60 sec × 4 | 780 | 58 | 118 |
| Example 13 | Photosensitive resin composition 13 | B | 60 sec × 3 | 820 | 50 | 110 |
| Example 14 | Photosensitive resin composition 14 | B | 60 sec × 3 | 840 | 48 | 108 |
| Example 15 | Photosensitive resin composition 15 | A | 60 sec × 1 | 720 | 35 | 100 |
| Example 16 | Photosensitive resin composition 16 | A | 60 sec × 1 | 760 | 40 | 106 |
| Example 17 | Photosensitive resin composition 17 | A | 60 sec × 3 | 800 | 60 | 116 |
| Example 18 | Photosensitive resin composition 18 | A | 60 sec × 2 | 760 | 62 | 120 |
| Example 19 | Photosensitive resin composition 19 | A | 60 sec × 3 | 800 | 58 | 114 |
| Example 20 | Photosensitive resin composition 20 | A | 60 sec × 3 | 820 | 62 | 118 |
| Example 21 | Photosensitive resin composition 21 | A | 60 sec × 3 | 840 | 64 | 120 |
| Example 22 | Photosensitive resin composition 22 | A | 60 sec × 2 | 740 | 66 | 124 |
| Example 23 | Photosensitive resin composition 23 | A | 60 sec × 3 | 840 | 60 | 118 |
| Comparative Example 1 | Comparative photosensitive resin composition 1 | B | 60 sec × 3 | 900 | 35 | 100 |
| Comparative Example 2 | Comparative photosensitive resin composition 2 | A | 60 sec × 2 | 780 | 40 | 112 |
| Comparative Example 3 | Comparative photosensitive resin composition 3 | C | 60 sec × 3 | 980 | 30 | 100 |

### VI. Adhesive Force

In the same procedure as the above patterning, the photosensitive resin compositions 1 to 23 and the comparative photosensitive resin compositions 1 and 2 were each used for the i-line exposure of 1-cm square pattern so that a finishing film thickness after curing was 5 um on a SiN substrate to obtain a lattice pattern on an entirety of the substrate. The exposure dose was set to an exposure dose at which the minimum pattern determined in the above LS patterning evaluation was able to be formed. The prebaking was performed at 100°C for 4 minutes, and PEB was performed at 110°C for 4 minutes. As the development, paddle development was performed for 1 minute prescribed times until the applied film in the unexposed portion was dissolved.

Thereafter, the patterned substrate was subjected to post-curing at 190°C for 2 hours while nitrogen purge. Then, the cured substrate was segmented along the 1-cm square pattern to obtain a chip with the cured film. On the obtained chip, an aluminum pin with an epoxy resin was stood, heating was performed at 150°C for 1 hour for adhering the aluminum pin to the chip to produce a measurement sample. After cooling, the adhesive force was measured by using ROMULUS, manufactured by Quad Group Inc., by a method illustrated in FIG. 1 (hereinafter, referred to as "Stud-pull method"). As the measurement condition, a measurement speed was 20 N/sec. FIG. 1 is an explanatory view illustrating the method for measuring the adhesive force. In FIG. 1, "1" represents the SiN substrate (substrate), "2" represents the cured film, "3" represents the aluminum pin with the adhesive, "4" represents a supporting table, "5" represents a grip, and "6" represents a tensile direction. The obtained value was an average value of ten-point measurement, and a higher value indicates higher adhesive force of the cured film to the SiN substrate. A peeling interface of the cured film / the adhesive indicates higher adhesive force of a peeling interface of the substrate / the cured film. The obtained value and the peeling interface were compared to evaluate the adhesiveness.

Further, as a high-temperature high-humidity test (PCT test), the obtained chip was left to stand in a pressure cooker under saturated 2 atm at 120°C and 100% RH for 168 hours. Thereafter, adhesive force after the test was evaluated by the Stud-pull method and shown in Table 4 as the adhesive force to the substate together with the results before the test.

**[Table 4]**

| | | Adhesive force (MPa) | | Peeling interface | |
|---|---|---|---|---|---|
| | | Before PCT test | After PCT test | Before PCT test | After PCT test |
| Example 1 | Photosensitive resin composition 1 | 53 | 55 | Cured film / Adhesive | Cured film / Adhesive |
| Example 2 | Photosensitive resin composition 2 | 54 | 55 | Cured film / Adhesive | Cured film / Adhesive |
| Example 3 | Photosensitive resin composition 3 | 56 | 55 | Cured film / Adhesive | Cured film / Adhesive |
| Example 4 | Photosensitive resin composition 4 | 58 | 58 | Cured film / Adhesive | Cured film / Adhesive |
| Example 5 | Photosensitive resin composition 5 | 54 | 54 | Cured film / Adhesive | Cured film / Adhesive |
| Example 6 | Photosensitive resin composition 6 | 52 | 53 | Cured film / Adhesive | Cured film / Adhesive |
| Example 7 | Photosensitive resin composition 7 | 57 | 56 | Cured film / Adhesive | Cured film / Adhesive |
| Example 8 | Photosensitive resin composition 8 | 56 | 55 | Cured film / Adhesive | Cured film / Adhesive |
| Example 9 | Photosensitive resin composition 9 | 58 | 57 | Cured film / Adhesive | Cured film / Adhesive |
| Example 10 | Photosensitive resin composition 10 | 62 | 60 | Cured film / Adhesive | Cured film / Adhesive |
| Example 11 | Photosensitive resin composition 11 | 58 | 56 | Cured film / Adhesive | Cured film / Adhesive |
| Example 12 | Photosensitive resin composition 12 | 56 | 54 | Cured film / Adhesive | Cured film / Adhesive |
| Example 13 | Photosensitive resin composition 13 | 50 | 50 | Cured film / Adhesive | Cured film / Adhesive |
| Example 14 | Photosensitive resin composition 14 | 54 | 53 | Cured film / Adhesive | Cured film / Adhesive |
| Example 15 | Photosensitive resin composition 15 | 53 | 54 | Cured film / Adhesive | Cured film / Adhesive |
| Example 16 | Photosensitive resin composition 16 | 58 | 58 | Cured film / Adhesive | Cured film / Adhesive |
| Example 17 | Photosensitive resin composition 17 | 60 | 60 | Cured film / Adhesive | Cured film / Adhesive |
| Example 18 | Photosensitive resin composition 18 | 64 | 62 | Cured film / Adhesive | Cured film / Adhesive |
| Example 19 | Photosensitive resin composition 19 | 62 | 60 | Cured film / Adhesive | Cured film / Adhesive |
| Example 20 | Photosensitive resin composition 20 | 60 | 60 | Cured film / Adhesive | Cured film / Adhesive |
| Example 21 | Photosensitive resin composition 21 | 62 | 61 | Cured film / Adhesive | Cured film / Adhesive |
| Example 22 | Photosensitive resin composition 22 | 64 | 64 | Cured film / Adhesive | Cured film / Adhesive |
| Example 23 | Photosensitive resin composition 23 | 63 | 62 | Cured film / Adhesive | Cured film / Adhesive |
| Comparative Example 1 | Comparative photosensitive resin composition 1 | 54 | 52 | Cured film / Adhesive | Cured film / Adhesive |
| Comparative Example 2 | Comparative photosensitive resin composition 2 | 56 | 55 | Cured film / Adhesive | Cured film / Adhesive |

As shown in Tables 3 and 4, it was found that Examples 1 to 23, which used the negative-type photosensitive composition of the present invention, yielded the cured film having good mechanical properties and high-temperature high-pressure resistance even by curing at a low temperature of 200°C or lower.

In contrast, Comparative Examples 1 to 3, which used the polymer containing no structural unit represented by the general formula (1) and/or (2) for the composition, resulted in poor breakage elongation by curing a low temperature of 200°C or lower.

As the above results, obtained were results that the compositions of Examples 1 to 23 yielded good rectangularity, exhibited excellent resolution of resolving the 2-um fine pattern, and exhibited properties sufficient as a photosensitive material, and its cured film had substrate adhesiveness and good high-temperature high-humidity resistance to be useful as the protective film for a circuit and an electronic component.

The present description includes the following embodiments.
[1]: A negative-type photosensitive resin composition, comprising:
   a polymer (A) having a structural unit represented by the following general formula (1) and/or (2) and a structural unit represented by the following general formula (3) and/or (4), 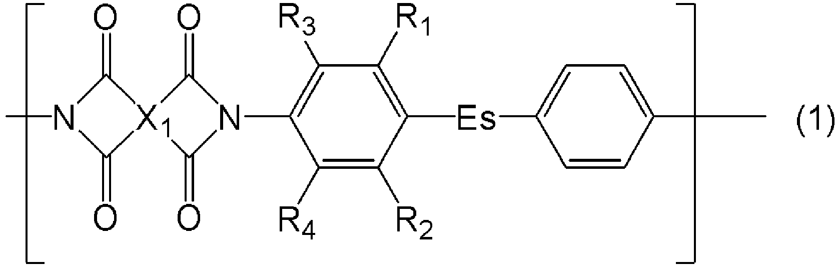
   wherein X₁ represents a tetravalent organic group; R₁ to R₄ represent a monovalent organic group having 1 to 15 carbon atoms and optionally having a heteroatom, or a hydrogen atom, R₁ to R₄ may be different from or same as each other, and at least one of R₁ to R₄ represents the monovalent organic group having 1 to 15 carbon atoms and optionally having a heteroatom; and Es represents a -O-C(=O)- bond or a -C(=O)-O- bond, 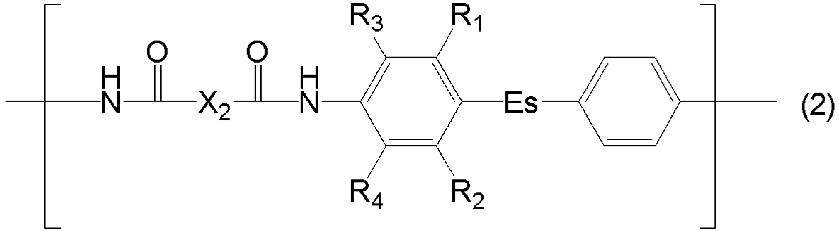
   wherein X₂ represents a divalent organic group; and R₁ to R₄ and Es are same as above, 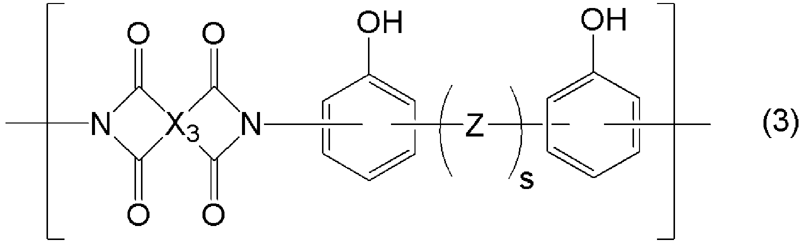
   wherein X₃ represents a tetravalent organic group same as or different from the X₁; "s" represents 0 or 1; Z represents a divalent bonding group; and when s=0, two aromatic rings in the formula are directly bonded via no bonding group, 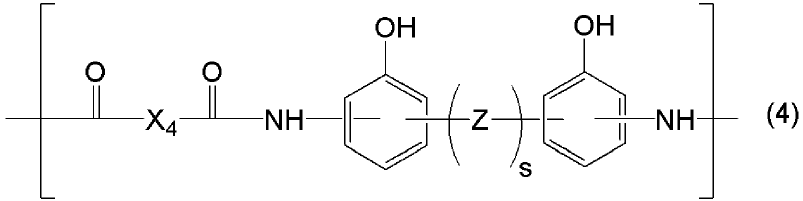
   wherein X₄ represents a divalent organic group same as or different from the X₂; and "s" and Z are same as above;
   a photoacid generator (B);
   a crosslinking agent (C); and
   a solvent (D).
[2]: The negative-type photosensitive resin composition of the above [1], wherein any one of the R₁ and R₂ in the general formulae (1) and (2) represents the monovalent organic group having 1 to 15 carbon atoms and optionally having a heteroatom, the other represents a hydrogen atom, and the R₃ and R₄ represent hydrogen atoms.
[3]: The negative-type photosensitive resin composition of the above [2], wherein any one of the R₁ and R₂ in the general formulae (1) and (2) represents an aromatic group having 1 to 10 carbon atoms, and the other represents a hydrogen atom.
[4]: The negative-type photosensitive resin composition any one of the above [1] to [3], wherein the Z in the general formulae (3) and (4) represents at least one bonding group selected from any groups represented by the following formulae (5), (6), (7), and (8), 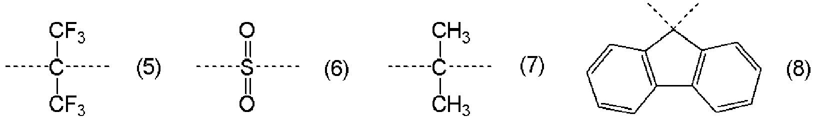 wherein a dotted line represents an attachment point.
[5]: The negative-type photosensitive resin composition any one of the above [1] to [4], wherein the component (C) is one or two or more crosslinking agents selected from: an amino condensate modified with formaldehyde or formaldehyde-alcohol; a phenol compound having two or more methylol groups or alkoxymethylol groups in average in one molecule; a compound in which a hydrogen atom in a hydroxy group of a polyvalent phenol is substituted with a glycidyl group; a compound in which a hydrogen atom in a hydroxy group of a polyvalent phenol or of a polyhydric alcohol is substituted with a substituent represented by the following formula (C-1); and a compound having two or more nitrogen atoms having a glycidyl group represented by the following formula (C-2), 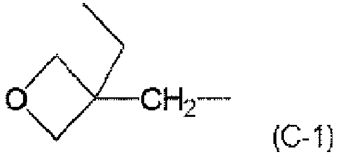 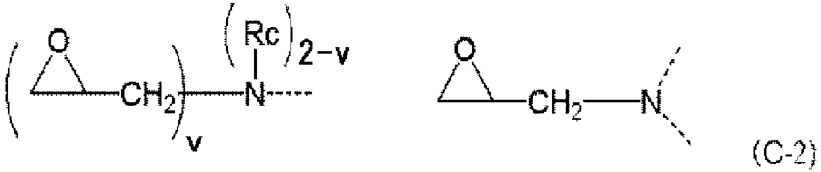 wherein a dotted line represents an attachment point; Rc represents a linear, branched, or cyclic alkyl group having 1 to 6 carbon atoms; and "v" represents 1 or 2.
[6]: The negative-type photosensitive resin composition any one of the above [1] to [5], further comprising a crosslinkable polymer (E) having a structural unit represented by the following general formula (9) and a group that is crosslinkable with the component (A), 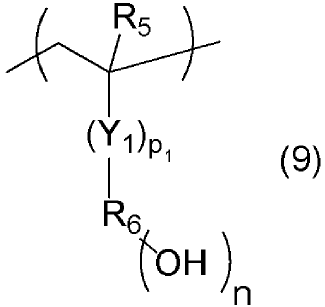 wherein R₅ represents a hydrogen atom or a methyl group; R₆ represents an (n+1)-valent linear, branched, or cyclic aliphatic saturated hydrocarbon group having 1 to 15 carbon atoms, an aromatic hydrocarbon group having 6 to 15 carbon atoms, a benzyl group, or a naphthalenemethyl group, and a carbon atom in the aliphatic saturated hydrocarbon group is optionally substituted with an oxygen atom; "n" represents an integer of 1 to 5; Y₁ each represents -C(=O)-O-, -C(=O)-NH-, or -C(=O)-N(R₇OH)-; R₇ represents a divalent linear, branched, or cyclic aliphatic saturated hydrocarbon group having 1 to 12 carbon atoms or an aromatic hydrocarbon group having 6 to 12 carbon atoms, and a carbon atom in the aliphatic saturated hydrocarbon group is optionally substituted with an oxygen atom; and p₁ represents 0 or 1.
[7]: The negative-type photosensitive resin composition of the above [6], wherein the component (E) is a crosslinkable polymer compound having: a structural unit represented by the following general formula (10); and a structural unit represented by the following general formula (11) having a group that is crosslinkable with the component (A), 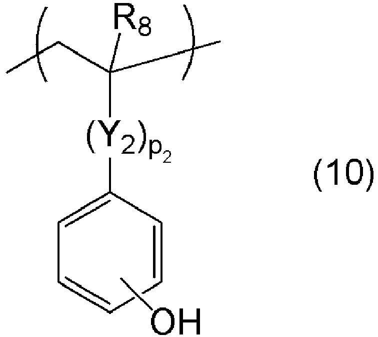 wherein R₈ represents a hydrogen atom or a methyl group; Y₂ each represents -C(=O)-O-, -C(=O)-NH-, or - C(=O)-N(R₉OH)-; R₉ represents a divalent linear, branched, or cyclic aliphatic saturated hydrocarbon group having 1 to 12 carbon atoms or an aromatic hydrocarbon group having 6 to 12 carbon atoms, and a carbon atoms in the aliphatic saturated hydrocarbon group is optionally substituted with an oxygen atom; and p₂ represents 0 or 1, 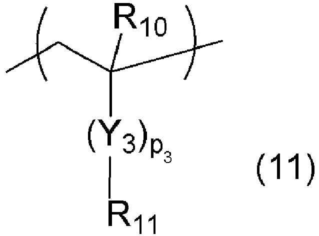 wherein R₁₀ represents a hydrogen atom or a methyl group; R₁₁ represents a group having an oxazoline group, an isocyanate group, a block isocyanate group, an oxetanyl group, or an epoxy group; Y₃ represents -C(=O)-O-, a phenylene group, or a naphthylene group; and p₃ represents 0 or 1.
[8]: The negative-type photosensitive resin composition of the above [7], wherein the component (E) is a crosslinkable polymer compound having structural units represented by the following general formula (10) and the following general formula (12), 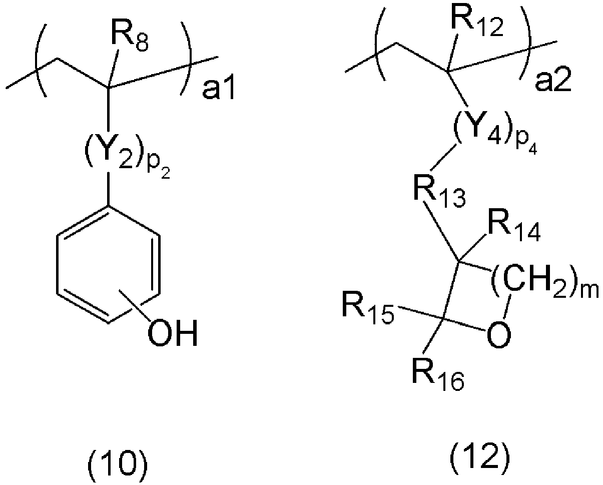 wherein R₈, Y₂, and p₂ are same as above; R₁₂ represents a hydrogen atom or a methyl group; Y₄ each represents -C(=O)-O-, a phenylene group, or a naphthylene group; R₁₃ represents a linear, branched, or cyclic alkylene group having 1 to 15 carbon atoms and optionally having a hydroxy group, an ester group, an ether group, or an aromatic hydrocarbon; R₁₄ represents a hydrogen atom or a linear, branched, or cyclic alkyl group having 1 to 6 carbon atoms, and R₁₄ is optionally bonded to R₁₃ to form a ring; R₁₅ represents a hydrogen atom or a linear, branched, or cyclic alkyl group having 1 to 6 carbon atoms; R₁₆ represents a hydrogen atom or a linear alkyl group having 1 to 6 carbon atoms, and R₁₆ is optionally bonded to R₁₃ to form a ring; "m" represents 0 or 1; p₄ represents 0 or 1; and 0<a1<1.0, 0<a2<1.0, and 0<a1+a2≤1.0.
[9]: The negative-type photosensitive resin composition any one of the above [6] to [8], wherein the component (E) is a crosslinkable polymer compound further having a structural unit represented by the following general formula (13), 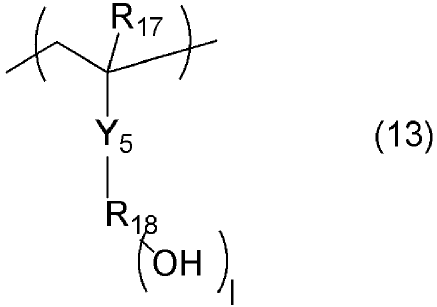 wherein R₁₇ represents a hydrogen atom or a methyl group; R₁₈ represents a single bond or a (l+1)-valent linear, branched, or cyclic aliphatic saturated hydrocarbon group having 1 to 13 carbon atoms, and a carbon atom in the aliphatic saturated hydrocarbon group is optionally substituted with an oxygen atom; Y₅ each represents -C(=O)-O-, -C(=O)-O-R₁₉-, -C(=O)-NH-, -C(=O)-N(R₁₉OH)-, a phenylene group, or a naphthylene group; R₁₉ represents a divalent linear, branched, or cyclic aliphatic saturated hydrocarbon group having 1 to 12 carbon atoms or an aromatic hydrocarbon group having 6 to 12 carbon atoms, and a carbon atom in the aliphatic saturated hydrocarbon group is optionally substituted with an oxygen atom; and "1" represents 0 or 1.
[10]: The negative-type photosensitive resin composition any one of the above [6] to [9], wherein the component (E) is a crosslinkable polymer compound further having at least one or more structural units selected from cyclization-polymerized structural units represented by the following general formula (14), the following general formula (15), the following general formula (16), and the following general formula (17), 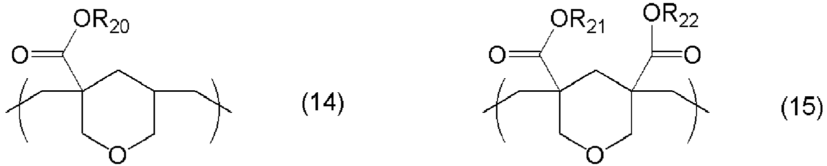 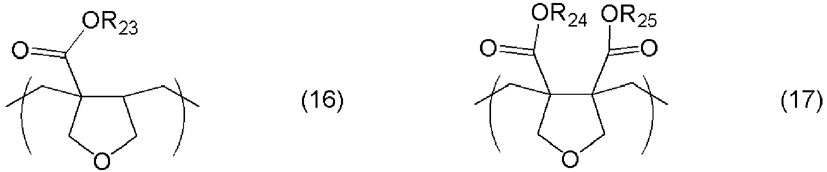 wherein R₂₀, R₂₁, R₂₂, R₂₃, R₂₄, and R₂₅ each independently represent a hydrogen atom or a linear or branched alkyl group having 1 to 5 carbon atoms.
[11]: The negative-type photosensitive resin composition any one of the above [1] to [10], further comprising one or more selected from a basic compound (F), a thermal acid generator (G), an oxidation inhibitor (H), and a silane compound (I).
[12]: A patterning method, comprising steps of:
   (1) applying the negative-type photosensitive resin composition any one of the above [1] to [11] on a substrate to form a photosensitive film;
   (2) after a subsequent heating treatment, subjecting the photosensitive film to light exposure through a photomask by using high-energy ray having a wavelength of 190 to 500 nm or electron beam; and
   (3) after the light exposure, subjecting the substrate to a heating treatment, and performing development by using a developer of an alkaline aqueous solution.
[13]: A method for forming a cured film, comprising a step of heating and post-curing the patterned photosensitive film obtained by the patterning method of the above [12] at a temperature of 100 to 300°C.
[14]: An interlayer insulative film, being a cured film formed by curing the negative-type photosensitive resin composition any one of the above [1] to [11].
[15]: A surface-protective film, being a cured film formed by curing the negative-type photosensitive resin composition any one of the above [1] to [11].
[16]: An electronic component, comprising the interlayer insulative film of the above [14], or comprising the surface-protective film of the above [15].

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention. The present invention also refers to the following numbered embodiments, wherein the term "claim" means "embodiment":
1. A negative-type photosensitive resin composition, comprising:
   a polymer (A) having a structural unit represented by the following general formula (1) and/or (2) and a structural unit represented by the following general formula (3) and/or (4), 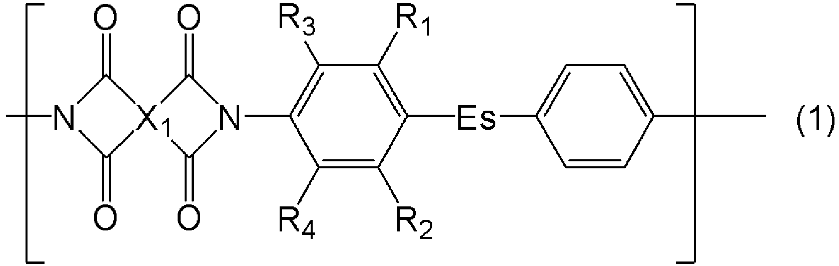
   wherein X₁ represents a tetravalent organic group; R₁ to R₄ represent a monovalent organic group having 1 to 15 carbon atoms and optionally having a heteroatom, or a hydrogen atom, R₁ to R₄ may be different from or same as each other, and at least one of R₁ to R₄ represents the monovalent organic group having 1 to 15 carbon atoms and optionally having a heteroatom; and Es represents a -O-C(=O)- bond or a -C(=O)-O- bond, 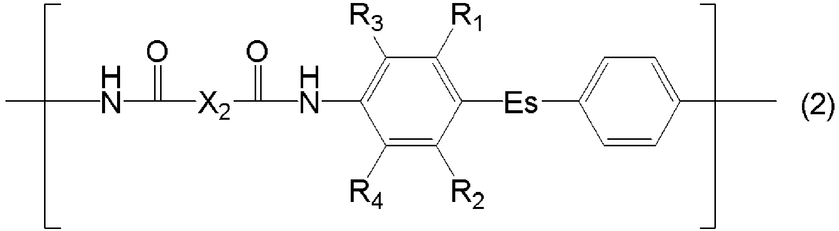
   wherein X₂ represents a divalent organic group; and R₁ to R₄ and Es are same as above, 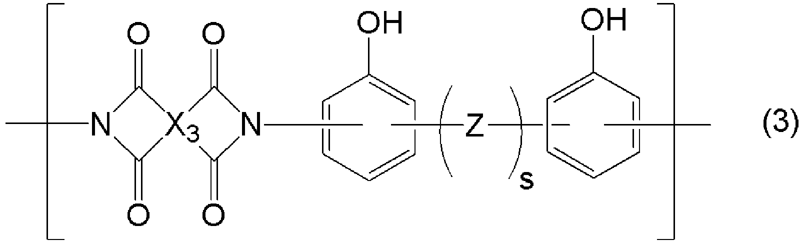
   wherein X₃ represents a tetravalent organic group same as or different from the X₁; "s" represents 0 or 1; Z represents a divalent bonding group; and when s=0, two aromatic rings in the formula are directly bonded via no bonding group, 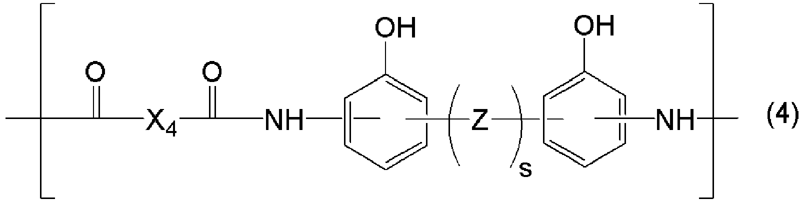
   wherein X₄ represents a divalent organic group same as or different from the X₂; and "s" and Z are same as above;
   a photoacid generator (B);
   a crosslinking agent (C); and
   a solvent (D).
2. The negative-type photosensitive resin composition according to claim 1, wherein any one of the R₁ and R₂ in the general formulae (1) and (2) represents the monovalent organic group having 1 to 15 carbon atoms and optionally having a heteroatom, the other represents a hydrogen atom, and the R₃ and R₄ represent hydrogen atoms.
3. The negative-type photosensitive resin composition according to claim 2, wherein any one of the R₁ and R₂ in the general formulae (1) and (2) represents an aromatic group having 1 to 10 carbon atoms, and the other represents a hydrogen atom.
4. The negative-type photosensitive resin composition according to any one of claims 1 to 3, wherein the Z in the general formulae (3) and (4) represents at least one bonding group selected from any groups represented by the following formulae (5), (6), (7), and (8), 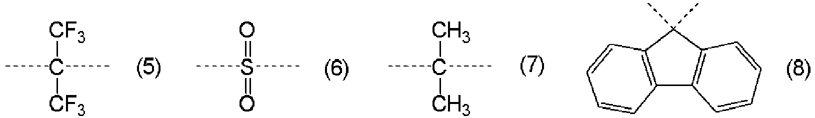 wherein a dotted line represents an attachment point.
5. The negative-type photosensitive resin composition according to any one of claims 1 to 4, wherein the component (C) is one or two or more crosslinking agents selected from: an amino condensate modified with formaldehyde or formaldehyde-alcohol; a phenol compound having two or more methylol groups or alkoxymethylol groups in average in one molecule; a compound in which a hydrogen atom in a hydroxy group of a polyvalent phenol is substituted with a glycidyl group; a compound in which a hydrogen atom in a hydroxy group of a polyvalent phenol or of a polyhydric alcohol is substituted with a substituent represented by the following formula (C-1); and a compound having two or more nitrogen atoms having a glycidyl group represented by the following formula (C-2) , 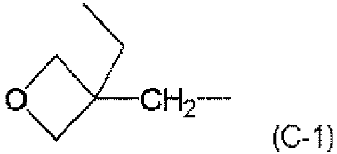 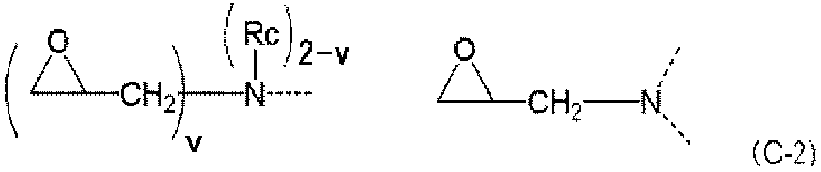 wherein a dotted line represents an attachment point; Rc represents a linear, branched, or cyclic alkyl group having 1 to 6 carbon atoms; and "v" represents 1 or 2.
6. The negative-type photosensitive resin composition according to any one of claims 1 to 5, further comprising a crosslinkable polymer (E) having a structural unit represented by the following general formula (9) and a group that is crosslinkable with the component (A), 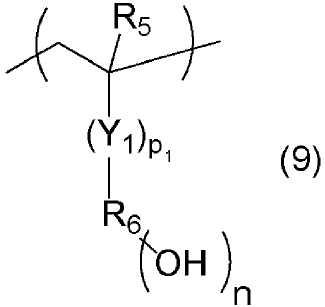 wherein R₅ represents a hydrogen atom or a methyl group; R₆ represents an (n+1)-valent linear, branched, or cyclic aliphatic saturated hydrocarbon group having 1 to 15 carbon atoms, an aromatic hydrocarbon group having 6 to 15 carbon atoms, a benzyl group, or a naphthalenemethyl group, and a carbon atom in the aliphatic saturated hydrocarbon group is optionally substituted with an oxygen atom; "n" represents an integer of 1 to 5; Y₁ each represents -C(=O)-O-, -C(=O)-NH-, or -C(=O)-N(R₇OH)-; R₇ represents a divalent linear, branched, or cyclic aliphatic saturated hydrocarbon group having 1 to 12 carbon atoms or an aromatic hydrocarbon group having 6 to 12 carbon atoms, and a carbon atom in the aliphatic saturated hydrocarbon group is optionally substituted with an oxygen atom; and p₁ represents 0 or 1.
7. The negative-type photosensitive resin composition according to claim 6, wherein the component (E) is a crosslinkable polymer compound having: a structural unit represented by the following general formula (10); and a structural unit represented by the following general formula (11) having a group that is crosslinkable with the component (A), 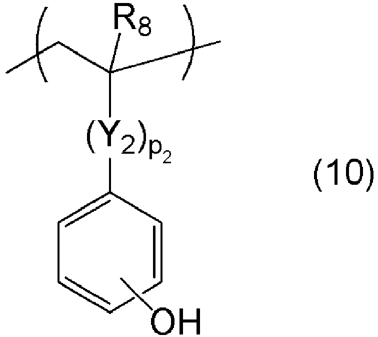 wherein R₈ represents a hydrogen atom or a methyl group; Y₂ each represents -C(=O)-O-, -C(=O)-NH-, or - C(=O)-N(R₉OH)-; R₉ represents a divalent linear, branched, or cyclic aliphatic saturated hydrocarbon group having 1 to 12 carbon atoms or an aromatic hydrocarbon group having 6 to 12 carbon atoms, and a carbon atoms in the aliphatic saturated hydrocarbon group is optionally substituted with an oxygen atom; and p₂ represents 0 or 1, 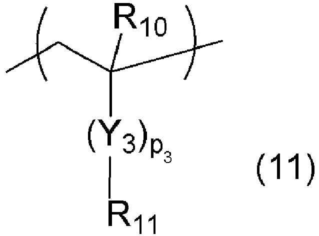 wherein R₁₀ represents a hydrogen atom or a methyl group; R₁₁ represents a group having an oxazoline group, an isocyanate group, a block isocyanate group, an oxetanyl group, or an epoxy group; Y₃ represents -C(=O)-O-, a phenylene group, or a naphthylene group; and p₃ represents 0 or 1.
8. The negative-type photosensitive resin composition according to claim 7, wherein the component (E) is a crosslinkable polymer compound having structural units represented by the following general formula (10) and the following general formula (12), 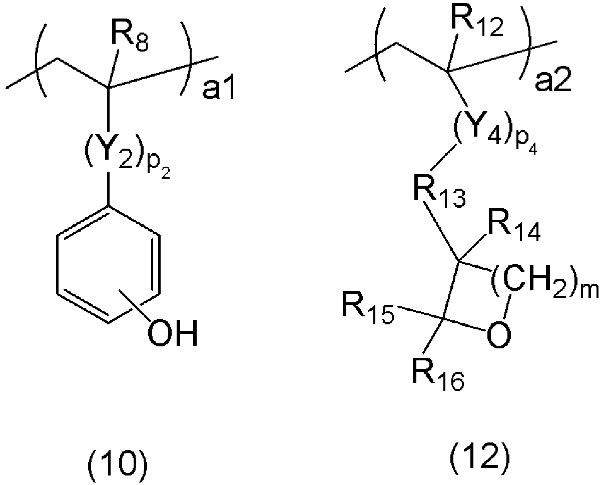 wherein R₈, Y₂, and p₂ are same as above; R₁₂ represents a hydrogen atom or a methyl group; Y₄ each represents -C(=O)-O-, a phenylene group, or a naphthylene group; R₁₃ represents a linear, branched, or cyclic alkylene group having 1 to 15 carbon atoms and optionally having a hydroxy group, an ester group, an ether group, or an aromatic hydrocarbon; R₁₄ represents a hydrogen atom or a linear, branched, or cyclic alkyl group having 1 to 6 carbon atoms, and R₁₄ is optionally bonded to R₁₃ to form a ring; R₁₅ represents a hydrogen atom or a linear, branched, or cyclic alkyl group having 1 to 6 carbon atoms; R₁₆ represents a hydrogen atom or a linear alkyl group having 1 to 6 carbon atoms, and R₁₆ is optionally bonded to R₁₃ to form a ring; "m" represents 0 or 1; p₄ represents 0 or 1; and 0<a1<1.0, 0<a2<1.0, and 0<a1+a2≤1.0.
9. The negative-type photosensitive resin composition according to any one of claims 6 to 8, wherein the component (E) is a crosslinkable polymer compound further having a structural unit represented by the following general formula (13), 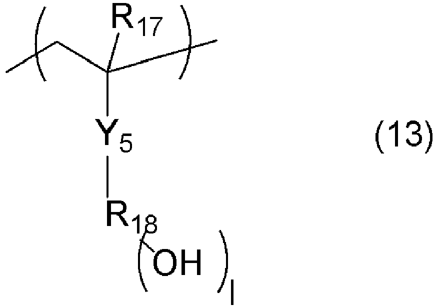 wherein R₁₇ represents a hydrogen atom or a methyl group; R₁₈ represents a single bond or a (1+1)-valent linear, branched, or cyclic aliphatic saturated hydrocarbon group having 1 to 13 carbon atoms, and a carbon atom in the aliphatic saturated hydrocarbon group is optionally substituted with an oxygen atom; Y₅ each represents -C(=O)-O-, -C(=O)-O-R₁₉-, -C(=O)-NH-, -C(=O)-N(R₁₉OH)-, a phenylene group, or a naphthylene group; R₁₉ represents a divalent linear, branched, or cyclic aliphatic saturated hydrocarbon group having 1 to 12 carbon atoms or an aromatic hydrocarbon group having 6 to 12 carbon atoms, and a carbon atom in the aliphatic saturated hydrocarbon group is optionally substituted with an oxygen atom; and "1" represents 0 or 1.
10. The negative-type photosensitive resin composition according to any one of claims 6 to 9, wherein the component (E) is a crosslinkable polymer compound further having at least one or more structural units selected from cyclization-polymerized structural units represented by the following general formula (14), the following general formula (15), the following general formula (16), and the following general formula (17), 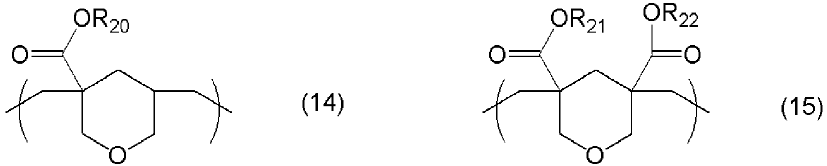 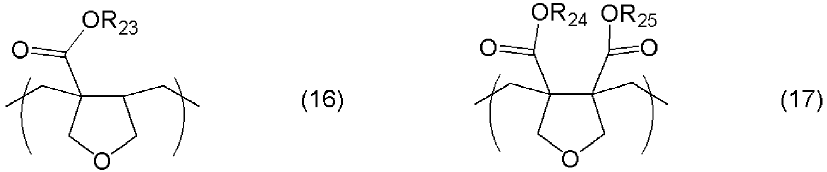 wherein R₂₀, R₂₁, R₂₂, R₂₃, R₂₄, and R₂₅ each independently represent a hydrogen atom or a linear or branched alkyl group having 1 to 5 carbon atoms.
11. The negative-type photosensitive resin composition according to any one of claims 1 to 10, further comprising one or more selected from a basic compound (F), a thermal acid generator (G), an oxidation inhibitor (H), and a silane compound (I).
12. A patterning method, comprising steps of:
   (1) applying the negative-type photosensitive resin composition according to any one of claims 1 to 11 on a substrate to form a photosensitive film;
   (2) after a subsequent heating treatment, subjecting the photosensitive film to light exposure through a photomask by using high-energy ray having a wavelength of 190 to 500 nm or electron beam; and
   (3) after the light exposure, subjecting the substrate to a heating treatment, and performing development by using a developer of an alkaline aqueous solution.
13. A method for forming a cured film, comprising a step of heating and post-curing the patterned photosensitive film obtained by the patterning method according to claim 12 at a temperature of 100 to 300°C.
14. An interlayer insulative film, being a cured film formed by curing the negative-type photosensitive resin composition according to any one of claims 1 to 11.
15. A surface-protective film, being a cured film formed by curing the negative-type photosensitive resin composition according to any one of claims 1 to 11.
16. An electronic component, comprising the interlayer insulative film according to claim 14, or comprising the surface-protective film according to claim 15.

## Claims

1. A negative-type photosensitive resin composition, comprising:
a polymer (A) having a structural unit represented by the following general formula (1) and/or (2) and a structural unit represented by the following general formula (3) and/or (4), 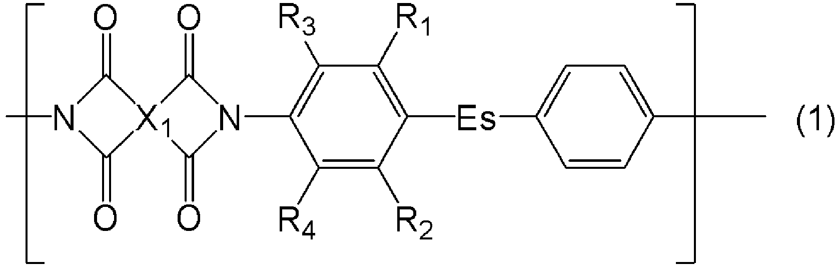
wherein X₁ represents a tetravalent organic group; R₁ to R₄ represent a monovalent organic group having 1 to 15 carbon atoms and optionally having a heteroatom, or a hydrogen atom, R₁ to R₄ may be different from or same as each other, and at least one of R₁ to R₄ represents the monovalent organic group having 1 to 15 carbon atoms and optionally having a heteroatom; and Es represents a -O-C(=O)- bond or a - C(=O)-O- bond, 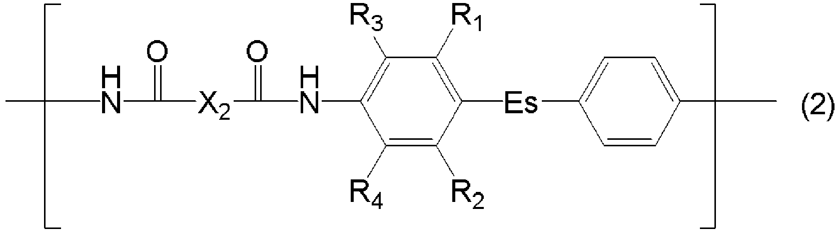
wherein X₂ represents a divalent organic group; and R₁ to R₄ and Es are same as above, 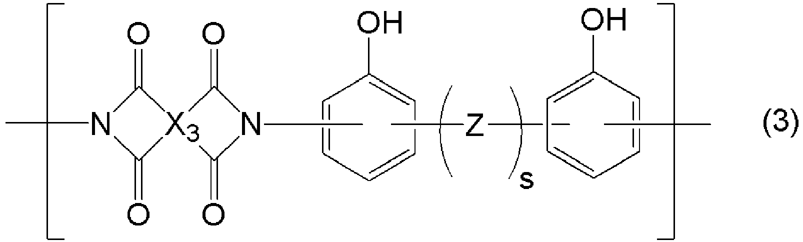
wherein X₃ represents a tetravalent organic group same as or different from the X₁; "s" represents 0 or 1; Z represents a divalent bonding group; and when s=0, two aromatic rings in the formula are directly bonded via no bonding group, 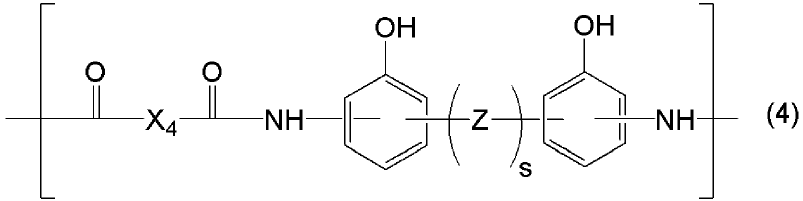
wherein X₄ represents a divalent organic group same as or different from the X₂; and "s" and Z are same as above;
a photoacid generator (B);
a crosslinking agent (C); and
a solvent (D).

2. The negative-type photosensitive resin composition according to claim 1, wherein any one of the R₁ and R₂ in the general formulae (1) and (2) represents the monovalent organic group having 1 to 15 carbon atoms and optionally having a heteroatom, the other represents a hydrogen atom, and the R₃ and R₄ represent hydrogen atoms.

3. The negative-type photosensitive resin composition according to claim 2, wherein any one of the R₁ and R₂ in the general formulae (1) and (2) represents an aromatic group having 1 to 10 carbon atoms, and the other represents a hydrogen atom.

4. The negative-type photosensitive resin composition according to any one of claims 1 to 3, wherein the Z in the general formulae (3) and (4) represents at least one bonding group selected from any groups represented by the following formulae (5), (6), (7), and (8), 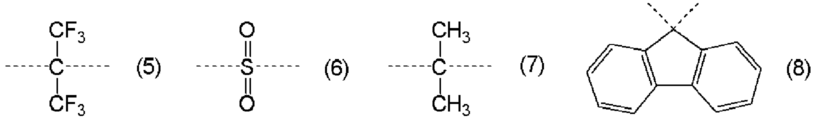 wherein a dotted line represents an attachment point.

5. The negative-type photosensitive resin composition according to any one of claims 1 to 4, wherein the component (C) is one or two or more crosslinking agents selected from: an amino condensate modified with formaldehyde or formaldehyde-alcohol; a phenol compound having two or more methylol groups or alkoxymethylol groups in average in one molecule; a compound in which a hydrogen atom in a hydroxy group of a polyvalent phenol is substituted with a glycidyl group; a compound in which a hydrogen atom in a hydroxy group of a polyvalent phenol or of a polyhydric alcohol is substituted with a substituent represented by the following formula (C-1); and a compound having two or more nitrogen atoms having a glycidyl group represented by the following formula (C-2), 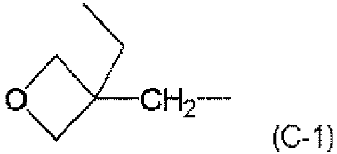 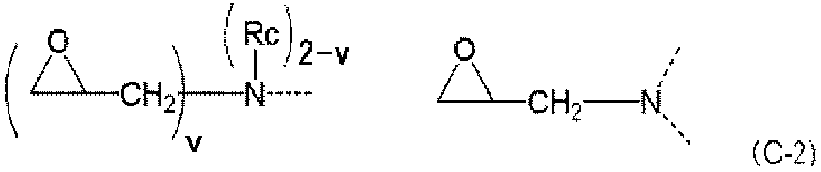 wherein a dotted line represents an attachment point; Rc represents a linear, branched, or cyclic alkyl group having 1 to 6 carbon atoms; and "v" represents 1 or 2.

6. The negative-type photosensitive resin composition according to any one of claims 1 to 5, further comprising a crosslinkable polymer (E) having a structural unit represented by the following general formula (9) and a group that is crosslinkable with the component (A), 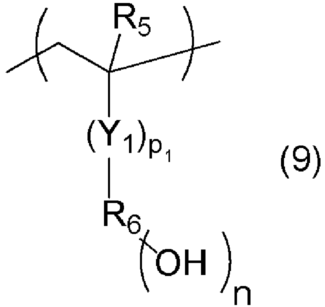 wherein R₅ represents a hydrogen atom or a methyl group; R₆ represents an (n+1)-valent linear, branched, or cyclic aliphatic saturated hydrocarbon group having 1 to 15 carbon atoms, an aromatic hydrocarbon group having 6 to 15 carbon atoms, a benzyl group, or a naphthalenemethyl group, and a carbon atom in the aliphatic saturated hydrocarbon group is optionally substituted with an oxygen atom; "n" represents an integer of 1 to 5; Y₁ each represents -C(=O)-O-, -C(=O)-NH-, or -C(=O)-N(R₇OH)-; R₇ represents a divalent linear, branched, or cyclic aliphatic saturated hydrocarbon group having 1 to 12 carbon atoms or an aromatic hydrocarbon group having 6 to 12 carbon atoms, and a carbon atom in the aliphatic saturated hydrocarbon group is optionally substituted with an oxygen atom; and p₁ represents 0 or 1.

7. The negative-type photosensitive resin composition according to claim 6, wherein the component (E) is a crosslinkable polymer compound having: a structural unit represented by the following general formula (10); and a structural unit represented by the following general formula (11) having a group that is crosslinkable with the component (A), 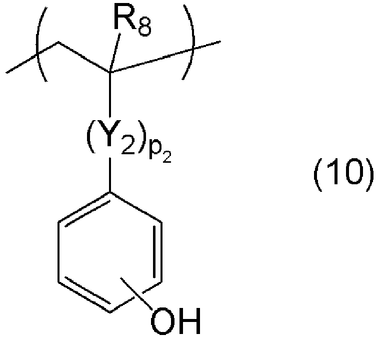
wherein R₈ represents a hydrogen atom or a methyl group; Y₂ each represents -C(=O)-O-, -C(=O)-NH-, or -C(=O)-N(RgOH)-; R₉ represents a divalent linear, branched, or cyclic aliphatic saturated hydrocarbon group having 1 to 12 carbon atoms or an aromatic hydrocarbon group having 6 to 12 carbon atoms, and a carbon atoms in the aliphatic saturated hydrocarbon group is optionally substituted with an oxygen atom; and p₂ represents 0 or 1, 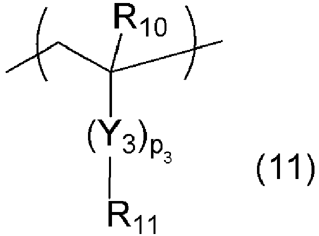
wherein R₁₀ represents a hydrogen atom or a methyl group; R₁₁ represents a group having an oxazoline group, an isocyanate group, a block isocyanate group, an oxetanyl group, or an epoxy group; Y₃ represents -C(=O)-O-, a phenylene group, or a naphthylene group; and p₃ represents 0 or 1;
preferably
wherein the component (E) is a crosslinkable polymer compound having structural units represented by the following general formula (10) and the following general formula (12), 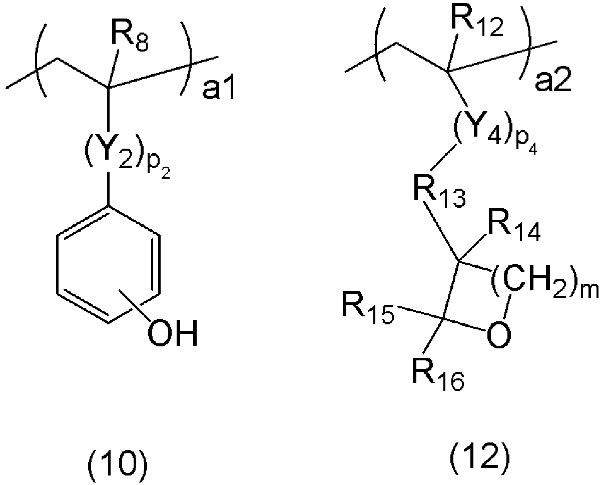 wherein R₈, Y₂, and p₂ are same as above; R₁₂ represents a hydrogen atom or a methyl group; Y₄ each represents -C(=O)-O-, a phenylene group, or a naphthylene group; R₁₃ represents a linear, branched, or cyclic alkylene group having 1 to 15 carbon atoms and optionally having a hydroxy group, an ester group, an ether group, or an aromatic hydrocarbon; R₁₄ represents a hydrogen atom or a linear, branched, or cyclic alkyl group having 1 to 6 carbon atoms, and R₁₄ is optionally bonded to R₁₃ to form a ring; R₁₅ represents a hydrogen atom or a linear, branched, or cyclic alkyl group having 1 to 6 carbon atoms; R₁₆ represents a hydrogen atom or a linear alkyl group having 1 to 6 carbon atoms, and R₁₆ is optionally bonded to R₁₃ to form a ring; "m" represents 0 or 1; p₄ represents 0 or 1; and 0<a1<1.0, 0<a2<1.0, and 0<a1+a2≤1.0.

8. The negative-type photosensitive resin composition according to claim 6 or 7, wherein the component (E) is a crosslinkable polymer compound further having a structural unit represented by the following general formula (13), 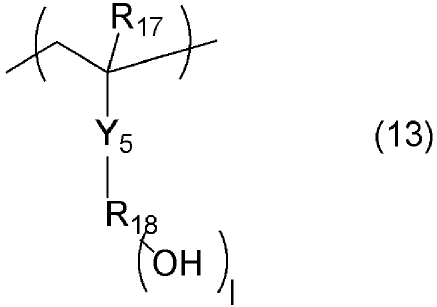 wherein R₁₇ represents a hydrogen atom or a methyl group; R₁₈ represents a single bond or a (l+1)-valent linear, branched, or cyclic aliphatic saturated hydrocarbon group having 1 to 13 carbon atoms, and a carbon atom in the aliphatic saturated hydrocarbon group is optionally substituted with an oxygen atom; Y₅ each represents -C(=O)-O-, -C(=O)-O-R₁₉-, -C(=O)-NH-, -C(=O)-N(R₁₉OH)-, a phenylene group, or a naphthylene group; R₁₉ represents a divalent linear, branched, or cyclic aliphatic saturated hydrocarbon group having 1 to 12 carbon atoms or an aromatic hydrocarbon group having 6 to 12 carbon atoms, and a carbon atom in the aliphatic saturated hydrocarbon group is optionally substituted with an oxygen atom; and "I" represents 0 or 1.

9. The negative-type photosensitive resin composition according to claim 6 to 8, wherein the component (E) is a crosslinkable polymer compound further having at least one or more structural units selected from cyclization-polymerized structural units represented by the following general formula (14), the following general formula (15), the following general formula (16), and the following general formula (17), 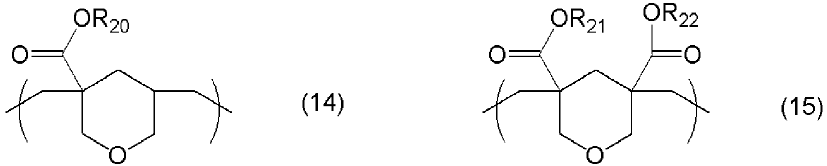 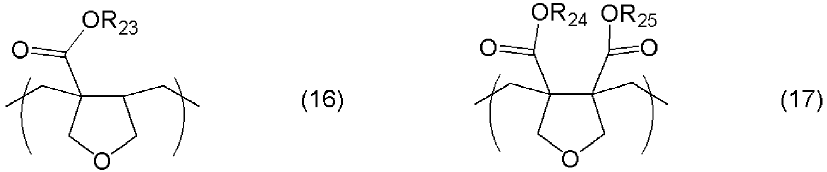 wherein R₂₀, R₂₁, R₂₂, R₂₃, R₂₄, and R₂₅ each independently represent a hydrogen atom or a linear or branched alkyl group having 1 to 5 carbon atoms.

10. The negative-type photosensitive resin composition according to any one of claims 1 to 9, further comprising one or more selected from a basic compound (F), a thermal acid generator (G), an oxidation inhibitor (H), and a silane compound (I).

11. A patterning method, comprising steps of:
(1) applying the negative-type photosensitive resin composition according to any one of claims 1 to 10 on a substrate to form a photosensitive film;
(2) after a subsequent heating treatment, subjecting the photosensitive film to light exposure through a photomask by using high-energy ray having a wavelength of 190 to 500 nm or electron beam; and
(3) after the light exposure, subjecting the substrate to a heating treatment, and performing development by using a developer of an alkaline aqueous solution.

12. A method for forming a cured film, comprising a step of heating and post-curing the patterned photosensitive film obtained by the patterning method according to claim 11 at a temperature of 100 to 300°C.

13. An interlayer insulative film, being a cured film formed by curing the negative-type photosensitive resin composition according to any one of claims 1 to 10.

14. A surface-protective film, being a cured film formed by curing the negative-type photosensitive resin composition according to any one of claims 1 to 10.

15. An electronic component, comprising the interlayer insulative film according to claim 13, or comprising the surface-protective film according to claim 14.
